(19) Europäisches Patentamt
European Patent Office
Office européen des brevets

(11) EP 3 171 673 B1

(12) **EUROPEAN PATENT SPECIFICATION**

(45) Date of publication and mention of the grant of the patent:
**05.09.2018 Bulletin 2018/36**

(21) Application number: **15822744.7**

(22) Date of filing: **08.07.2015**

(51) Int Cl.:
***H01L 51/56*** *(2006.01)* *H01L 51/54* *(2006.01)*

(86) International application number:
**PCT/JP2015/069595**

(87) International publication number:
**WO 2016/009908 (21.01.2016 Gazette 2016/03)**

(54) **METHOD FOR MANUFACTURING LIGHT EMITTING ELEMENT**

VERFAHREN ZUR HERSTELLUNG EINES LICHTEMITTIERENDEN ELEMENTS

PROCÉDÉ DE FABRICATION D'ÉLÉMENT ÉLECTROLUMINESCENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.07.2014 JP 2014145618**
**25.12.2014 JP 2014261997**

(43) Date of publication of application:
**24.05.2017 Bulletin 2017/21**

(73) Proprietor: **Sumitomo Chemical Company Limited**
**Tokyo 104-8260 (JP)**

(72) Inventors:
- **YOSHIDA, Sadamu**
**Osaka-shi**
**Osaka 554-8558 (JP)**
- **KAKIMOTO, Hidenobu**
**Osaka-shi**
**Osaka 554-8558 (JP)**

(74) Representative: **J A Kemp**
**14 South Square**
**Gray's Inn**
**London WC1R 5JJ (GB)**

(56) References cited:
**EP-A1- 2 515 615**
**EP-A2- 1 780 817**
**WO-A1-2010/067746**
**WO-A1-2011/115075**
**JP-A- 2007 265 880**
**JP-A- 2009 505 409**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 171 673 B1

**Description**

Technical Field

The present invention relates to a method of producing a light emitting device.

Background Art

An organic electroluminescent device (hereinafter, referred to also as "light emitting device") can be suitably used for applications of display and illumination because of high light emission efficiency and low driving voltage, and has been intensively studied and developed. This light emitting device has organic layers such as a light emitting layer and a charge transporting layer. Since the organic layer can be formed by an application method typified by an inkjet printing method by using a material soluble in a solvent which can be used in production of a light emitting device, a method of producing a light emitting device using a soluble material is under investigation.

A light emitting device comprising a light emitting layer using a metal complex showing emission from the triplet excited state (phosphorescent emission) generates higher light emission efficiency than a light emitting device comprising a light emitting layer using a fluorescent material showing emission from the singlet excited state (fluorescent emission). Therefore, a method of producing a light emitting device using a metal complex soluble in a solvent which can be used in production of a light emitting device is under investigation. For example, Patent document 1 discloses a method of producing a light emitting device, comprising a step of forming a light emitting layer by an application method using an iridium complex as a metal complex showing phosphorescent emission, a step of annealing the formed light emitting layer, and a step of vapor-depositing a cathode on the annealed light emitting layer.

[Prior Art Document]

[Patent Document]

Patent document 1: US Patent Application Publication No. 2006/0040136
EP 1 780 817 A2 discusses a method for fabricating an organic electroluminescent display involving a light emitting layer formed in a housing.

Summary of the Invention

Problem to be Solved by the Invention

However, the light emitting device produced by the above-described method had no sufficient light emission efficiency.

Then, the present invention has an object of providing a method of producing a light emitting device excellent in light emission efficiency.

Means for Solving the Problem

The present inventors have found that, with respect to a light emitting device comprising an anode, a cathode, a light emitting layer formed by an application method using an iridium complex or a polymer compound comprising a constitutional unit derived from an iridium complex, and an encapsulating layer, for the whole process from initiation of the step of forming the light emitting layer to completion of the step of forming the encapsulating layer during which the light emitting device in production is exposed to ozone, the value of the product of the average value of the ozone concentration and the time interval exerts an influence on the light emission efficiency of the light emitting device, leading to completion of the present invention.

The present invention provides the following [1] to [5].

[1] A method of producing a light emitting device comprising an anode, a cathode, a light emitting layer disposed between the anode and the cathode, and an encapsulating layer, comprising
a step of forming the light emitting layer by an application method using an iridium complex having an iridium atom as the central metal or a polymer compound comprising a constitutional unit derived from an iridium complex having

an iridium atom as the central metal,
a step of forming the anode or the cathode, and
a step of forming the encapsulating layer,
wherein for the whole process from initiation of the step of forming the light emitting layer to completion of the step of forming the encapsulating layer during which the light emitting device in production is exposed to ozone, the average value of the ozone concentration: A ppb and the time interval: B min satisfy the formula (1-1):

$$0 \leq A \times B \leq 1000 \quad (1\text{-}1),$$

and wherein the iridium complex is an iridium complex represented by the formula (4):

[Chemical Formula 1]

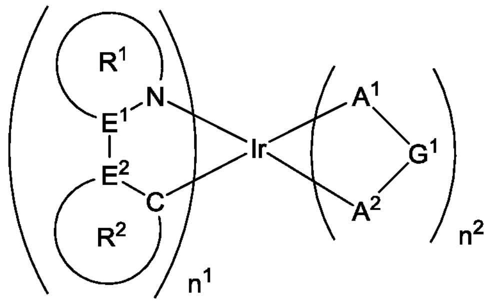

(4)

[wherein,

$n^1$ represents an integer of 1 or more, $n^2$ represents an integer of 0 or more, and $n^1+n^2$ is 3.
$E^1$ and $E^2$ each independently represent a carbon atom or a nitrogen atom. At least one of $E^1$ and $E^2$ is a carbon atom.

The ring $R^1$ represents a 5-membered or 6-membered aromatic heterocyclic ring, and these rings each optionally have a substituent. When a plurality of the substituents are present, they may be the same or different and may be combined together to form a ring together with the atoms to which they are attached. When a plurality of the rings $R^1$ are present, they may be the same or different. $E^1$ is a carbon atom when the ring $R^1$ is a 6-membered aromatic heterocyclic ring.
The ring $R^2$ represents a 5-membered or 6-membered aromatic hydrocarbon ring or a 5-membered or 6-membered aromatic heterocyclic ring, and these rings optionally have a substituent. When a plurality of the substituents are present, they may be the same or different and may be combined together to form a ring together with the atoms to which they are attached. When a plurality of the rings $R^2$ are present, they may be the same or different. $E^2$ is a carbon atom when the ring $R^2$ is a 6-membered aromatic heterocyclic ring.
$A^1$-$G^1$-$A^2$ represents an anionic bidentate ligand. $A^1$ and $A^2$ each independently represent a carbon atom, an oxygen atom or a nitrogen atom, and these atoms each may be an atom constituting a ring. $G^1$ represents a single bond or an atomic group constituting the bidentate ligand together with $A^1$ and $A^2$. When a plurality of $A^1$-$G^1$-$A^2$ are present, they may be the same or different.]..
[2] The method of producing a light emitting device according to [1], wherein A and B satisfy the formula (1-2) :

$$0 \leq A \times B \leq 100 \quad (1\text{-}2).$$

[3] The method of producing a light emitting device according to [1] or [2], wherein A satisfies the formula (2-1) :

$$0 \leq A \leq 30 \quad (2\text{-}1).$$

[4] The method of producing a light emitting device according to any one of [1] to [3], wherein B satisfies the formula

(3-0):

$$0 \leq B \leq 1000 \quad (3\text{-}0).$$

[5] The method of producing a light emitting device according to any one of [1] to [4], wherein the whole process from initiation of the step of forming the light emitting layer to completion of the step of forming the encapsulating layer is performed under an environment using a chemical filter.

Effect of the Invention

According to the present invention, a method of producing a light emitting device excellent in light emission efficiency can be provided. Further, according to a preferable embodiment of the present invention, a method of producing a light emitting device excellent in luminance life can be provided.

Brief Explanation of Drawing

Fig. 1 shows the relation of the value of the product of the average value of the ozone concentration: A ppb and the time interval: B min to standardized light emission efficiency, for a light emitting device 1 versus a light emitting device C1 and a light emitting device C2 (the light emission efficiency of the light emitting device 1 is standardized to 1.00), a light emitting device 2 versus a light emitting device 3 and a light emitting device C3 (the light emission efficiency of the light emitting device 2 is standardized to 1.00), a light emitting device 4 versus a light emitting device 5 and a light emitting device C4 (the light emission efficiency of the light emitting device 4 is standardized to 1.00), a light emitting device 6 versus a light emitting device 7, a light emitting device 8 and a light emitting device C5 (the light emission efficiency of the light emitting device 6 is standardized to 1.00), a light emitting device 9 versus a light emitting device 10, a light emitting device C6 and a light emitting device C7 (the light emission efficiency of the light emitting device 9 is standardized to 1.00), a light emitting device 11 versus a light emitting device C8 (the light emission efficiency of the light emitting device 11 is standardized to 1.00), and, a light emitting device 12 versus a light emitting device C9 and a light emitting device C10 (the light emission efficiency of the light emitting device 12 is standardized to 1.00), respectively.

Modes for Carrying Out the Invention

Suitable embodiments of the present invention will be illustrated in detail below.

<Explanation of common term>

Terms commonly used in the present specification have the following meanings unless otherwise stated.

Me represents a methyl group, Et represents an ethyl group, Bu represents a butyl group, i-Pr represents an isopropyl group, and t-Bu represents a tert-butyl group.

A hydrogen atom may be a heavy hydrogen atom or a light hydrogen atom.

A solid line representing a bond to a central metal in a formula representing a metal complex denotes a covalent bond or a coordinate bond.

"Polymer compound" denotes a polymer having molecular weight distribution and having a polystyrene-equivalent number average molecular weight of $1\times10^3$ to $1\times10^8$.

A polymer compound may be any of a block copolymer, a random copolymer, an alternating copolymer and a graft copolymer, and may also be another embodiment.

An end group of a polymer compound is preferably a stable group because if a polymerization active group remains intact at the end, when the polymer compound is used for fabrication of a light emitting device, the light emitting property or luminance life possibly becomes lower. This end group is preferably a group having a conjugated bond to the main chain, and includes, for example, groups bonding to an aryl group or a monovalent heterocyclic group via a carbon-carbon bond.

"Low molecular weight compound" denotes a compound having no molecular weight distribution and having a molecular weight of $1\times10^4$ or less.

"Constitutional unit" denotes a unit structure found once or more in a polymer compound.

"Alkyl group" may be any of linear or branched. The number of carbon atoms of the linear alkyl group is, not including the number of carbon atoms of a substituent, usually 1 to 50, preferably 3 to 30, more preferably 4 to 20. The number of carbon atoms of the branched alkyl groups is, not including the number of carbon atoms of a substituent,

usually 3 to 50, preferably 3 to 30, more preferably 4 to 20.

The alkyl group optionally has a substituent, and examples thereof include a methyl group, an ethyl group, a propyl group, an isopropyl group, a butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group, and groups obtained by substituting a hydrogen atom in these groups with a cycloalkyl group, an alkoxy group, a cycloalkoxy group, an aryl group, a fluorine atom or the like, and the alkyl group having a substituent includes, for example, a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di- hexylphenyl) propyl group and a 6-ethyloxyhexyl group.

The number of carbon atoms of "Cycloalkyl group" is, not including the number of carbon atoms of a substituent, usually 3 to 50, preferably 3 to 30, more preferably 4 to 20.

The cycloalkyl group optionally has a substituent, and examples thereof include a cyclohexyl group, a cyclohexylmethyl group and a cyclohexylethyl group.

"Aryl group" denotes an atomic group remaining after removing from an aromatic hydrocarbon one hydrogen atom linked directly to a carbon atom constituting the ring. The number of carbon atoms of the aryl group is, not including the number of carbon atoms of a substituent, usually 6 to 60, preferably 6 to 20, more preferably 6 to 10.

The aryl group optionally has a substituent, and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, a 4-phenylphenyl group, and groups obtained by substituting a hydrogen atom in these groups with an alkyl group, a cycloalkyl group, an alkoxy group, a cycloalkoxy group, an aryl group, a fluorine atom or the like.

"Alkoxy group" may be any of linear or branched. The number of carbon atoms of the linear alkoxy group is, not including the number of carbon atoms of a substituent, usually 1 to 40, preferably 4 to 10. The number of carbon atoms of the branched alkoxy group is, not including the number of carbon atoms of a substituent, usually 3 to 40, preferably 4 to 10.

The alkoxy group optionally has a substituent, and examples thereof include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group, and groups obtained by substituting a hydrogen atom in these groups with a cycloalkyl group, an alkoxy group, a cycloalkoxy group, an aryl group, a fluorine atom or the like.

The number of carbon atoms of "Cycloalkoxy group" is, not including the number of carbon atoms of a substituent, usually 3 to 40, preferably 4 to 10.

The cycloalkoxy group optionally has a substituent, and examples thereof include a cyclohexyloxy group.

The number of carbon atoms of "Aryloxy group" is, not including the number of carbon atoms of a substituent, usually 6 to 60, preferably 7 to 48.

The aryloxy group optionally has a substituent, and examples thereof include a phenoxy group, a 1-naphthyloxy group, a 2-naphthyloxy group, a 1-anthracenyloxy group, a 9-anthracenyloxy group, a 1-pyrenyloxy group, and groups obtained by substituting a hydrogen atom in these groups with an alkyl group, a cycloalkyl group, an alkoxy group, a cycloalkoxy group, a fluorine atom or the like.

"p-Valent heterocyclic group" (p represents an integer of 1 or more) denotes an atomic group remaining after removing from a heterocyclic compound p hydrogen atoms among hydrogen atoms directly linked to a carbon atom or a hetero atom constituting the ring. Of p-valent heterocyclic groups, "p-valent aromatic heterocyclic groups" as an atomic group remaining after removing from an aromatic heterocyclic compound p hydrogen atoms among hydrogen atoms directly linked to a carbon atom or a hetero atom constituting the ring are preferable.

"Aromatic heterocyclic compound" denotes a compound in which the heterocyclic ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole and dibenzophosphole, and a compound in which an aromatic ring is condensed to the heterocyclic ring even if the heterocyclic ring itself shows no aromaticity such as phenoxazine, phenothiazine, dibenzoborole, dibenzosilole and benzopyran.

The number of carbon atoms of the monovalent heterocyclic group is, not including the number of carbon atoms of a substituent, usually 2 to 60, preferably 4 to 20.

The monovalent heterocyclic group optionally has a substituent, and examples thereof include a thienyl group, a pyrrolyl group, a furyl group, a pyridyl group, a piperidyl group, a quinolinyl group, an isoquinolinyl group, a pyrimidinyl group, a triazinyl group, and groups obtained by substituting a hydrogen atom in these groups with an alkyl group, a cycloalkyl group, an alkoxy group, a cycloalkoxy group or the like.

"Halogen atom" denotes a fluorine atom, a chlorine atom, a bromine atom or an iodine atom.

"Amino group" optionally has a substituent, and a substituted amino group is preferable. The substituent which an amino group has is preferably an alkyl group, a cycloalkyl group, an aryl group or a monovalent heterocyclic group.

The substituted amino group includes, for example, a dialkylamino group, a dicycloalkylamino group and a diarylamino group.

The amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

"Alkenyl group" may be any of linear or branched. The number of carbon atoms of the linear alkenyl group, not including the number of carbon atoms of the substituent, is usually 2 to 30, preferably 3 to 20. The number of carbon atoms of the branched alkenyl group, not including the number of carbon atoms of the substituent, is usually 3 to 30, preferably 4 to 20.

The number of carbon atoms of "Cycloalkenyl group", not including the number of carbon atoms of the substituent, is usually 3 to 30, preferably 4 to 20.

The alkenyl group and cycloalkenyl group each optionally have a substituent, and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group, and these groups having a substituent.

"Alkynyl group" may be any of linear or branched. The number of carbon atoms of the alkynyl group, not including the number of carbon atoms of the substituent, is usually 2 to 20, preferably 3 to 20. The number of carbon atoms of the branched alkynyl group, not including the number of carbon atoms of the substituent, is usually 4 to 30, preferably 4 to 20.

The number of carbon atoms of "Cycloalkynyl group", not including the number of carbon atoms of the substituent, is usually 4 to 30, preferably 4 to 20.

The alkynyl group and cycloalkynyl group each optionally have a substituent, and examples thereof include an ethynyl group, a 1-propynyl group, a 2-propynyl group, a 2-butynyl group, a 3-butynyl group, a 3-pentynyl group, a 4-pentynyl group, a 1-hexynyl group, a 5-hexynyl group, and these groups having a substituent.

"Arylene group" denotes an atomic group remaining after removing from an aromatic hydrocarbon two hydrogen atoms linked directly to carbon atoms constituting the ring. The number of carbon atoms of the arylene group is, not including the number of carbon atoms of a substituent, usually 6 to 60, preferably 6 to 30, more preferably 6 to 18.

The arylene group optionally has a substituent, and examples thereof include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and these groups having a substituent, preferably, groups represented by the formulae (A-1) to (A-20). The arylene group includes groups obtained by linking a plurality of these groups.

[Chemical Formula 2]

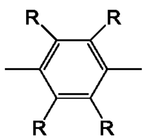
(A-1)

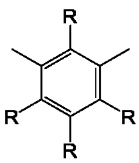
(A-2)

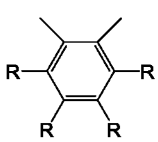
(A-3)

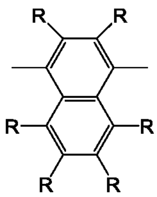
(A-4)

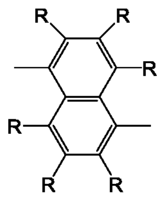
(A-5)

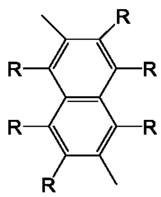
(A-6)

[Chemical Formula 3]

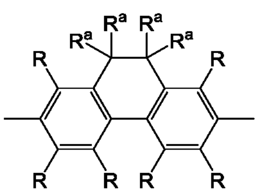
(A-7)

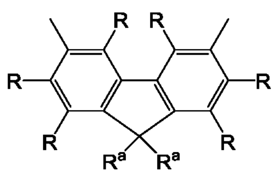
(A-8)

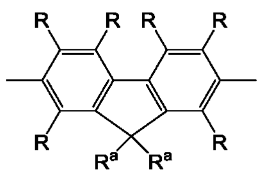
(A-9)

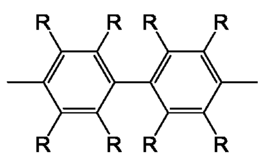
(A-10)

[Chemical Formula 4]

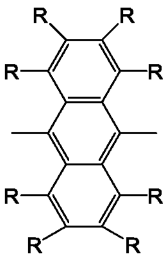
(A-11)

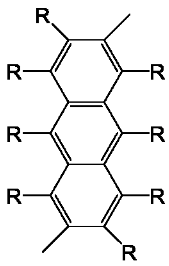
(A-12)

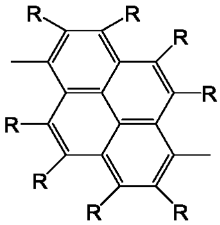
(A-13)

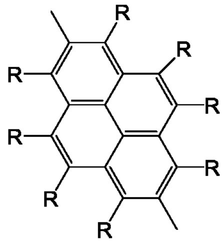
(A-14)

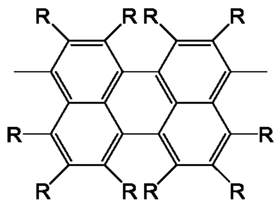
(A-15)

[Chemical Formula 5]

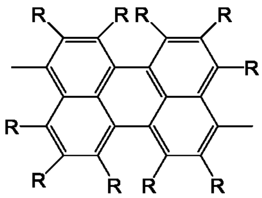
(A-16)

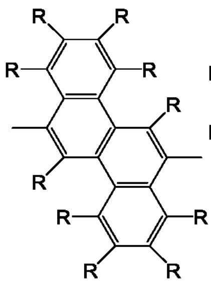
(A-17)

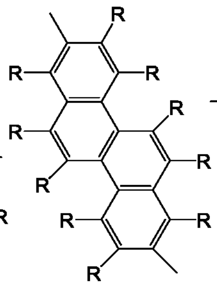
(A-18)

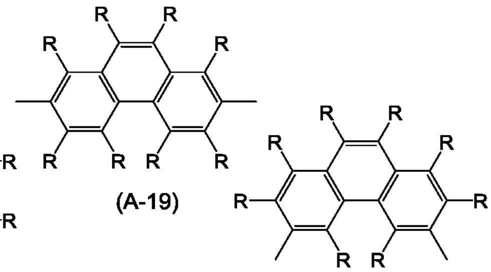
(A-19)

(A-20)

[wherein, R and $R^a$ each independently represent a hydrogen atom, an alkyl group, a cycloalkyl group, an aryl group or a monovalent heterocyclic group. The plurality of R and $R^a$ each may be the same or different, and groups $R^a$ may be combined together to form a ring together with the atoms to which they are attached.]

The number of carbon atoms of the divalent heterocyclic group is, not including the number of carbon atoms of a substituent, usually 2 to 60, preferably 3 to 20, more preferably 4 to 15.

The divalent heterocyclic group optionally has a substituent, and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among hydrogen atoms linking directly to a carbon atom or a hetero atom constituting the ring, preferably groups represented by the formulae (AA-1) to (AA-34). The divalent heterocyclic group includes groups obtained by linking a plurality of these groups.

[Chemical Formula 6]

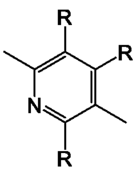
(AA-1)

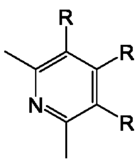
(AA-2)

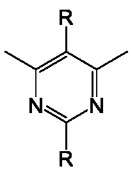
(AA-3)

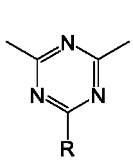
(AA-4)

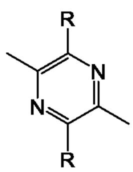
(AA-5)

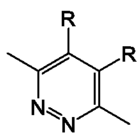
(AA-6)

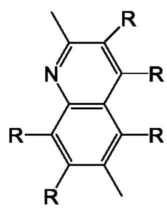
(AA-7)

[Chemical Formula 7]

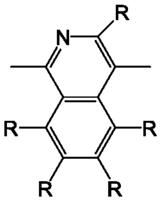
(AA-8)

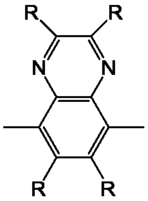
(AA-9)

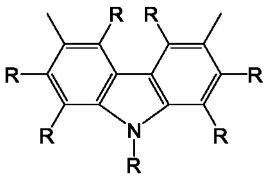
(AA-10)

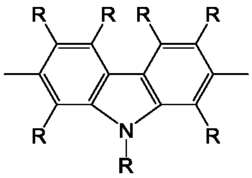
(AA-11)

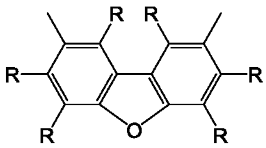
(AA-12)

[Chemical Formula 8]

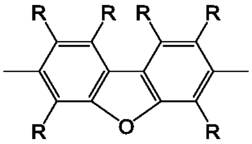
(AA-13)

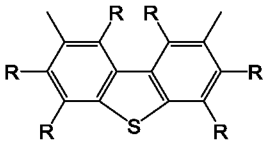
(AA-14)

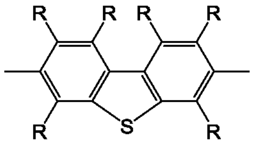
(AA-15)

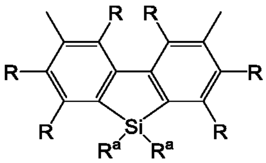
(AA-16)

[Chemical Formula 9]

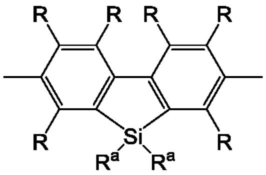
(AA-17)

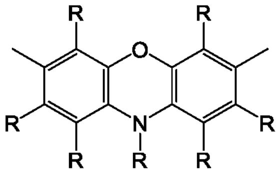
(AA-18)

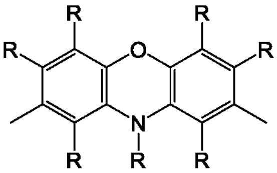
(AA-19)

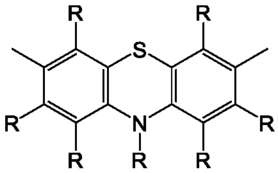
(AA-20)

[Chemical Formula 10]

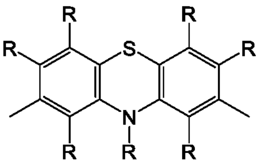
(AA-21)

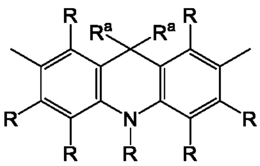
(AA-22)

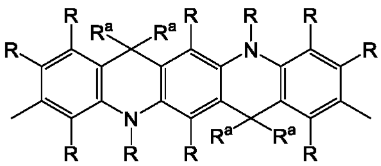
(AA-23)

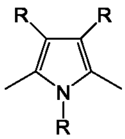
(AA-24)

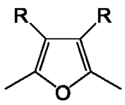
(AA-25)

[Chemical Formula 11]

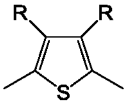
(AA-26)

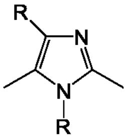
(AA-27)

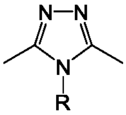
(AA-28)

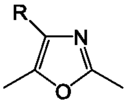
(AA-29)

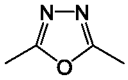
(AA-30)

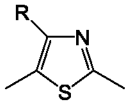
(AA-31)

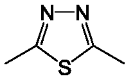
(AA-32)

[Chemical Formula 12]

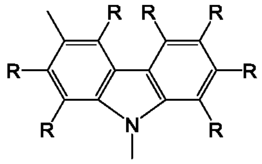
(AA-33)

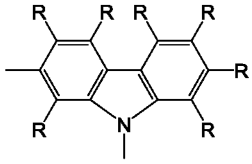
(AA-34)

[wherein, R and $R^a$ represent the same meaning as described above.]

"Crosslinkable group" is a group capable of forming a new bond by being subjected to a heating treatment, an ultraviolet irradiation treatment, a radical reaction and the like, and the crosslinkable group is preferably a group represented by any one of the formulae (B-1) to (B-17). These groups each optionally have a substituent.

[Chemical Formula 13]

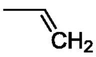
(B-1)
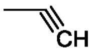
(B-2)
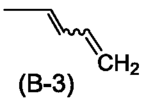
(B-3)
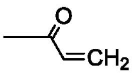
(B-4)
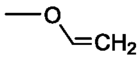
(B-5)
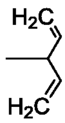
(B-6)
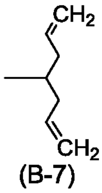
(B-7)
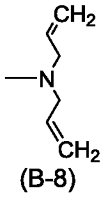
(B-8)

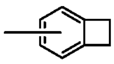
(B-9)
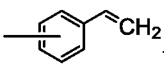
(B-10)
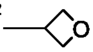
(B-11)
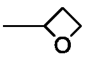
(B-12)
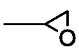
(B-13)
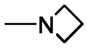
(B-14)
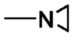
(B-15)
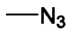
(B-16)
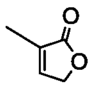
(B-17)

"Substituent" represents a halogen atom, a cyano group, an alkyl group, a cylcoalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group or a cycloalkynyl group. The substutuent may be a crosslinkable group.

"Dendron" denotes a group having a regular dendritic branched structure having a branching point at an atom or ring (that is, a dendrimer structure). A compound having a dendron (hereinafter, referred to as "dendrimer") includes, for example, structures described in literatures such as International Publication WO02/067343, JP-A No. 2003-231692, International Publication WO2003/079736, International Publication WO2006/097717 and the like.

The dendron is preferably a group represented by the formula (D-A) or (D-B).

[Chemical Formula 14]

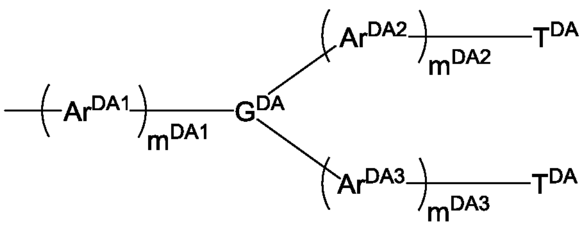
(D-A)

[wherein,

$m^{DA1}$, $m^{DA2}$ and $m^{DA3}$ each independently represent an integer of 0 or more.

$G^{DA}$ represents a nitrogen atom, an aromatic hydrocarbon group or a heterocyclic group, and these groups each optionally have a substituent.

$Ar^{DA1}$, $Ar^{DA2}$ and $Ar^{DA3}$ each independently represent an arylene group or a divalent heterocyclic group, and these groups each optionally have a substituent. When a plurality of $Ar^{DA1}$, $Ar^{DA2}$ and $Ar^{DA3}$ are present, they may be the same or different at each occurrence.
$T^{DA}$ represents an aryl group or a monovalent heterocyclic group, and these groups each optionally have a substituent. The plurality of $T^{DA}$ may be the same or different.]

[Chemical Formula 15]

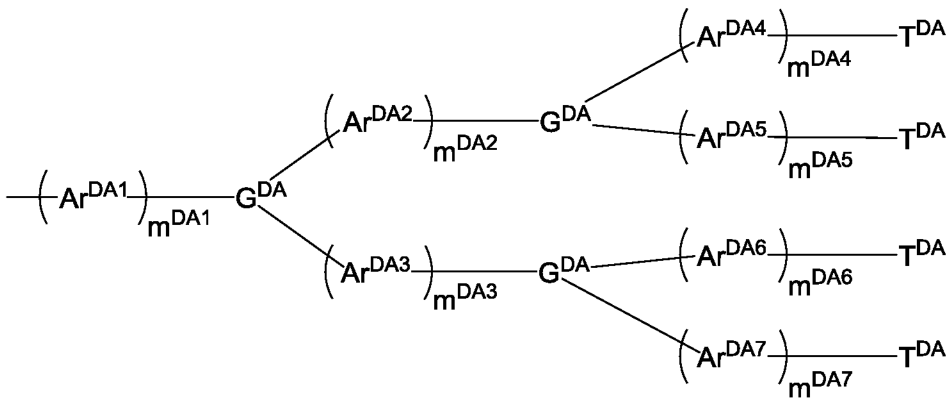

(D-B)

[wherein,

$m^{DA1}$, $m^{DA2}$, $m^{DA3}$, $m^{DA4}$, $m^{DA5}$, $m^{DA6}$ and $m^{DA7}$ each independently represent an integer of 0 or more.
$G^{DA}$ represents a nitrogen atom, an aromatic hydrocarbon group or a heterocyclic group, and these groups each optionally have a substituent. The plurality of $G^{DA}$ may be the same or different.
$Ar^{DA1}$, $Ar^{DA2}$, $Ar^{DA3}$, $Ar^{DA4}$, $Ar^{DA5}$, $Ar^{DA6}$ and $Ar^{DA7}$ each independently represent an arylene group or a divalent heterocyclic group, and these groups each optionally have a substituent. When a plurality of $Ar^{DA1}$, $Ar^{DA2}$, $Ar^{DA3}$, $Ar^{DA4}$, $Ar^{DA5}$, $Ar^{DA6}$ and $Ar^{DA7}$ are present, they may be the same or different at each occurrence.
$T^{DA}$ represents an aryl group or a monovalent heterocyclic group, and these groups each optionally have a substituent. The plurality of $T^{DA}$ may be the same or different.]

$m^{DA1}$, $m^{DA2}$, $m^{DA3}$, $m^{DA4}$, $m^{DA5}$, $m^{DA6}$ and $m^{DA7}$ are usually an integer of 10 or less, preferably an integer of 5 or less, more preferably 0 or 1. It is preferable that $m^{DA1}$, $m^{DA2}$, $m^{DA3}$, $m^{DA4}$, $m^{DA5}$, $m^{DA6}$ and $m^{DA7}$ are the same integer.

$G^{DA}$ is preferably a group represented by the formula (GDA-11) to (GDA-15), and these groups each optionally have a substituent.

[Chemical Formula 16]

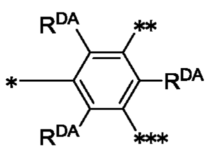

(GDA-11)

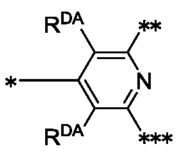

(GDA-12)

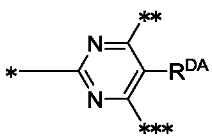

(GDA-13)

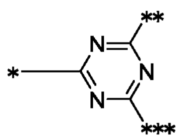

(GDA-14)

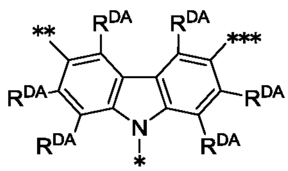

(GDA-15)

[wherein,

* represents a linkage to $Ar^{DA1}$ in the formula (D-A), $Ar^{DA1}$ in the formula (D-B), $Ar^{DA2}$ in the formula (D-B) or $Ar^{DA3}$ in the formula (D-B).
** represents a linkage to $Ar^{DA2}$ in the formula (D-A), $Ar^{DA2}$ in the formula (D-B), $Ar^{DA4}$ in the formula (D-B) or $Ar^{DA6}$ in the formula (D-B).
*** represents a linkage to $Ar^{DA3}$ in the formula (D-A), $Ar^{DA3}$ in the formula (D-B), $Ar^{DA5}$ in the formula (D-B) or $Ar^{DA7}$

in the formula (D-B).

$R^{DA}$ represents a hydrogen atom, an alkyl group, a cycloalkyl group, an alkoxy group, a cycloalkoxy group, an aryl group or a monovalent heterocyclic group, and these groups each optionally have a substituent. When a plurality of $R^{DA}$ are present, they may be the same or different.]

$R^{DA}$ is preferably a hydrogen atom, an alkyl group, a cycloalkyl group, an alkoxy group or a cycloalkoxy group, more preferably a hydrogen atom, an alkyl group or cycloalkyl group, and these groups each optionally have a substituent.

$Ar^{DA1}$, $Ar^{DA2}$, $Ar^{DA3}$, $Ar^{DA4}$, $Ar^{DA5}$, $Ar^{DA6}$ and $Ar^{DA7}$ are preferably groups represented by the formulae (ArDA-1) to (ArDA-3).

[Chemical Formula 17]

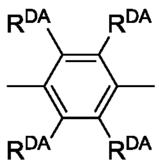

**(ArDA-1)**

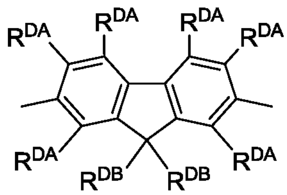

**(ArDA-2)**

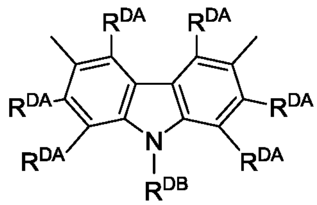

**(ArDA-3)**

[wherein,

$R^{DA}$ represents the same meaning as described above.

$R^{DB}$ represents a hydrogen atom, an alkyl group, a cycloalkyl group, an aryl group or a monovalent heterocyclic group, and these groups each optionally have a substituent. When a plurality of $R^{DB}$ are present, they may be the same or different.]

$R^{DB}$ is preferably an alkyl group, a cycloalkyl group, an aryl group or a monovalent heterocyclic group, more preferably an aryl group or a monovalent heterocyclic group, further preferably an aryl group.

$T^{DA}$ is preferably groups represented by the formulae (TDA-1) to (TDA-3).

[Chemical Formula 18]

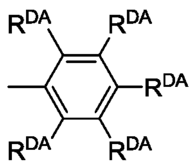

**(TDA-1)**

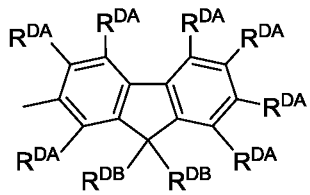

**(TDA-2)**

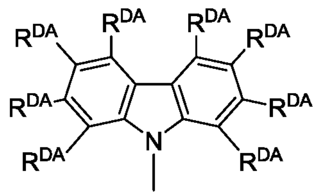

**(TDA-3)**

[wherein, $R^{DA}$ and $R^{DB}$ represent the same meaning described above.]

The group represented by the formula (D-A) is preferably a group represented by the formula (D-A1) to (D-A3) .

[Chemical Formula 19]

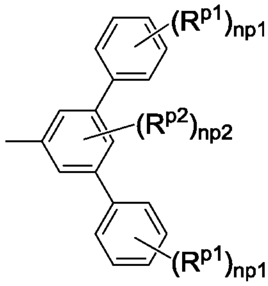
(D-A1)

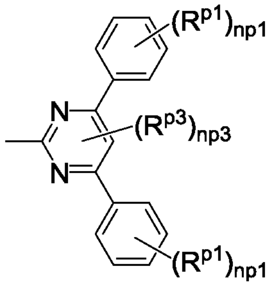
(D-A2)

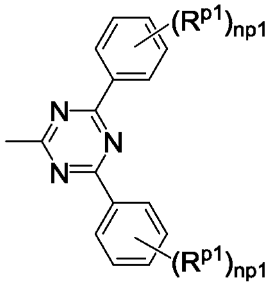
(D-A3)

[wherein,

$R^{p1}$, $R^{p2}$ and $R^{p3}$ each independently represent an alkyl group, a cycloalkyl group, an alkoxy group, a cycloalkoxy group or a halogen atom. When a plurality of $R^{p1}$ and $R^{p2}$ are present, they may be the same or different at each occurrence.

np1 represents an integer of 0 to 5, np2 represents an integer of 0 to 3, and np3 represents 0 or 1. The plurality of np1 may be the same or different.]

The group represented by the formula (D-B) is preferably a group represented by the formula (D-B1) to (D-B3) .

[Chemical Formula 20]

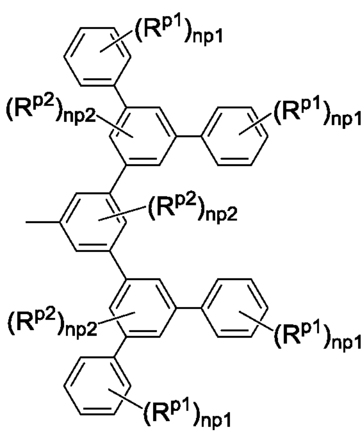
(D-B1)

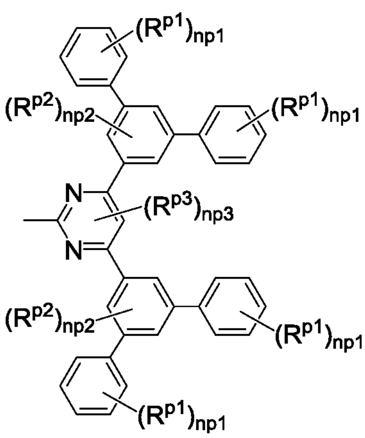
(D-B2)

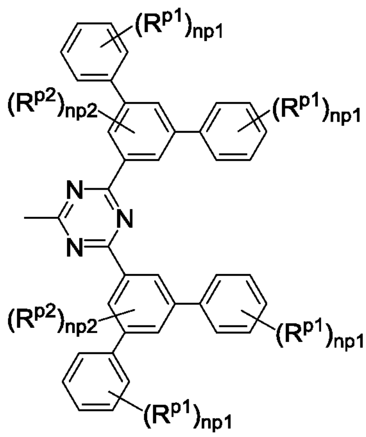
(D-B3)

[wherein,

$R^{p1}$, $R^{p2}$ and $R^{p3}$ each independently represent an alkyl group, a cycloalkyl group, an alkoxy group, a cycloalkoxy group or a halogen atom. When a plurality of $R^{p1}$ and $R^{p2}$ are present, they may be the same or different at each occurrence.

np1 represents an integer of 0 to 5, np2 represents an integer of 0 to 3, and np3 represents 0 or 1. When a plurarity of np1 and np2 are present, they may be the same or different at each occurrence.]

np1 is preferably 0 or 1, more preferably 1. np2 is preferably 0 or 1, more preferably 0. np3 is preferably 0.

$R^{p1}$, $R^{p2}$ and $R^{p3}$ are preferably an alkyl group or a cycloalkyl group.

<Method of producing light emitting device>

The present invention is a method of producing a light emitting device comprising
an anode,
a cathode,
a light emitting layer disposed between the anode and the cathode, and
an encapsulating layer, comprising
a step of forming the light emitting layer by an application method using an iridium complex of formula (4) having an iridium atom as the central metal or a polymer compound comprising a constitutional unit derived from an iridium complex of formula (4) having an iridium atom as the central metal,
a step of forming the anode or the cathode, and
a step of forming the encapsulating layer,
wherein for the whole process from initiation of the step of forming the light emitting layer to completion of the step of forming the encapsulating layer during which the light emitting device in production is exposed to ozone, the average value of the ozone concentration: A ppb (the average value of the ozone concentration for the whole process from initiation of the step of forming the light emitting layer to completion of the step of forming the encapsulating layer during which the light emitting device in production is exposed to ozone) and the time interval: B min (the time interval for the whole process from initiation of the step of forming the light emitting layer to completion of the step of forming the encapsulating layer during which the light emitting device in production is exposed to ozone) satisfy the formula (1-1):

$$0 \leq A \times B \leq 1000 \qquad (1\text{-}1).$$

The average value of the ozone concentration: A ppb is the average value of the ozone concentration for the time interval: B min of the whole process from initiation of the step of forming the light emitting layer to completion of the step of forming the encapsulating layer during which the light emitting device in production is exposed to ozone.

When A and B satisfy the formula (1-1), the formula (1-1') is usually satisfied.

$$0 < A \times B \leq 1000 \qquad (1\text{-}1')$$

A and B preferably satisfy the formula (1-2), more preferably satisfy the formula (1-3), further preferably satisfy the formula (1-4), because a light emitting device produced by the production method of the present invention is excellent in light emission efficiency and luminance life.

$$0 \leq A \times B \leq 100 \qquad (1\text{-}2)$$

$$0 \leq A \times B \leq 50 \qquad (1\text{-}3)$$

$$0 \leq A \times B \leq 30 \qquad (1\text{-}4)$$

When A and B satisfy the formula (1-2), the formula (1-2') is usually satisfied. When A and B satisfy the formula (1-3), the formula (1-3') is usually satisfied. When A and B satisfy the formula (1-4), the formula (1-4') is usually satisfied.

$$0 < A \times B \leq 100 \qquad (1\text{-}2')$$

$$0 < A \times B \leq 50 \qquad (1\text{-}3')$$

$$0 < A \times B \leq 30 \qquad (1\text{-}4')$$

A preferably satisfies the formula (2-1), more preferably satisfies the formula (2-2), further preferably satisfies the formula (2-3).

$$0 \leq A \leq 30 \quad (2\text{-}1)$$

$$0 \leq A \leq 3 \quad (2\text{-}2)$$

$$0 \leq A \leq 1 \quad (2\text{-}3)$$

When A satisfies the formula (2-1), the formula (2-1') is usually satisfied. When A satisfies the formula (2-2), the formula (2-2') is usually satisfied. When A satisfies the formula (2-3), the formula (2-3') is usually satisfied.

$$0 < A \leq 30 \quad (2\text{-}1')$$

$$0 < A \leq 3 \quad (2\text{-}2')$$

$$0 < A \leq 1 \quad (2\text{-}3')$$

B preferably satisfies the formula (3-0), more preferably satisfies the formula (3-1), further preferably satisfies the formula (3-2).

$$0 \leq B \leq 1000 \quad (3\text{-}0)$$

$$0 \leq B \leq 30 \quad (3\text{-}1)$$

$$0 \leq B \leq 20 \quad (3\text{-}2)$$

When B satisfies the formula (3-0), the formula (3-0') is usually satisfied, the formula (3-0") is preferably satisfied.

$$0 < B \leq 1000 \quad (3\text{-}0')$$

$$10 \leq B \leq 1000 \quad (3\text{-}0'')$$

When B satisfies the formula (3-1), the formula (3-1') is usually satisfied, the formula (3-1") is preferably satisfied.

$$0 < B \leq 30 \quad (3\text{-}1')$$

$$10 \leq B \leq 30 \quad (3\text{-}1'')$$

When B satisfies the formula (3-2), the formula (3-2') is usually satisfied, the formula (3-2") is preferably satisfied.

$$0 < B \leq 20 \quad (3\text{-}2')$$

$$10 \leq B \leq 20 \quad (3\text{-}2'')$$

In the method of producing a light emitting device of the present invention, it is preferable to perform the production under an environment of the low average value of the ozone concentration: A ppb (specifically, under the condition satisfying the formula (2-1), during the whole process from initiation of the step of forming the light emitting layer to completion of the step of forming the encapsulating layer. Therefore, it is preferable to perform the production under an indoor environment having an ozone filter installed to an external air intake during the whole process from initiation of the step of forming the light emitting layer to completion of the step of forming the encapsulating layer. The ozone filter includes, for example, a chemical filter, and more specifically, a chemical filter using activated carbon and a chemical filter using a catalyst, and a chemical filter using activated carbon is preferable because the average value of the ozone concentration: A ppb can be reduced more.

The average value of the ozone concentration: A ppb during the whole process from initiation of the step of forming the light emitting layer to completion of the step of forming the encapsulating layer can be measured by using an ozone concentration measurement apparatus.

<Light emitting layer>

In the method of producing a light emitting device of the present invention, the light emitting layer is formed by an application method using an ink containing an iridium complex of formula (4) or a polymer compound comprising a constitutional unit derived from an iridium complex of formula (4). The light emitting layer formed comprises an iridium complex of formula (4) or a polymer compound comprising a constitutional unit derived from an iridium complex of formula (4), and the iridium complex of formula (4) or the polymer compound comprising a constitutional unit derived from an iridium complex of formula (4) usually functions as a light emitting material. The application method includes, for example, a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method and a nozzle coat method, and a spin coat method, a nozzle coat method or an inkjet printing method is preferable.

The viscosity of the ink may be adjusted depending on the kind of the application method, and when the ink goes through a discharge apparatus such as in an inkjet printing method, the viscosity is preferably in the range of 1 to 20 mPa·s at 25°C because curved aviation and clogging in discharging are unlikely.

As the solvent contained in the ink, those capable of dissolving or uniformly dispersing solid components (the iridium complex of formula (4) or the polymer compound comprising a constitutional unit derived from an iridium complex of formula (4)) in the ink are preferable. The solvent includes, for example, chlorine-based solvents such as 1,2-dichloroethane, 1,1,2-trichloroethane, chlorobenzene and o-dichlorobenzene; ether solvents such as tetrahydrofuran, dioxane, anisole and 4-methylanisole; aromatic hydrocarbon solvents such as toluene, xylene, mesitylene, ethylbenzene, n-hexylbenzene and cyclohexylbenzene; aliphatic hydrocarbon solvents such as cyclohexane, methylcyclohexane, n-pentane, n-hexane, n-heptane, n-octane, n-nonane, n-decane, n-dodecane and bicyclohexyl; ketone solvents such as acetone, methylethylketone, cyclohexanone and acetophenone; ester solvents such as ethyl acetate, butyl acetate, ethylcellosolve acetate, methyl benzoate and phenyl acetate; poly-hydric alcohol solvents such as ethylene glycol, glycerin and 1,2-hexanediol and derivatives thereof; alcohol solvents such as isopropylalcohol and cyclohexanol; sulfoxide solvents such as dimethyl sulfoxide; and amide solvents such as N-methyl-2-pyrrolidone and N,N-dimethylformamide. These solvents may be used singly, or two or more of them may be used in combination.

In the ink, the compounding amount of the solvent is usually 1000 to 100000 parts by weight, preferably 2000 to 20000 parts by weight when the content of the iridium complex of formula (4) or the polymer compound comprising a constitutional unit derived from an iridium complex of formula (4) is 100 parts by weight.

The thickness of the light emitting layer is usually 1 nm to 10 μm.

[Iridium complex]

As the ligand of an iridium complex, a neutral or anionic monodentate ligand or a neutral or anionic polydentate ligand, forming at least one bond selected from the group consisting of a coordinate bond and a covalent bond with the iridium atom, is exemplified. As the bond between an iridium atom and a ligand, a metal-nitrogen bond, a metal-carbon bond, a metal-oxygen bond, a metal-phosphorus bond, a metal-sulfur bond and a metal-halogen bond are exemplified. The polydentate ligand usually denotes a bidentate or more and hexadentate or less ligand.

The iridium complex is available from Aldrich, Luminescence Technology Corp., American Dye Source and the like.

As the other obtaining route than those described above, it is also possible to produce the iridium complex by known methods described in documents such as "Journal of the American Chemical Society, Vol. 107, 1431-1432 (1985)", "Journal of the American Chemical Society, Vol. 106, 6647-6653 (1984)", International Publication WO2011/024761, International Publication WO2002/44189 and JP-A No. 2006-188673.

The iridium complex is an iridium complex represented by the formula (4).

[Chemical Formula 21]

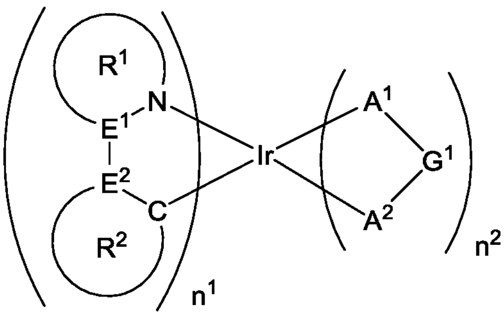

**(4)**

$n^1$ is preferably 2 or 3, more preferably 3.

$E^1$ and $E^2$ preferably represent a carbon atom.

The ring $R^1$ is preferably a pyridine ring, a pyrimidine ring, an imidazole ring or a triazole ring, and these rings each optionally have a substituent.

The ring $R^2$ is preferably a benzene ring, a naphthalene ring, a fluorene ring, a phenanthrene ring, a pyridine ring, a diazabenzene ring or a triazine ring, more preferably a benzene ring, a pyridine ring or a pyrimidine ring, and these rings each optionally have a substituent.

At least one ring selected from the group consisting of the ring $R^1$ and the ring $R^2$ preferably has an aryl group, a monovalent heterocyclic group or a substituted amino group as a substituent, more preferably has an aryl group or a monovalent heterocyclic group as a substituent, further preferably has an aryl group as a substituent. It is preferable that the aryl group, the monovalent heterocyclic group and the substituted amino group are each a dendron.

When at least one ring selected from the group consisting of the ring $R^1$ and the ring $R^2$ has an aryl group, a monovalent heterocyclic group or a substituted amino group as a substituent and when a plurality of the rings $R^1$ and a plurality of the rings $R^2$ are present, it is preferable that all the plurality of the rings $R^1$, all the plurality of the rings $R^2$, or all the plurality of the rings $R^1$ and the plurality of the rings $R^2$ have an aryl group, a monovalent heterocyclic group or a substituted amino group as a substituent, it is more preferable that all the plurality of the rings $R^2$ have an aryl group, a monovalent heterocyclic group or a substituted amino group as a substituent.

The anionic bidentate ligand represented by $A^1$-$G^1$-$A^2$ includes, for example, ligands shown below.

[Chemical Formula 22]

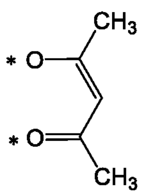 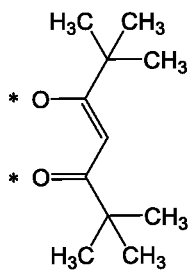 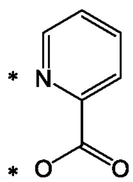 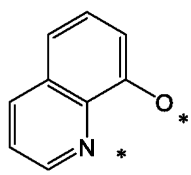 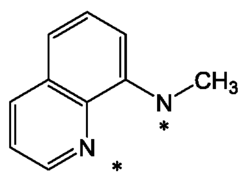

[Chemical Formula 23]

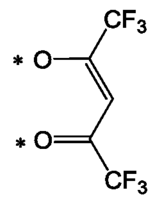 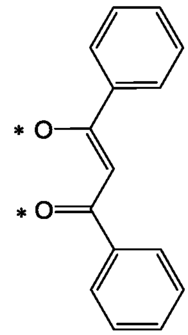 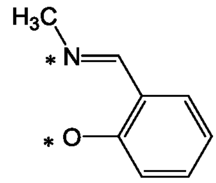 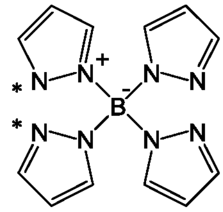

[wherein, * represents a site binding to an iridium atom.]

The iridium complex represented by the formula (4) is preferably an iridium complex represented by the formula (4-A1), an iridium complex represented by the formula (4-A2), an iridium complex represented by the formula (4-A3), an iridium complex represented by the formula (4-A4), an iridium complex represented by the formula (4-B1), an iridium complex represented by the formula (4-B2) or an iridium complex represented by the formula (4-B3), more preferably an iridium complex represented by the formula (4-A1), an iridium complex represented by the formula (4-A3), a metal complex represented by the formula (4-B1), a metal complex represented by the formula (4-B2) or a metal complex represented by the formula (4-B3), further preferably an iridium complex represented by the formula (4-A1), an iridium complex represented by the formula (4-A3) or a metal complex represented by the formula (4-B1), particularly preferably a metal complex represented by the formula (4-B1).

[Chemical Formula 24]

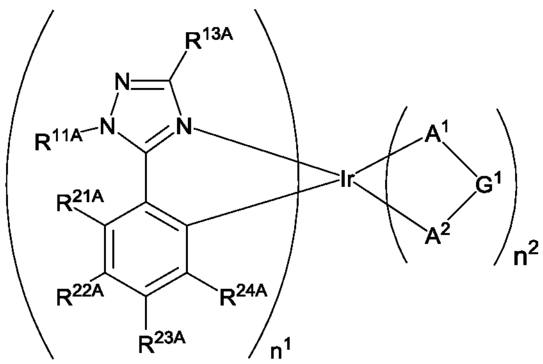

**(4-A1)**

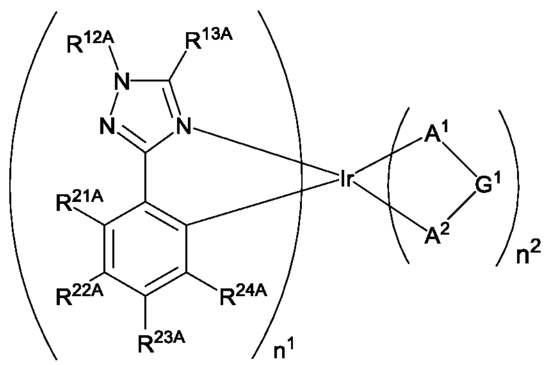

**(4-A2)**

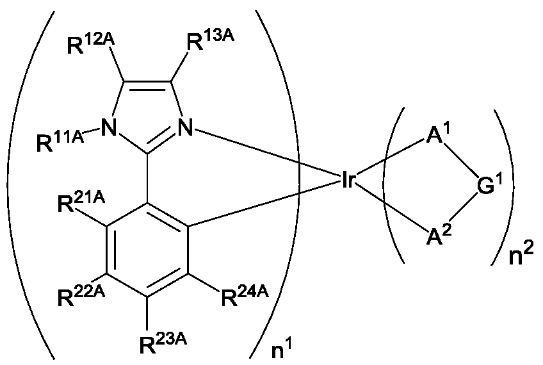

**(4-A3)**

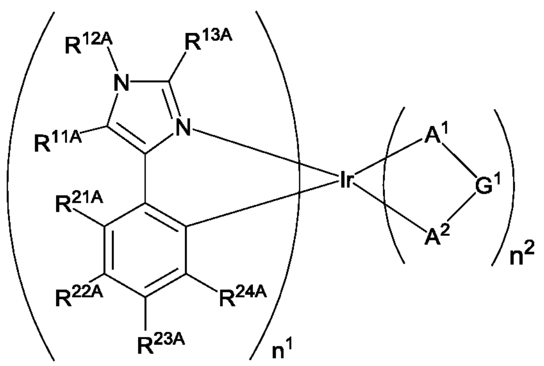

**(4-A4)**

[wherein,

$n^1$, $n^2$ and $A^1$-$G^1$-$A^2$ represent the same meaning as described above.

$R^{11A}$, $R^{12A}$, $R^{13A}$, $R^{21A}$, $R^{22A}$, $R^{23A}$ and $R^{24A}$ each independently represent a hydrogen atom, an alkyl group, a

cycloalkyl group, an alkoxy group, a cycloalkoxy group, an aryl group, an aryloxy group, a monovalent heterocyclic group, a substituted amino group or a halogen atom, and these groups each optionally have a substituent. When a plurality of $R^{11A}$, $R^{12A}$, $R^{13A}$, $R^{21A}$, $R^{22A}$, $R^{23A}$ and $R^{24A}$ are present, they may be the same or different at each occurrence. $R^{11A}$ and $R^{12A}$, $R^{12A}$ and $R^{13A}$, $R^{11A}$ and $R^{21A}$, $R^{21A}$ and $R^{22A}$, $R^{22A}$ and $R^{23A}$, and $R^{23A}$ and $R^{24A}$ each may be combined together to form a ring together with the atoms to which they are attached.]

In the formula (4-A1), $R^{11A}$ is preferably an alkyl group, a cycloalkyl group, an aryl group, a monovalent heterocyclic group or a substituted amino group, more preferably an alkyl group, a cycloalkyl group, an aryl group or a monovalent heterocyclic group, further preferably an alkyl group, a cycloalkyl group or an aryl group. It is preferable that the aryl group, the monovalent heterocyclic group and the substituted amino group are each a dendron.

In the formula (4-A1), $R^{13A}$ is preferably a hydrogen atom, an alkyl group, a cycloalkyl group, an aryl group or a monovalent heterocyclic group, more preferably a hydrogen atom, an alkyl group, a cycloalkyl group or an aryl group, further preferably a hydrogen atom, an alkyl group or a cycloalkyl group.

In the formula (4-A2), $R^{12A}$ is preferably an alkyl group, a cycloalkyl group, an aryl group, a monovalent heterocyclic group or a substituted amino group, more preferably an alkyl group, a cycloalkyl group, an aryl group or a monovalent heterocyclic group, further preferably an alkyl group, a cycloalkyl group or an aryl group. It is preferable that the aryl group, the monovalent heterocyclic group and the substituted amino group are each a dendron.

In the formula (4-A2), $R^{13A}$ is preferably a hydrogen atom, an alkyl group, a cycloalkyl group, an aryl group or a monovalent heterocyclic group, more preferably a hydrogen atom, an alkyl group, a cycloalkyl group or an aryl group, further preferably a hydrogen atom, an alkyl group or a cycloalkyl group.

In the formula (4-A3), $R^{11A}$ is preferably an alkyl group, a cycloalkyl group, an aryl group, a monovalent heterocyclic group or a substituted amino group, more preferably an alkyl group, a cycloalkyl group, an aryl group or a monovalent heterocyclic group, further preferably an alkyl group, a cycloalkyl group or an aryl group. It is preferable that the aryl group, the monovalent heterocyclic group and the substituted amino group are each a dendron.

In the formula (4-A3), $R^{12A}$ and $R^{13A}$ represent preferably a hydrogen atom, an alkyl group, a cycloalkyl group, an aryl group or a monovalent heterocyclic group, more preferably a hydrogen atom, an alkyl group, a cycloalkyl group or an aryl group, further preferably a hydrogen atom, an alkyl group or a cycloalkyl group.

In the formula (4-A4), $R^{12A}$ is preferably an alkyl group, a cycloalkyl group, an aryl group, a monovalent heterocyclic group or a substituted amino group, more preferably an alkyl group, a cycloalkyl group, an aryl group or a monovalent heterocyclic group, further preferably an alkyl group, a cycloalkyl group or an aryl group. It is preferable that the aryl group, the monovalent heterocyclic group and the substituted amino group are each a dendron.

In the formula (4-A4), $R^{11A}$ and $R^{13A}$ represent preferably a hydrogen atom, an alkyl group, a cycloalkyl group, an aryl group or a monovalent heterocyclic group, more preferably a hydrogen atom, an alkyl group, a cycloalkyl group or an aryl group, further preferably a hydrogen atom, an alkyl group or a cycloalkyl group.

$R^{21A}$, $R^{22A}$, $R^{23A}$ and $R^{24A}$ represent preferably a hydrogen atom, an alkyl group, a cycloalkyl group, an aryl group, a monovalent heterocyclic group or a substituted amino group, more preferably a hydrogen atom, an aryl group, a monovalent heterocyclic group or a substituted amino group, further preferably a hydrogen atom, an aryl group or a monovalent heterocyclic group, particularly preferably a hydrogen atom or an aryl group. It is preferable that the aryl group, the monovalent heterocyclic group and the substituted amino group are each a dendron.

When at least one selected from the group consisting of $R^{21A}$, $R^{22A}$, $R^{23A}$ and $R^{24A}$ is an aryl group, a monovalent heterocyclic group or a substituted amino group, it is preferable that $R^{22A}$ or $R^{23A}$ is an aryl group, a monovalent heterocyclic group or a substituted amino group, it is more preferable that $R^{22A}$ is an aryl group, a monovalent heterocyclic group or a substituted amino group.

[Chemical Formula 25]

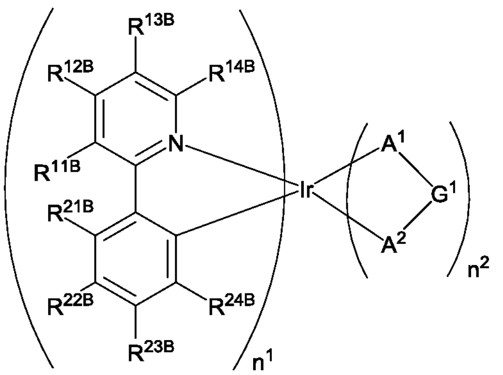

(4-B1)

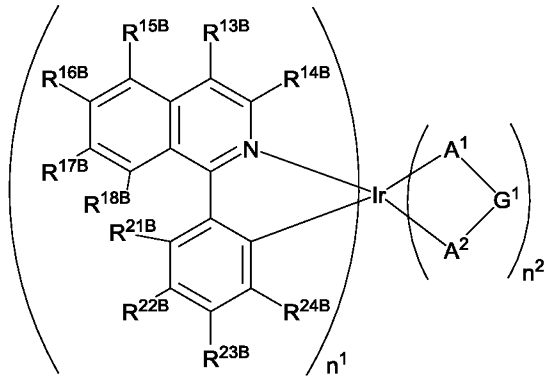

(4-B2)

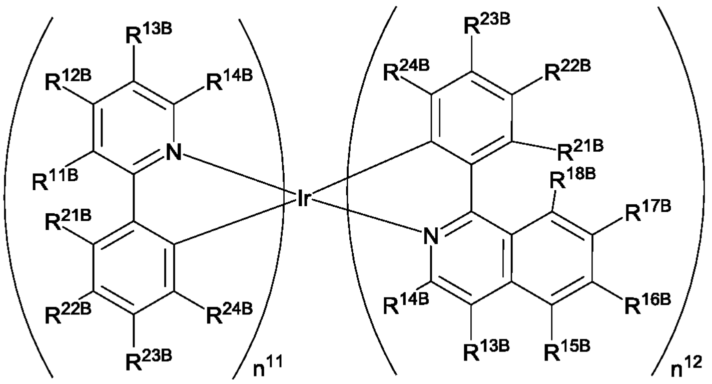

(4-B3)

[wherein,

$n^1$, $n^2$ and $A^1$-$G^1$-$A^2$ represent the same meaning as described above.

$n^{11}$ represents an integer of 1 or more, $n^{12}$ represents an integer of 1 or more, and $n^{11}$+$n^{12}$ is 3.

$R^{11B}$, $R^{12B}$, $R^{13B}$, $R^{14B}$, $R^{15B}$, $R^{16B}$, $R^{17B}$, $R^{18B}$, $R^{21B}$, $R^{22B}$, $R^{23B}$ and $R^{24B}$ each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. When a plurality of $R^{11B}$, $R^{12B}$, $R^{13B}$, $R^{14B}$, $R^{15B}$, $R^{16B}$, $R^{17B}$, $R^{18B}$, $R^{21B}$, $R^{22B}$, $R^{23B}$ and $R^{24B}$ are present, they may be the same or different at each occurrence. $R^{11B}$ and $R^{12B}$, $R^{12B}$and $R^{13B}$, $R^{13B}$, and $R^{14B}$, $R^{13B}$ and $R^{15B}$, $R^{15B}$ and $R^{16B}$, $R^{16B}$ and $R^{17B}$, $R^{17B}$ and $R^{18B}$, $R^{11B}$ and $R^{21B}$, $R^{18B}$ and $R^{21B}$, $R^{21B}$ and $R^{22B}$, $R^{22B}$ and $R^{23B}$, and $R^{23B}$ and $R^{24B}$ each may be combined together to form a ring together with the carbon atoms to which they are attached.]

$R^{11B}$, $R^{12B}$, $R^{13B}$, $R^{14B}$, $R^{15B}$, $R^{16B}$, $R^{17B}$ and $R^{18B}$ represent preferably a hydrogen atom, an alkyl group, a cycloalkyl group, an aryl group, a monovalent heterocyclic group or a substituted amino group, more preferably a hydrogen atom, an alkyl group, a cycloalkyl group, an aryl group or a monovalent heterocyclic group. It is preferable that the aryl group, the monovalent heterocyclic group and the substituted amino group are each a dendron.

When at least one selected from the group consisting of $R^{11B}$, $R^{12B}$, $R^{13B}$, $R^{14B}$, $R^{15B}$, $R^{16B}$, $R^{17B}$ and $R^{18B}$ is an aryl group, a monovalent heterocyclic group or a substituted amino group, it is preferable that $R^{11B}$, $R^{12B}$ or $R^{13B}$ is an aryl group, a monovalent heterocyclic group or a substituted amino group, it is more preferable that $R^{11B}$ or $R^{13B}$ is an aryl group, a monovalent heterocyclic group or a substituted amino group, it is further preferable that $R^{13B}$ is an aryl group, a monovalent heterocyclic group or a substituted amino group.

$R^{21B}$, $R^{22B}$, $R^{23B}$ and $R^{24B}$ represent preferably a hydrogen atom, an alkyl group, a cycloalkyl group, an aryl group, a monovalent heterocyclic group or a substituted amino group, more preferably a hydrogen atom, an aryl group, a monovalent heterocyclic group or a substituted amino group, further preferably a hydrogen atom, an aryl group or a monovalent heterocyclic group, particularly preferably a hydrogen atom or an aryl group. It is preferable that the aryl group, the monovalent heterocyclic group and the substituted amino group are each a dendron.

When at least one selected from the group consisting of $R^{21B}$, $R^{22B}$, $R^{23B}$ and $R^{24B}$ is an aryl group, a monovalent heterocyclic group or a substituted amino group, it is preferable that $R^{22B}$ or $R^{23B}$ is an aryl group, a monovalent

heterocyclic group or a substituted amino group, it is more preferable that $R^{22B}$ is an aryl group, a monovalent heterocyclic group or a substituted amino group.

The iridium complex represented by the formula (4) includes, for example, iridium complexes shown below.

[Chemical Formula 26]

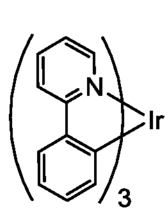

**Ir(ppy)$_3$**

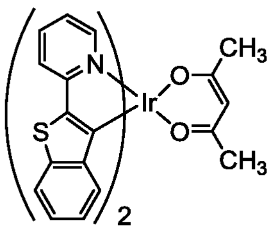

**Btp$_2$Ir(acac)**

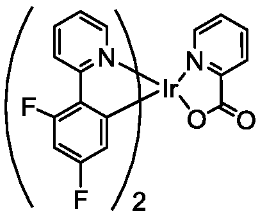

**FIrpic**

[Chemical Formula 27]

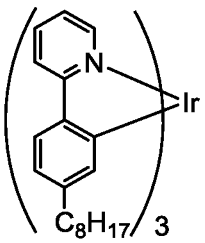

**COM-1**

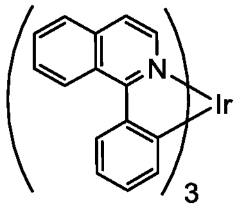

**COM-2**

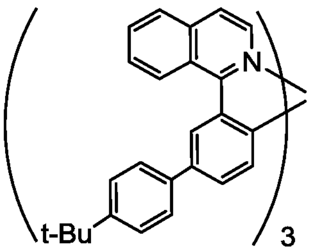

**COM-3**

[Chemical Formula 28]

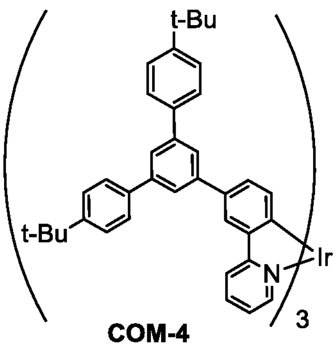

**COM-4**

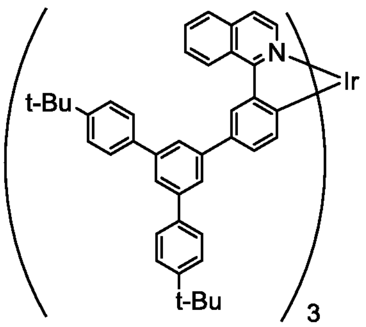

**COM-5**

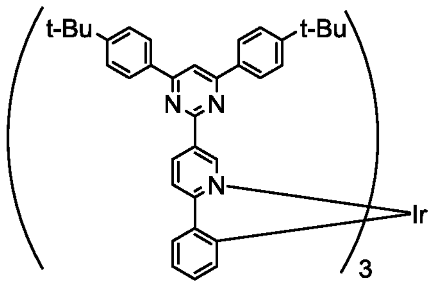

**COM-6**

[Chemical Formula 29]

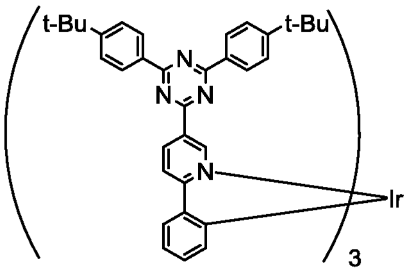

COM-7

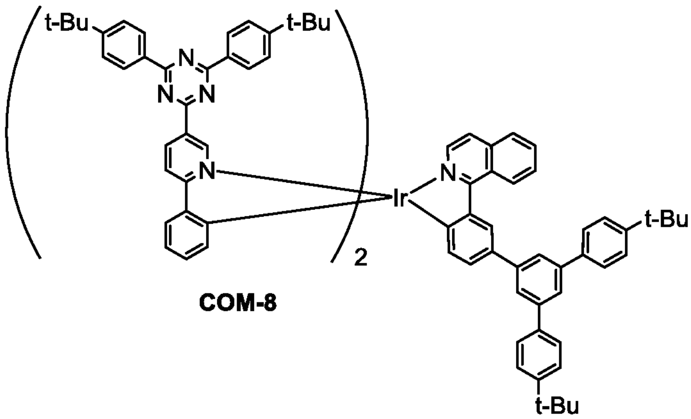

COM-8

[Chemical Formula 30]

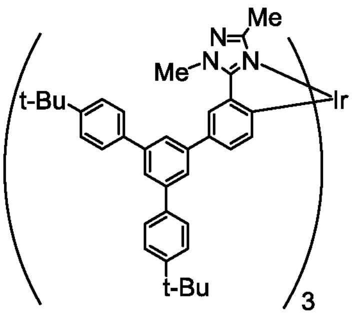

COM-9

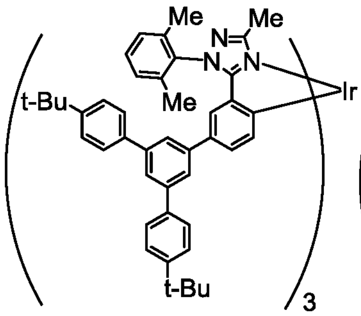

COM-10

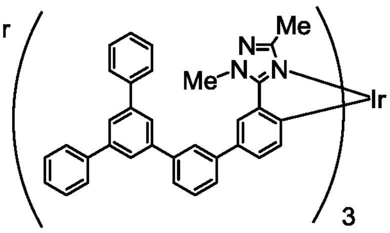

COM-11

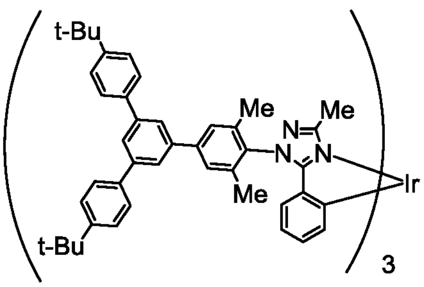

COM-12

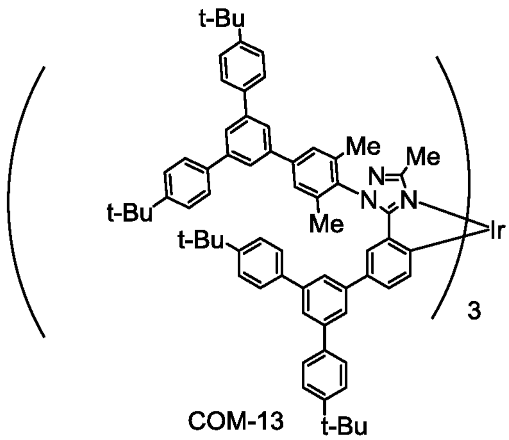

COM-13

[Chemical Formula 31]

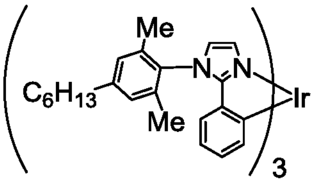

COM-14

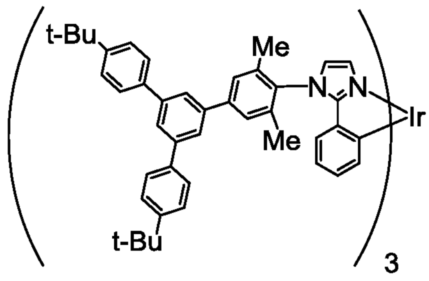

COM-15

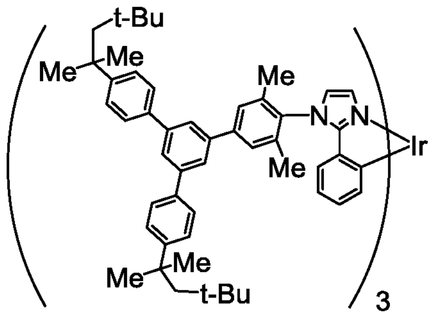

COM-16

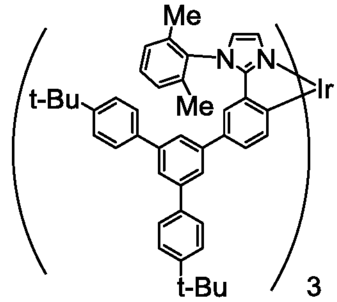

COM-17

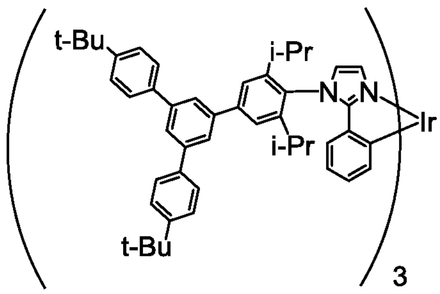

COM-18

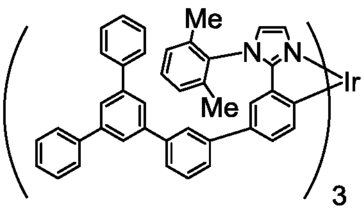

COM-19

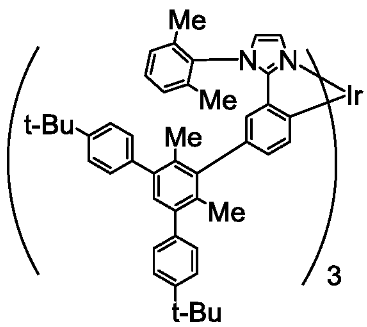

COM-20

The iridium complex can be synthesized, for example, according to methods described in Japanese Patent Application National Publication No. 2004-530254, JP-A No. 2008-179617, JP-A No. 2011-105701, Japanese Patent Application National Publication No. 2007-504272, JP-A No. 2013-147449 and JP-A No. 2013-147450.

In the method of producing a light emitting device of the present invention, for formation of a light emitting layer an iridium complex may be used each singly, or two or more iridium complexes may be used in combination. By simultaneously using two or more iridium complexes having emission spectra the maximum peak wavelengths of which are different, emission color can be controlled and a light emitting device exhibiting white emission can also be produced.

The polymer compound comprising a constitutional unit derived from an iridium complex is a polymer compound comprising a constitutional unit having a group obtained by removing one or more hydrogen atoms from an iridium complex of formula (4).

The constitutional unit derived from an iridium complex of formula (4) includes, for example, a group obtained by removing one hydrogen atom from an iridium complex, an arylene group or a divalent heterocyclic group having as a substituent a group obtained by removing one hydrogen atom from an iridium complex, a group obtained by removing two hydrogen atoms from an iridium complex, and a group obtained by removing three hydrogen atoms from an iridium complex.

When the constitutional unit derived from an iridium complex of formula (4) is a group obtained by removing one hydrogen atom from an iridium complex, the polymer compound comprising the constitutional unit derived from an iridium complex comprises this constitutional unit as an end constitutional unit. When the constitutional unit derived from an iridium complex is a group obtained by removing three hydrogen atoms from an iridium complex, the polymer compound comprising the constitutional unit derived from an iridium complex is branched at the position of this constitutional unit.

The polymer compound comprising a constitutional unit derived from an iridium complex preferably comprises at least one constitutional unit selected from the group consisting of a constitutional unit represented by the formula (Y) and a constitutional unit represented by the formula (X) described later, more preferably comprises a constitutional unit represented by the formula (Y).

In the method of producing a light emitting device of the present invention, for formation of a light emitting layer a polymer compound comprising a constitutional unit derived from an iridium complex may be used singly, or two or more polymer compounds may be used in combination. By simultaneously using two or more constitutional units derived from an iridium complex having emission spectra the maximum peak wavelengths of which are different (may be a single polymer compound or two or more polymer compounds in combination), emission color can be controlled and a light emitting device exhibiting white emission can also be produced.

[Host material]

The light emitting layer is preferably formed by an application method by using an ink containing an iridium complex or a polymer compound comprising a constitutional unit derived from an iridium complex and a host material having at least one function selected from the group consisting of hole injectability, hole transportability, electron injectability and electron transportability, because a light emitting device produced by the production method of the present invention is more excellent in light emission efficiency. In the ink containing an iridium complex or a polymer compound comprising a constitutional unit derived from an iridium complex and a host material, the host material may be contained singly, or two or more host materials may be contained in combination.

In the ink containing an iridium complex or a polymer compound comprising a constitutional unit derived from an iridium complex and a host material, the content of an iridium complex or a polymer compound comprising a constitutional unit derived from an iridium complex is usually 0.1 to 80 parts by weight, preferably 0.5 to 70 parts by weight, more preferably 1 to 50 parts by weight, when the sum of the iridium complex or the polymer compound comprising a constitutional unit derived from an iridium complex and the host material is 100 parts by weight.

The lowest excited triplet state ($T_1$) of the host material preferably has energy level equal to or higher than $T_1$ of the iridium complex or the polymer compound comprising a constitutional unit derived from an iridium complex, because a light emitting device produced by the production method of the present invention is more excellent in light emission efficiency.

The host material is classified into low molecular weight compounds and polymer compounds.

The low molecular weight compound used as the host material includes, for example, a compound having a carbazole structure, a compound having a triarylamine structure, a compound having a phenanthroline structure, a compound having a triaryltriazine structure, a compound having an azole structure, a compound having a benzothiophene structure, a compound having a benzofuran structure, a compound having a fluorene structure and a compound having a spirofluorene structure.

The low molecular weight compound used as the host material is preferably a compound represented by the formula (H-1).

[Chemical Formula 32]

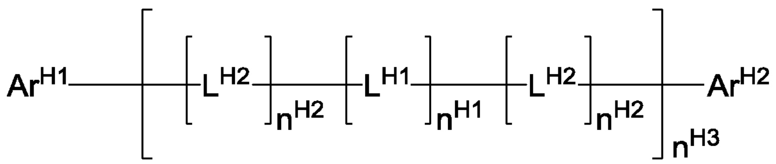

**(H-1)**

[wherein,

$Ar^{H1}$ and $Ar^{H2}$ each independently represent an aryl group or a monovalent heterocyclic group, and these groups each optionally have a substituent.

$n^{H1}$ and $n^{H2}$ each independently represent 0 or 1. When a plurality of $n^{H1}$ are present, they may be the same or different. The plurality of $n^{H2}$ may be the same or different.

$n^{H3}$ represents an integer of 0 or more.

$L^{H1}$ represents an arylene group, a divalent heterocyclic group or a group represented by-$[C(R^{H11})_2]n^{H11}$-, and these groups each optionally have a substituent. When a plurality of $L^{H1}$ are present, they may be the same or different. $n^{H11}$ represents an integer of 1 to 10. $R^{H11}$ represents a hydrogen atom, an alkyl group, a cycloalkyl group, an alkoxy group, a cycloalkoxy group, an aryl group or a monovalent heterocyclic group, and these groups each optionally have a substituent. The plurality of $R^{H11}$ may be the same or different and may be combined together to form a ring together with the carbon atoms to which they are attached.

$L^{H2}$ represents a group represented by -N(-$L^{H21}$-$R^{H21}$)-. When a plurality of $L^{H2}$ are present, they may be the same or different.

$L^{H21}$ represents a single bond, an arylene group or a divalent heterocyclic group, and these groups each optionally have a substituent. $R^{H21}$ represents a hydrogen atom, an alkyl group, a cycloalkyl group, an aryl group or a monovalent heterocyclic group, and these groups each optionally have a substituent.]

$Ar^{H1}$ and $Ar^{H2}$ are preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group or a phenothiazinyl group, more preferably a phenyl group, a spirobifluorenyl group, a pyridyl group, a pyrimidinyl group, a triazinyl group, a dibenzothienyl group, a dibenzofuryl group, a carbazolyl group or an azacarbazolyl group, further preferably a phenyl group, a pyridyl group, a carbazolyl group or an azacarbazolyl group, particularly preferably a group represented by the formula (TDA-1) or (TDA-3) described above, especially preferably a group represented by the formula (TDA-3) described above, and these groups each optionally have a substituent.

The substituent which $Ar^{H1}$ and $Ar^{H2}$ optionally have is preferably a halogen atom, an alkyl group, a cycloalkyl group, an alkoxy group, a cycloalkoxy group, an aryl group or a monovalent heterocyclic group, more preferably an alkyl group, a cycloalkoxy group, an alkoxy group or cycloalkoxy group, further preferably an alkyl group or cycloalkoxy group, and these groups each optionally further have a substituent.

$n^{H1}$ is preferably 1. $n^{H2}$ is preferably 0.

$n^{H3}$ is usually an integer of 0 to 10, preferably an integer of 0 to 5, further preferably an integer of 1 to 3, particularly preferably 1.

$n^{H11}$ is preferably an integer of 1 to 5, more preferably an integer of 1 to 3, further preferably 1.

$R^{H11}$ is preferably a hydrogen atom, an alkyl group, a cycloalkyl group, an aryl group or a monovalent heterocyclic group, more preferably a hydrogen atom, an alkyl group or a cycloalkyl group, further preferably a hydrogen atom or an alkyl group, and these groups each optionally have a substituent.

$L^{H1}$ is preferably an arylene group or a divalent heterocyclic group.

$L^{H1}$ is preferably a group represented by the formula (A-1) to (A-3), the formula (A-8) to (A-10), the formula (AA-1) to (AA-6), the formula (AA-10) to (AA-21) or the formula (AA-24) to (AA-34), more preferably a group represented by the formula (A-1), the formula (A-2), the formula (A-8), the formula (A-9), the formula (AA-1) to (AA-4), the formula (AA-10) to (AA-15) or the formula (AA-29) to (AA-34), further preferably a group represented by the formula (A-1), the formula (A-2), the formula (A-8), the formula (A-9), the formula (AA-2), the formula (AA-4) or the formula (AA-10) to (AA-15), particularly preferably a group represented by the formula (A-1), the formula (A-2), the formula (A-8), the formula (AA-2), the formula (AA-4), the formula (AA-10), the formula (AA-12) or the formula (AA-14), especially preferably a group represented by the formula (A-1), the formula (A-2), the formula (AA-2), the formula (AA-4) or the formula (AA-14).

The substituent which $L^{H1}$ optionally has is preferably a halogen atom, an alkyl group, a cycloalkyl group, an alkoxy group, a cycloalkoxy group, an aryl group or a monovalent heterocyclic group, more preferably an alkyl group, an alkoxy group, an aryl group or a monovalent heterocyclic group, further preferably an alkyl group, an aryl group or a monovalent heterocyclic group, and these groups each optionally further have a substituent.

$L^{H21}$ is preferably a single bond or an arylene group, more preferably a single bond, and this arylene group optionally has a substituent.

The definition and examples of the arylene group or the divalent heterocyclic group represented by $L^{H21}$ are the same as the definition and examples of the arylene group or the divalent heterocyclic group represented by $L^{H1}$.

$R^{H21}$ is preferably an aryl group or a monovalent heterocyclic group, and these groups each optionally have a substituent.

The definition and examples of the aryl group and the monovalent heterocyclic group represented by $R^{H21}$ are the same as the definition and examples of the aryl group and the monovalent heterocyclic group represented by $Ar^{H1}$ and $Ar^{H2}$.

The definition and examples of the substituent which $R^{H21}$ may optionally has are the same as the definition and examples of the substituent which $Ar^{H1}$ and $Ar^{H2}$ optionally have.

The compound represented by the formula (H-1) is preferably a compound represented by the formula (H-2).

[Chemical Formula 33]

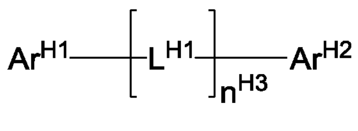

**(H-2)**

[wherein, $Ar^{H1}$, $Ar^{H2}$, $n^{H3}$ and $L^{H1}$ represent the same meaning as described above.]

As the compound represented by the formula (H-1), compounds represented by the following formulae (H-101) to (H-118) are exemplified.

[Chemical Formula 34]

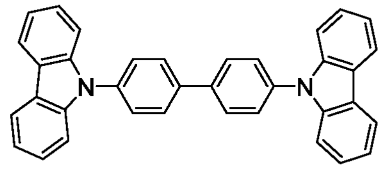

(H-101)

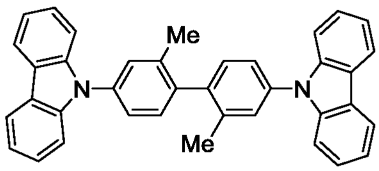

(H-102)

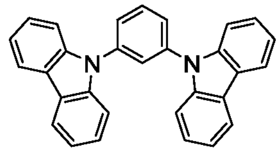

(H-103)

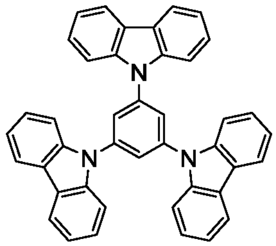

(H-104)

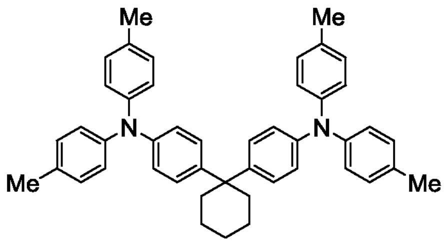

(H-105)

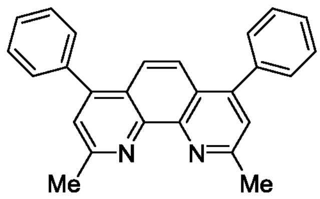

(H-106)

[Chemical Formula 35]

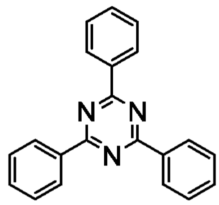

(H-107)

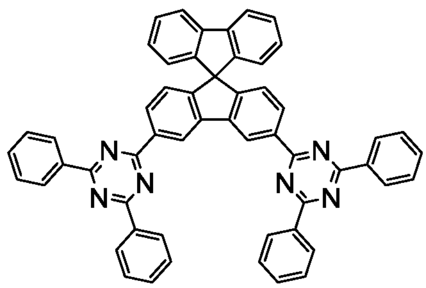

(H-108)

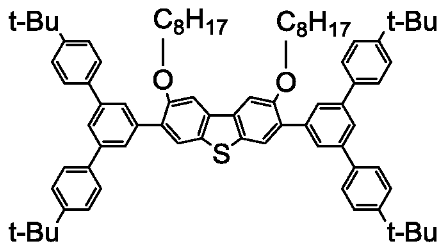

(H-109)

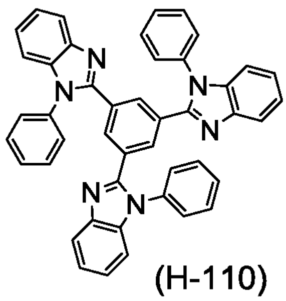

(H-110)

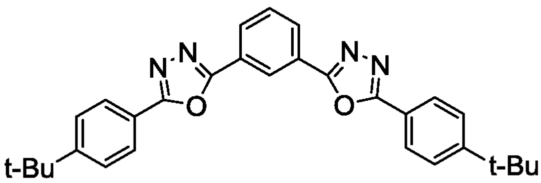

(H-111)

[Chemical Formula 36]

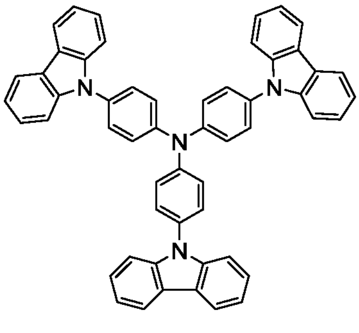

(H-112)

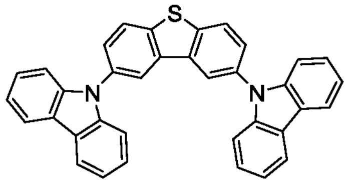

(H-113)

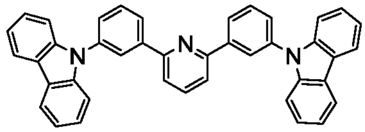

(H-114)

[Chemical Formula 37]

(H-112)

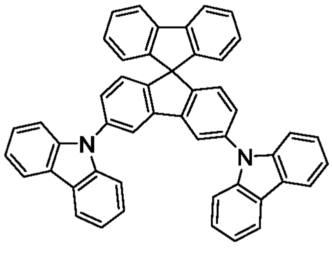

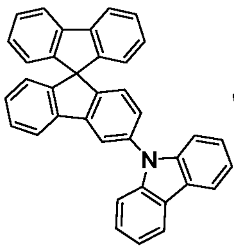

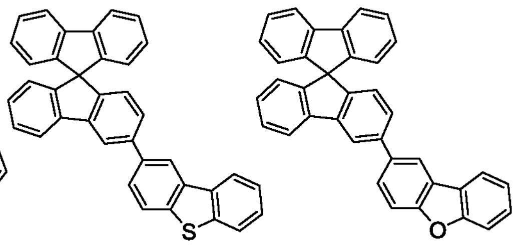

(H-115) (H-116) (H-117) (H-118)

The polymer compound used as a host material includes, for example, polymer compounds as a hole transporting material described later and polymer compounds as an electron transporting material described later.

[Polymer host]

The polymer compound which is preferable as a host compound (hereinafter, referred to as "polymer host") will be explained.

The polymer host is preferably a polymer compound comprising a constitutional unit represented by the formula (Y) .

[Chemical Formula 38]

[Chemical Formula 38]

$$-\!\left[Ar^{Y1}\right]\!- \quad (Y)$$

[wherein, $Ar^{Y1}$ represents an arylene group, a divalent heterocyclic group or a divalent group in which at least one arylene group and at least one divalent heterocyclic group are bonded directly to each other, and these groups each optionally have a substituent.]

The arylene group represented by $Ar^{Y1}$ is more preferably a group represented by the formula (A-1), the formula (A-2), the formula (A-6) to (A-10), the formula (A-19) or the formula (A-20), further preferably a group represented by the formula (A-1), the formula (A-2), the formula (A-7), the formula (A-9) or the formula (A-19), and these groups each

optionally have a substituent.

The divalent heterocyclic group represented by $Ar^{Y1}$ is more preferably a group represented by the formula (AA-1) to (AA-4), the formula (AA-10) to (AA-15), the formula (AA-18) to (AA-21), the formula (AA-33) or the formula (AA-34), further preferably a group represented by the formula (AA-4), the formula (AA-10), the formula (AA-12), the formula (AA-14) or the formula (AA-33), and these groups each optionally have a substituent.

The more preferable range and the further preferable range of the arylene group and the divalent heterocyclic group in the divalent group in which at least one arylene group and at least one divalent heterocyclic group are bonded directly to each other represented by $Ar^{Y1}$ are the same as the more preferable range and the further preferable range of the arylene group and the divalent heterocyclic group represented by $Ar^{Y1}$ described above, respectively.

"The divalent group in which at least one arylene group and at least one divalent heterocyclic group are bonded directly to each other" includes, for example, groups represented by the following formulae, and each of them optionally has a substituent.

[Chemical Formula 39]

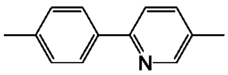
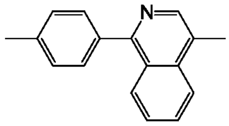
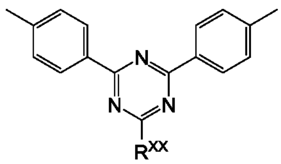
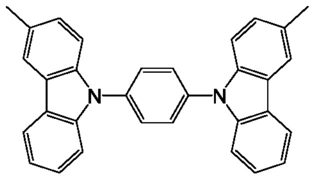

[wherein, $R^{XX}$ represents a hydrogen atom, an alkyl group, a cycloalkyl group, an aryl group or a monovalent heterocyclic group, and these groups each optionally have a substituent.]

$R^{XX}$ is preferably an alkyl group, a cycloalkyl group or an aryl group, and these groups each optionally have a substituent.

The substituent which the group represented by $Ar^{Y1}$ optionally has is preferably an alkyl group, a cycloalkyl group or an aryl group, and these groups each optionally further have a substituent.

The constitutional unit represented by the formula (Y) includes, for example, constitutional units represented by the formulae (Y-1) to (Y-10), and from the standpoint of the luminance life of a light emitting device produced by the production method of the present invention preferable are constitutional units represented by the formulae (Y-1) to (Y-3), from the standpoint of electron transportability of a light emitting device produced by the production method of the present invention preferable are constitutional units represented by the formulae (Y-4) to (Y-7), and from the standpoint of hole transportability of a light emitting device produced by the production method of the present invention preferable are constitutional units represented by the formulae (Y-8) to (Y-10).

[Chemical Formula 40]

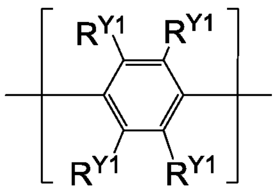
(Y-1)

[wherein, $R^{Y1}$ represents a hydrogen atom, an alkyl group, a cycloalkyl group, an alkoxy group, a cycloalkoxy group, an aryl group or a monovalent heterocyclic group, and these groups each optionally have a substituent. The plurality of $R^{Y1}$ may be the same or different, and adjacent $R^{Y1}$s may be combined together to form a ring together with the carbon atoms to which they are attached.]

$R^{Y1}$ is preferably a hydrogen atom, an alkyl group, a cycloalkyl group or an aryl group, and these groups each optionally have a substituent.

The constitional unit represented by the formula (Y-1) may be a constitutional unit represented by the formula (Y-1').

[Chemical Formula 41]

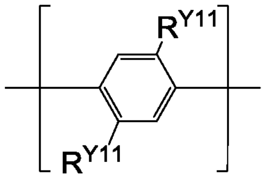

(Y-1')

[wherein, $R^{Y11}$ represents an alkyl group, a cycloalkyl group, an alkoxy group, a cycloalkoxy group, an aryl group or a monovalent heterocyclic group, and these groups each optionally have a substituent. The plurality of $R^{Y11}$ may be the same or different.]

$R^{Y11}$ is preferably an alkyl group, a cycloalkyl group or an aryl group, more preferably an alkyl group or a cycloalkyl group, and these groups each optionally have a substituent.

[Chemical Formula 42]

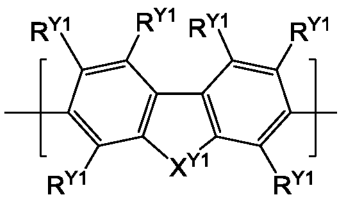

(Y-2)

[wherein,

$R^{Y1}$ represents the same meaning as described above.
$X^{Y1}$ represents a group represented by $-C(R^{Y2})_2-$,$-C(R^{Y2})=C(R^{Y2})-$ or $-C(R^{Y2})_2-C(R^{Y2})_2-$. $R^{Y2}$ represents a hydrogen atom, an alkyl group, a cycloalkyl group, an alkoxy group, a cycloalkoxy group, an aryl group or a monovalent heterocyclic group and these groups each optionally have a substituent. The plurality of $R^{Y2}$ may be the same or different, and groups $R^{Y2}$ may be combined together to form a ring together with the carbon atoms to which they are attached.]

$R^{Y2}$ is preferably an alkyl group, a cycloalkyl group, an aryl group or a monovalent heterocyclic group, more preferably an alkyl group a cycloalkyl group or an aryl group, and these groups each optionally have a substituent.

Regarding the combination of two $R^{Y2}$s in the group represented by $-C(R^{Y2})_2-$ in $X^{Y1}$, it is preferable that the both are an alkyl group or a cycloalkyl group, the both are an aryl group, the both are a monovalent heterocyclic group, or one is an alkyl group or a cycloalkyl group and the other is an aryl group or a monovalent heterocyclic group, it is more preferable that one is an alkyl group or cycloalkyl group and the other is an aryl group, and these groups each optionally have a substituent. The two groups $R^{Y2}$ may be combined together to form a ring together with the atoms to which they are attached, and when the groups $R^{Y2}$ form a ring, the group represented by $-C(R^{Y2})_2-$ is preferably a group represented by the formula (Y-A1) to (Y-A5), more preferably a group represented by the formula (Y-A4), and these groups each optionally have a substituent.

[Chemical Formula 43]

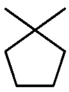

(Y-A1)

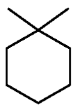

(Y-A2)

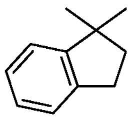

(Y-A3)

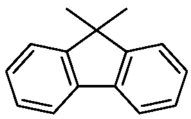

(Y-A4)

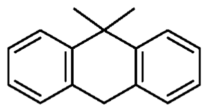

(Y-A5)

Regarding the combination of two $R^{Y2}$s in the group represented by $-C(R^{Y2})=C(R^{Y2})-$ in $X^{Y1}$, it is preferable that the both are an alkyl group or cycloalkyl group, or one is an alkyl group or a cycloalkyl group and the other is an aryl group, and these groups each optionally have a substituent.

Four $R^{Y2}$s in the group represented by $-C(R^{Y2})_2-C(R^{Y2})_2-$in $X^{Y1}$ are preferably an alkyl group or a cycloalkyl

group each optionally having a substituent. The plurality of $R^{Y2}$ may be combined together to form a ring together with the atoms to which they are attached, and when the groups $R^{Y2}$ form a ring, the group represented by $-C(R^{Y2})_2-C(R^{Y2})_2-$ is preferably a group represented by the formula (Y-B1) to (Y-B5), more preferably a group represented by the formula (Y-B3), and these groups each optionally have a substituent.

[Chemical Formula 44]

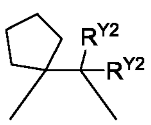
(Y-B1)

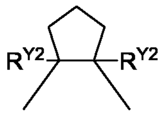
(Y-B2)

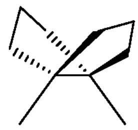
(Y-B3)

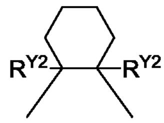
(Y-B4)

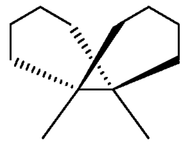
(Y-B5)

[wherein, $R^{Y2}$ represents the same meaning as described above.]

The constitutional unit represented by the formula (Y-2) may be a constitutional unit represented by the formula (Y-2').

[Chemical Formula 45]

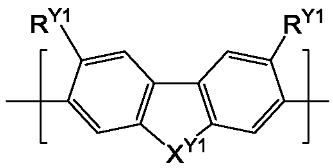
(Y-2')

[wherein, $R^{Y1}$ and $X^{Y1}$ represent the same meaning as described above.]

[Chemical Formula 46]

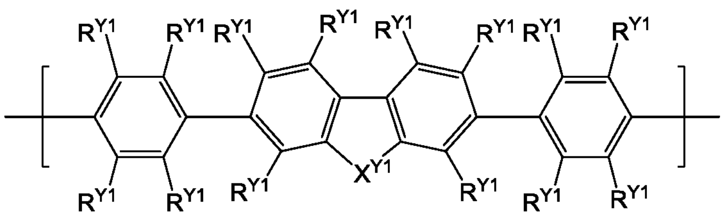
(Y-3)

[wherein, $R^{Y1}$ and $X^{Y1}$ represent the same meaning as described above.]

The constitutional unit represented by the formula (Y-3) may be a constitutional unit represented by the formula (Y-3').

[Chemical Formula 47]

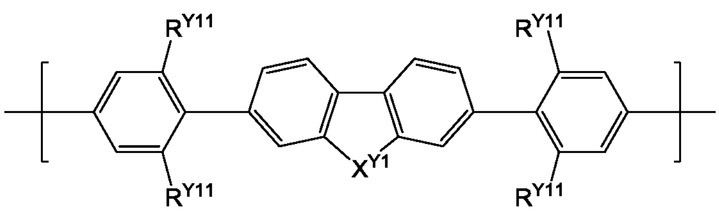
(Y-3')

[wherein, $R^{Y11}$ and $X^{Y1}$ represent the same meaning as described above.]

[Chemical Formula 48]

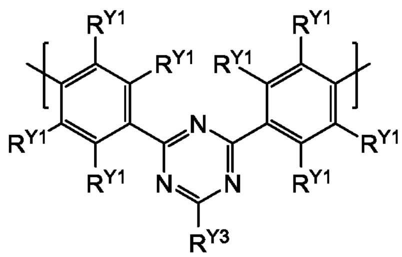

(Y-4)

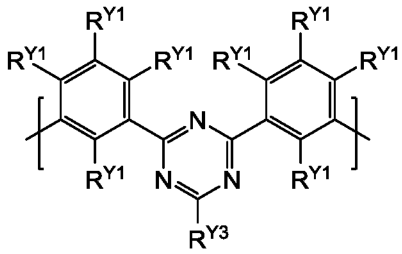

(Y-5)

[Chemical Formula 49]

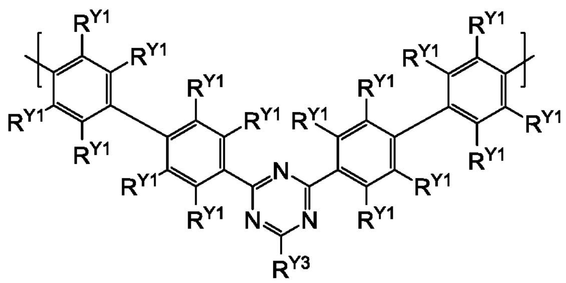

(Y-6)

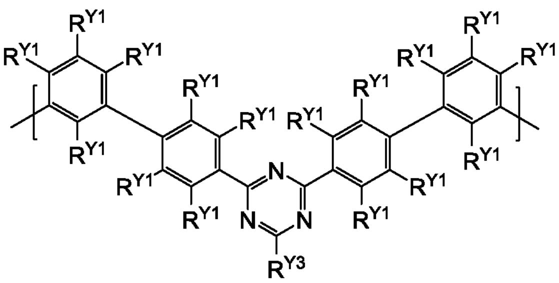

(Y-7)

[wherein, $R^{Y1}$ represents the same meaning as described above. $R^{Y3}$ represents a hydrogen atom, an alkyl group, a cycloalkyl group, an alkoxy group, a cycloalkoxy group, an aryl group or a monovalent heterocyclic group and these groups each optionally have a substituent.]

$R^{Y3}$ is preferably an alkyl group, a cycloalkyl group, an alkoxy group, a cycloalkoxy group, an aryl group or a monovalent heterocyclic group, more preferably an aryl group, and these groups each optionally have a substituent.

The constitutional unit represented by the formula (Y-4) may be a constitutional unit represented by the formula (Y-4'), and the constitutional unit represented by the formula (Y-6) may be a constitutional unit represented by the formula (Y-6').

[Chemical Formula 50]

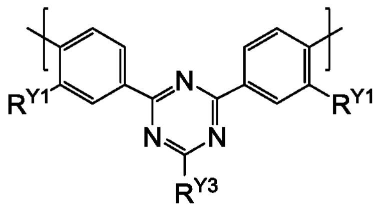

(Y-4')

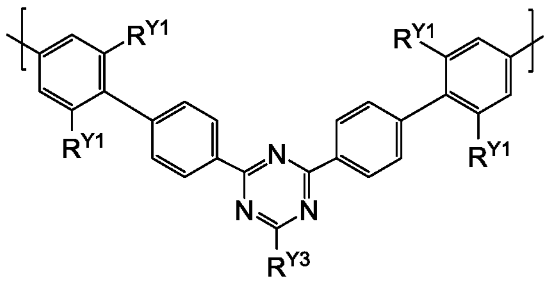

(Y-6')

[wherein, $R^{Y1}$ and $R^{Y3}$ represent the same meaning as described above.]

[Chemical Formula 51]

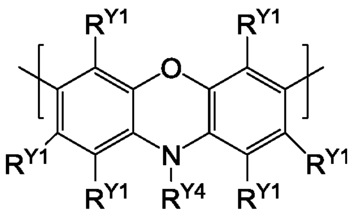
(Y-8)

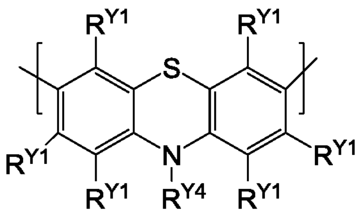
(Y-9)

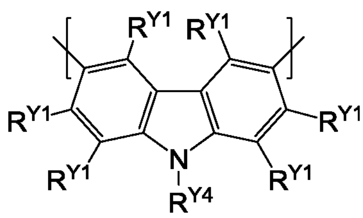
(Y-10)

[wherein, $R^{Y1}$ represents the same meaning as described above. $R^{Y4}$ represents a hydrogen atom, an alkyl group, a cycloalkyl group, an alkoxy group, a cycloalkoxy group, an aryl group or a monovalent heterocyclic group, and these groups each optionally have a substituent.]

$R^{Y4}$ is preferably an alkyl group, a cycloalkyl group, an alkoxy group, a cycloalkoxy group, an aryl group or a monovalent heterocyclic group, more preferably an aryl group, and these groups each optionally have a substituent.

The constitutional unit represented by the formula (Y) includes, for example, a constitutional unit composed of an arylene group represented by the formula (Y-101) to (Y-121), a constitutional unit composed of a divalent heterocyclic group represented by the formula (Y-201) to (Y-206), and a constitutional unit composed of a divalent group in which at least one arylene group and at least one divalent heterocyclic group are bonded directly to each other represented by the formula (Y-301) to (Y-304).

[Chemical Formula 52]

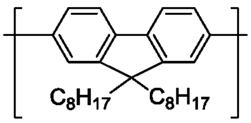
(Y-101)

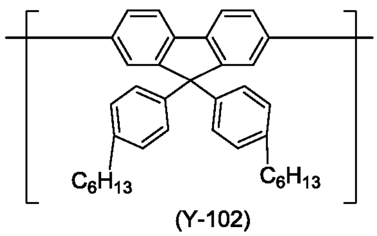
(Y-102)

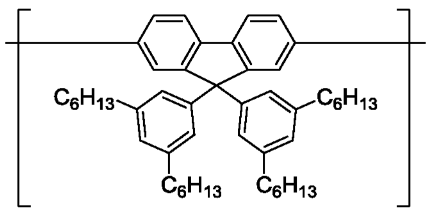
(Y-103)

[Chemical Formula 53]

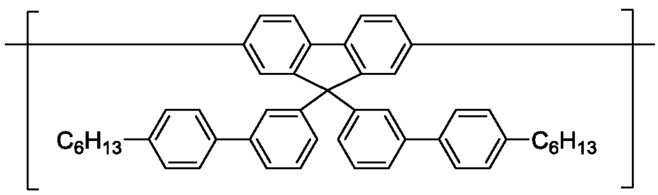
(Y-104)

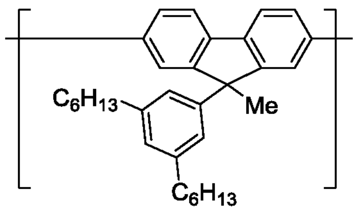
(Y-105)

[Chemical Formula 54]

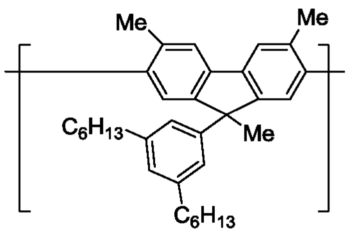
(Y-106)

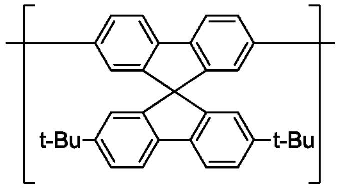
(Y-107)

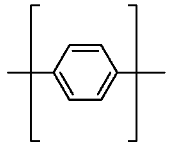
(Y-108)

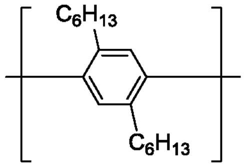
(Y-109)

[Chemical Formula 55]

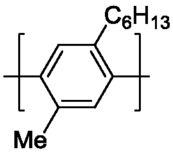
(Y-110)

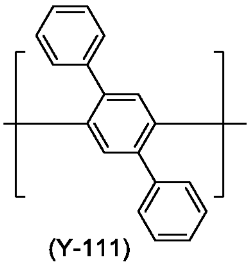
(Y-111)

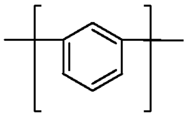
(Y-112)

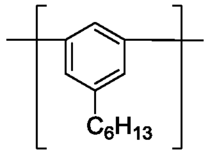
(Y-113)

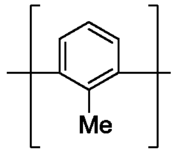
(Y-114)

[Chemical Formula 56]

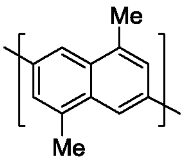
(Y-115)

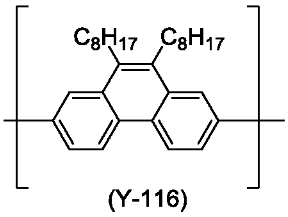
(Y-116)

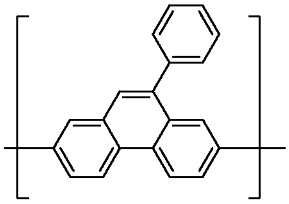
(Y-117)

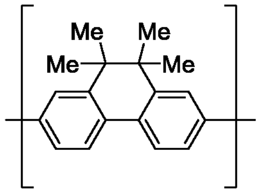
(Y-118)

[Chemical Formula 57]

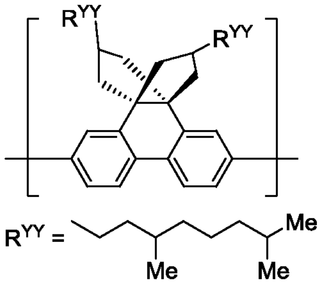
(Y-119)

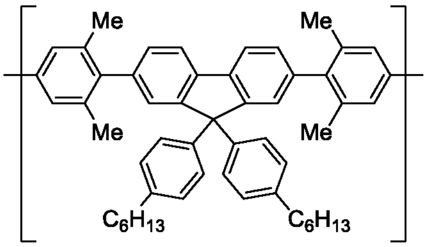
(Y-120)

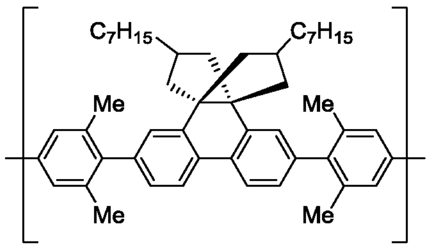
(Y-121)

[Chemical Formula 58]

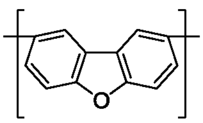
(Y-201)

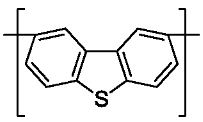
(Y-202)

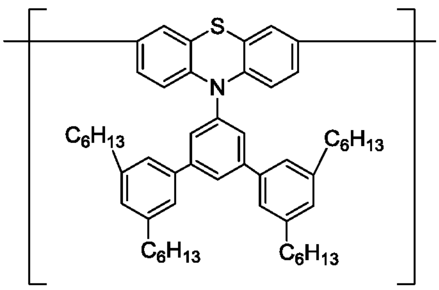
(Y-203)

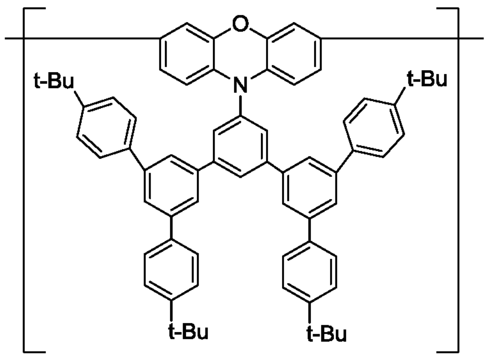
(Y-204)

[Chemical Formula 59]

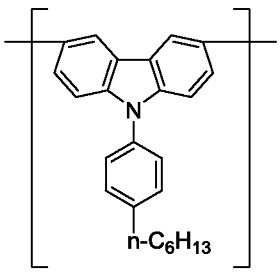

(Y-205)

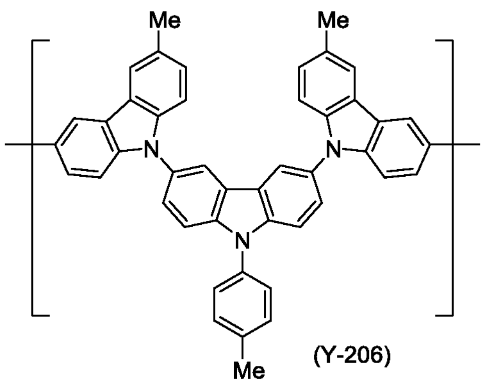

(Y-206)

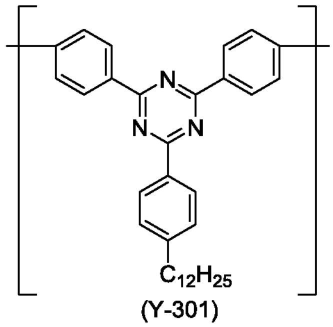

(Y-301)

[Chemical Formula 60]

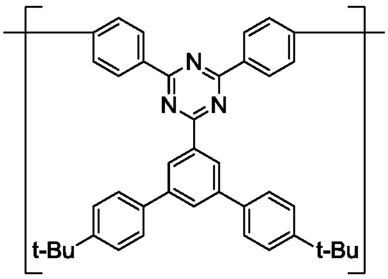

(Y-302)

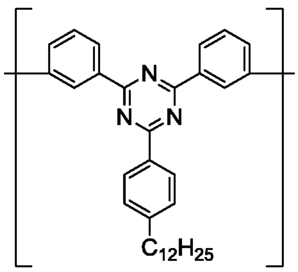

(Y-303)

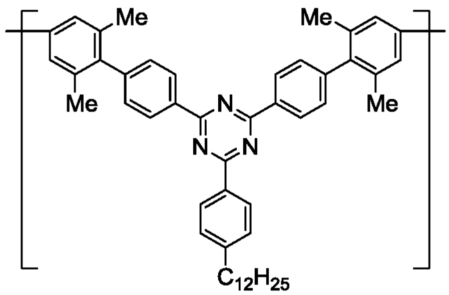

(Y-304)

The amount of the constitutional unit represented by the formula (Y) in which $Ar^{Y1}$ is an arylene group is preferably 0.5 to 80 mol%, more preferably 30 to 60 mol% with respect to the total amount of constitutional units contained in a polymer compound, because the luminance life of a light emitting device produced by the production method of the present invention is excellent.

The amount of the constitutional unit represented by the formula (Y) in which $Ar^{Y1}$ is a divalent heterocyclic group or a divalent group in which at least one arylene group and at least one divalent heterocyclic group are bonded directly to each other is preferably 0.5 to 30 mol%, more preferably 3 to 20 mol% with respect to the total amount of constitutional units contained in a polymer compound, because the charge transportability of a light emitting device produced by the production method of the present invention is excellent.

The constitutional unit represented by the formula (Y) may be contained only singly or two or more units thereof may be contained in the polymer host.

It is preferable that the polymer host further comprises a constitutional unit represented by the following formula (X), because hole transportability is excellent.

[Chemical Formula 61]

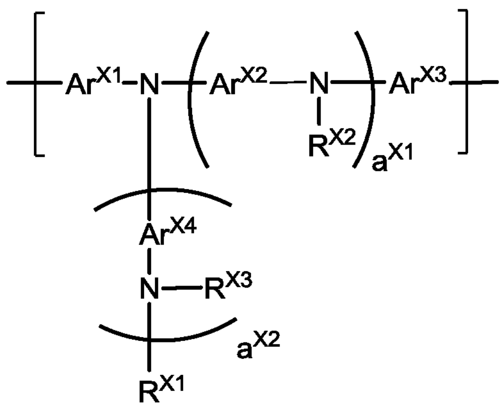

(X)

[wherein,

$a^{X1}$ and $a^{X2}$ each independently represent an integer of 0 or more.
$Ar^{X1}$ and $Ar^{X3}$ each independently represent an arylene group or a divalent heterocyclic group, and these groups each optionally have a substituent.
$Ar^{X2}$ and $Ar^{X4}$ each independently represent an arylene group, a divalent heterocyclic group or a divalent group in which at least one arylene group and at least one divalent heterocyclic group are bonded directly to each other, and these groups each optionally have a substituent.
$R^{X1}$, $R^{X2}$ and $R^{X3}$ each independently represent a hydrogen atom, an alkyl group, a cycloalkyl group, an aryl group or a monovalent heterocyclic group, and these groups each optionally have a substituent.]

$a^{X1}$ is preferably 2 or less, more preferably 1, because the luminance life of a light emitting device produced by the production method of the present invention is excellent.
$a^{X2}$ is preferably 2 or less, more preferably 0, because the luminance life of a light emitting device produced by the production method of the present invention is excellent.
$R^{X1}$, $R^{X2}$ and $R^{X3}$ are preferably an alkyl group, a cycloalkyl group, an aryl group or a monovalent heterocyclic group, more preferably an aryl group, and these groups each optionally have a substituent.
The arylene group represented by $Ar^{X1}$ and $Ar^{X3}$ is more preferably a group represented by the formula (A-1) or the formula (A-9), further preferably a group represented by the formula (A-1), and these groups each optionally have a substituent.
The divalent heterocyclic group represented by $Ar^{X1}$ and $Ar^{X3}$ is more preferably a group represented by the formula (AA-1), the formula (AA-2) or the formula (AA-7) to (AA-26), and these groups each optionally have a substituent.
$Ar^{X1}$ and $Ar^{X3}$ are preferably an arylene group optionally having a substituent.
The arylene group represented by $Ar^{X2}$ and $Ar^{X4}$ is more preferably a group represented by the formula (A-1), the formula (A-6), the formula (A-7), the formula (A-9) to (A-11) or the formula (A-19), and these groups each optionally have a substituent.
The more preferable range of the divalent heterocyclic group represented by $Ar^{X2}$ and $Ar^{X4}$ is the same as the more preferable range of the divalent heterocyclic group represented by $Ar^{X1}$ and $Ar^{X3}$.
The more preferable range and the further preferable range of the arylene group and the divalent heterocyclic group in the divalent group in which at least one arylene group and at least one divalent heterocyclic group are bonded directly to each other represented by $Ar^{X2}$ and $Ar^{X4}$ are the same as the more preferable range and the further preferable range of the arylene group and the divalent heterocyclic group represented by $Ar^{X1}$ and $Ar^{X3}$, respectively.
The divalent group in which at least one arylene group and at least one divalent heterocyclic group are bonded directly to each other represented by $Ar^{X2}$ and $Ar^{X4}$ includes the same groups as the divalent group in which at least one arylene group and at least one divalent heterocyclic group are bonded directly to each other represented by $Ar^{Y1}$ in the formula (Y).
$Ar^{X2}$ and $Ar^{X4}$ are preferably an arylene group optionally having a substituent.
The substituent which the group represented by $Ar^{X1}$ to $Ar^{X4}$ and $R^{X1}$ to $R^{X3}$ optionally has is preferably an alkyl group, a cycloalkyl group or an aryl group, and these groups each optionally further have a substituent.
The constitutional unit represented by the formula (X) is preferably a constitutional unit represented by the formula (X-1) to (X-7), more preferably a constitutional unit represented by the formula (X-1) to (X-6), further preferably a constitutional unit represented by the formula (X-3) to (X-6).

[Chemical Formula 62]

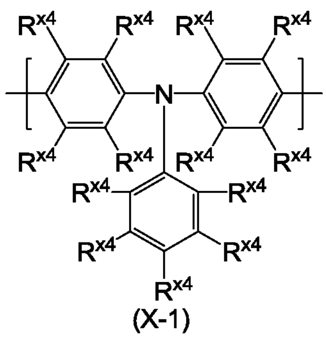
(X-1)

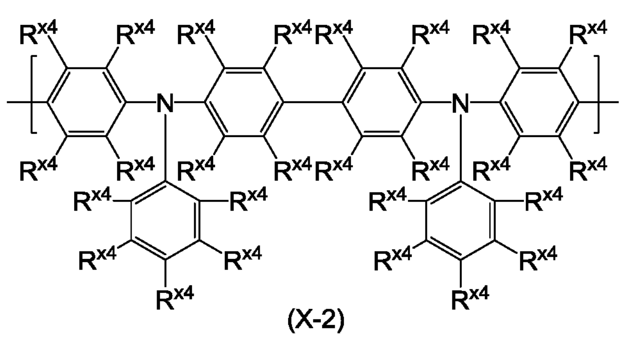
(X-2)

[Chemical Formula 63]

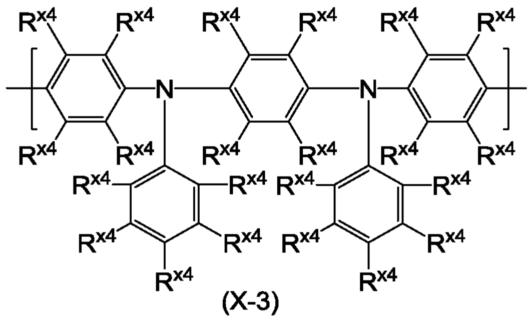

(X-3)

[Chemical Formula 64]

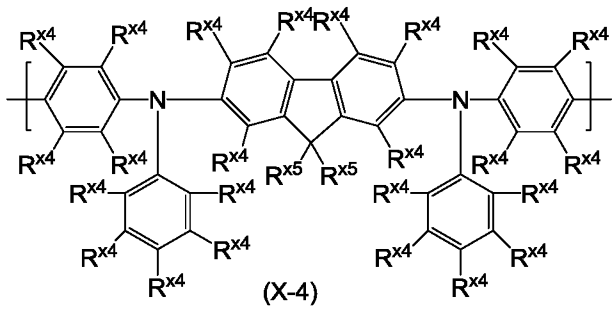

(X-4)

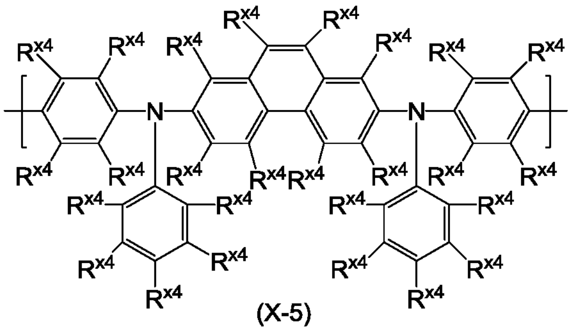

(X-5)

[Chemical Formula 65]

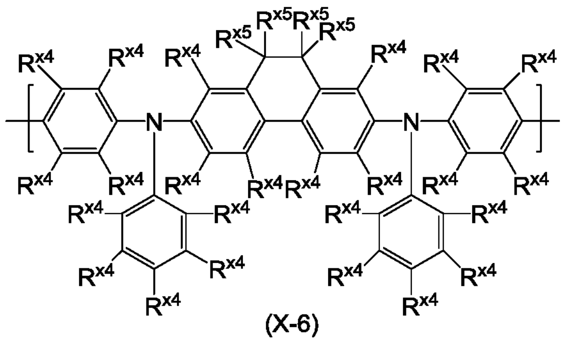

(X-6)

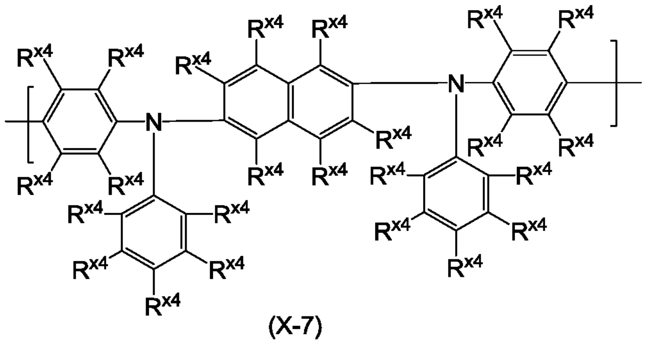

(X-7)

[wherein, $R^{X4}$ and $R^{X5}$ each independently represent a hydrogen atom, an alkyl group, a cycloalkyl group, an alkoxy group, a cycloalkoxy group, an aryl group, an aryloxy group, a halogen atom, a monovalent heterocyclic group or a cyano group, and these groups each optionally have a substituent. The plurality of $R^{X4}$ may be the same or different. The plurality of $R^{X5}$ may be the same or different, and adjacent groups $R^{X5}$ may be combined together to form a ring together with the carbon atoms to which they are attached.]

The amount of the constitutional unit represented by the formula (X) is preferably 0.1 to 50 mol%, more preferably 1 to 40 mol%, further preferably 5 to 30 mol% with respect to the total amount of constitutional units contained in a polymer host, because hole transportability is excellent.

The constitutional unit represented by the formula (X) includes, for example, constitutional units represented by the formulae (X1-1) to (X1-11), preferably constitutional units represented by the formulae (X1-3) to (X1-10).

[Chemical Formula 66]

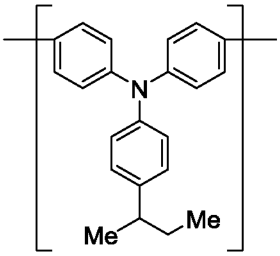

(X1-1)

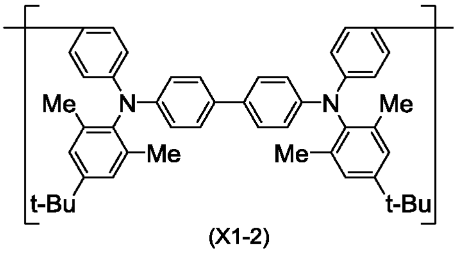

(X1-2)

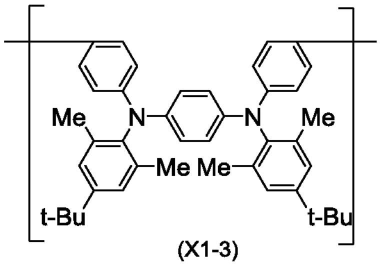

(X1-3)

[Chemical Formula 67]

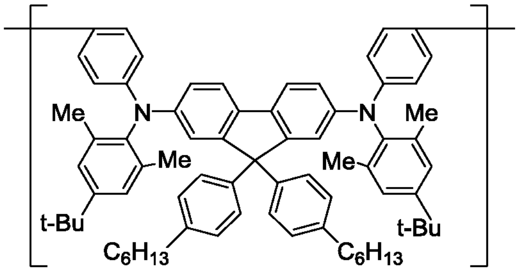

(X1-4)

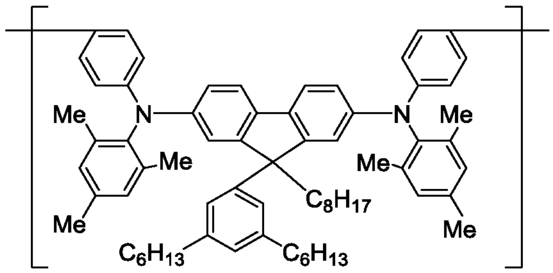

(X1-5)

[Chemical Formula 68]

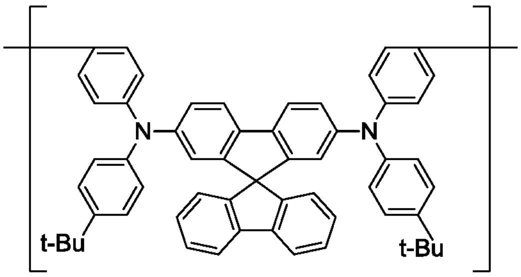

(X1-6)

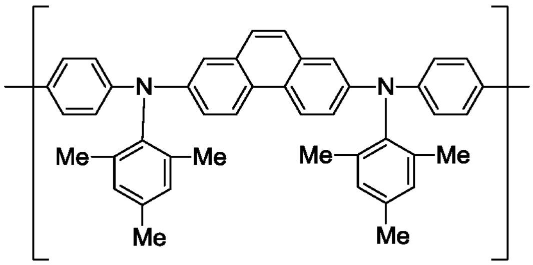

(X1-7)

[Chemical Formula 69]

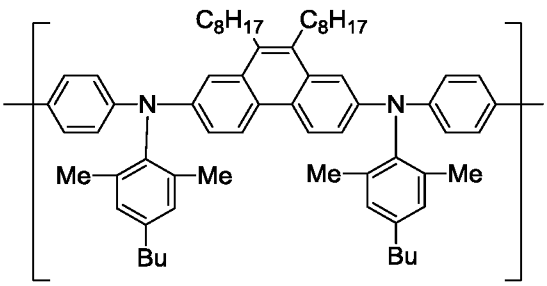

(X1-8)

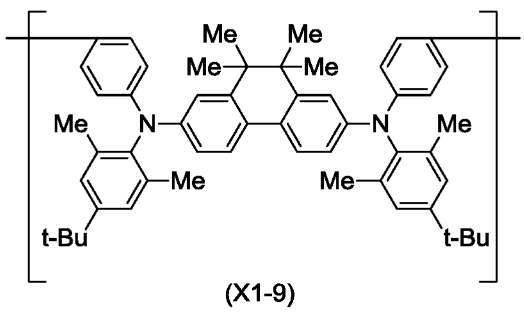

(X1-9)

[Chemical Formula 70]

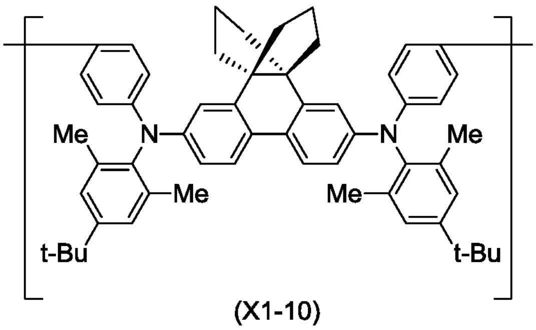

(X1-10)

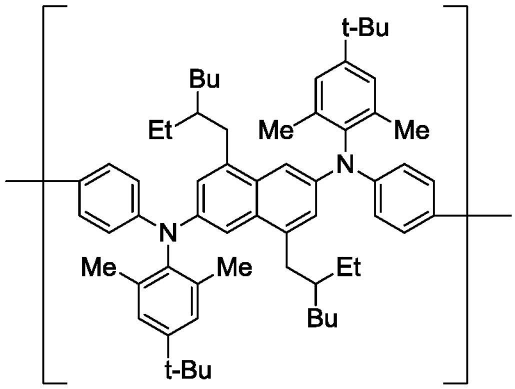

(X1-11)

The constitutional unit represented by the formula (X) may be contained only singly or two or more units thereof may be contained in the polymer host.

Examples of the polymer host include polymer compounds (P-1) to (P-6) in the Table 1.

[Table 1]

| polymer compound | constitutional unit and mole fraction thereof | | | | |
|---|---|---|---|---|---|
| | formula (Y) | | | formula (X) | other |
| | formulae (Y-1) to (Y-3) | formulae (Y-4) to (Y-7) | formulae (Y-8) to (Y-10) | formulae (X-1) to (X-7) | |
| | p | q | r | s | t |
| (P-1) | 0.1 to 99.9 | 0.1 to 99.9 | 0 | 0 | 0 to 30 |
| (P-2) | 0.1 to 99.9 | 0 | 0.1 to 99.9 | 0 | 0 to 30 |
| (P-3) | 0.1 to 99.8 | 0.1 to 99.8 | 0 | 0.1 to 99.8 | 0 to 30 |
| (P-4) | 0.1 to 99.8 | 0.1 to 99.8 | 0.1 to 99.8 | 0 | 0 to 30 |
| (P-5) | 0.1 to 99.8 | 0 | 0.1 to 99.8 | 0.1 to 99.8 | 0 to 30 |
| (P-6) | 0.1 to 99.7 | 0.1 to 99.7 | 0.1 to 99.7 | 0.1 to 99.7 | 0 to 30 |

[In the table, p, q, r, s and t represent the mole fraction of each constitutional unit. $p+q+r+s+t = 100$, and $100 \geq p+q+r+s \geq 70$. Other constitutional unit denotes a constitutional unit other than the constitutional unit represented by the formula (Y) and the constitutional unit represented by the formula (X).]

The polymer host may be any of a block copolymer, a random copolymer, an alternating copolymer or a graft copolymer, and may also be another embodiment, and is preferably a copolymer produced by copolymerizing a plurality of raw material monomers.

<Production method of polymer host>

The polymer host can be produced by using a known polymerization method described in Chem. Rev., vol. 109, pp. 897-1091 (2009) and the like, exemplified are methods of causing polymerization by a coupling reaction using a transition metal catalyst such as the Suzuki reaction, the Yamamoto reaction, the Buchwald reaction, the Stille reaction, the Negishi reaction and the Kumada reaction.

In the above-described polymerization method, the method of charging monomers includes, for example, a method in which the total amount of monomers is charged in a lump into the reaction system, a method in which monomers

are partially charged and reacted, then, the remaining monomers are charged in a lump, continuously or in divided doses, and a method in which monomers are charged continuously or in divided doses.

The transition metal catalyst includes a palladium catalyst, a nicked catalyst and the like.

For the post treatment of the polymerization reaction, known methods, for example, a method of removing watersoluble impurities by liquid-separation, a method in which the reaction solution after the polymerization reaction is added to a lower alcohol such as methanol to cause deposition of a precipitate which is then filtrated before drying, and other methods, are used each singly or combined. When the purity of the polymer host is low, the polymer host can be purified by usual methods such as, for example, recrystallization, reprecipitation, continuous extraction with a Soxhlet extractor and column chromatography.

<Layer constitution of light emitting device>

The light emitting device produced by the production method of the present invention may comprise a layer other than an anode, a cathode, a light emitting layer and an encapsulating layer (hereinafter, referred to also as "other layer"). The other layer includes, for example, a hole transporting layer, a hole injection layer, an electron transporting layer and an electron injection layer.

The light emitting layer is formed by an application method using the ink described above containing materials of a light emitting layer (an iridium complex of formula (4) or a polymer compound comprising a constitutional unit derived from an iridium complex of formula (4); a host material), and the ink may contain other materials (for example, a light emitting material other than an iridium complex).

The hole transporting layer, the hole injection layer, the electron transporting layer and the electron injection layer comprise a hole transporting material, a hole injection material, an electron transporting material and an electron injection material, respectively, and can be formed by using a hole transporting material, a hole injection material, an electron transporting material and an electron injection material, respectively.

That is, one embodiment of the production method of the present invention is a method of producing a light emitting device comprising an anode, a cathode, a light emitting layer disposed between the anode and the cathode, and an encapsulating layer. In this case, the light emitting layer is formed on the anode or formed on the cathode.

Another embodiment of the production method of the present invention is a method of producing a light emitting device comprising an anode, a cathode, a light emitting layer disposed between the anode and the cathode, at least one layer selected from the group consisting of a hole injection layer and a hole transporting layer disposed between the anode and the light emitting layer, and an encapsulating layer. In this case, the light emitting layer is formed on at least one layer selected from the group consisting of a hole injection layer and a hole transporting layer, or formed on the cathode.

Another embodiment of the production method of the present invention is a method of producing a light emitting device comprising an anode, a cathode, a light emitting layer disposed between the anode and the cathode, at least one layer selected from the group consisting of an electron injection layer and an electron transporting layer disposed between the cathode and the light emitting layer, and an encapsulating layer. In this case, the light emitting layer is formed on the anode or formed on at least one layer selected from the group consisting of an electron injection layer and an electron transporting layer.

Another embodiment of the production method of the present invention is a method of producing a light emitting device comprising an anode, a cathode, a light emitting layer disposed between the anode and the cathode, at least one layer selected from the group consisting of a hole injection layer and a hole transporting layer disposed between the anode and the light emitting layer, at least one layer selected from the group consisting of an electron injection layer and an electron transporting layer disposed between the cathode and the light emitting layer, and an encapsulating layer. In this case, the light emitting layer is formed on at least one layer selected from the group consisting of a hole injection layer and a hole transporting layer, or formed on at least one layer selected from the group consisting of an electron injection layer and an electron transporting layer.

The light emitting material which may be contained in the ink described above containing materials of a light emitting layer (an iridium complex of formula (4) or a polymer compound comprising a constitutional unit derived from an iridium complex of formula (4); a host material) will be described later.

The order, the number and the thickness of layers to be laminated may be advantageously adjusted in view of the luminance life and the driving voltage of a light emitting device produced by the production method of the present invention.

The thicknesses of a hole transporting layer, a hole injection layer, an electron transporting layer and an electron injection layer are usually 1 nm to 10 μm.

The light emitting device produced by the production method of the present invention preferably comprises at least one of a hole injection layer and a hole transporting layer between an anode and a light emitting layer from the standpoint of hole injectability and hole transportability, and preferably comprises at least one of an electron injection

layer and an electron transporting layer between a cathode and a light emitting layer from the standpoint of electron injectability and electron transportability.

The method of forming a hole transporting layer, a hole injection layer, an electron transporting layer and an electron injection layer in a light emitting device produced by the production method of the present invention includes, for example, a vacuum vapor deposition method from a powder and a method by film formation from solution or melted state when a low molecular weight compound is used, and includes, for example, a method by film formation from solution or melted state when a polymer compound is used.

A hole transporting layer, a hole injection layer, an electron transporting layer and an electron injection layer can be formed by an application method by using inks containing a hole transporting material, a hole injection material, an electron transporting material and an electron injection material, respectively. Specific examples of the application method include the same examples as the specific examples of the application method in formation of a light emitting layer described above. Specific examples of a solvent contained in the ink include the same examples as the specific examples of a solvent contained in the ink in formation of a light emitting layer described above.

In the ink, the compounding amount of a solvent is usually 1000 to 100000 parts by weight, preferably 2000 to 20000 parts by weight with respect to 100 parts by weight of a hole transporting material, a hole injection material, an electron transporting material or an electron injection material.

When the material of a hole transporting layer, the material of an electron transporting layer and the material of a light emitting layer are soluble in solvents used in forming layers adjacent to a hole transporting layer, an electron transporting layer and a light emitting layer, respectively, in the method of producing a light emitting device of the present invention, it is preferable that the material has a crosslinkable group for avoiding dissolution of the material in the solvent. After formation of each layer using a material having a crosslinkable group, the crosslinkable group can be cross-linked to insolubilize the layer.

The temperature of heating for crosslinking each layer is usually 25 to 300°C, and it is preferably 50 to 250°C, more preferably 150 to 200°C, because a light emitting device produced by the production method of the present invention is excellent in luminance life.

The kind of light used in light irradiation for crosslinking each layer includes, for example, ultraviolet light, near ultraviolet light and visible light.

[Substrate/electrode]

The light emitting device produced by the production method of the present invention usually comprises a substrate. The substrate which the light emitting device comprises may advantageously be a substrate on which an electrode can be formed and which does not chemically change in forming an organic layer, and is a substrate made of a material such as, for example, glass, plastic and silicon. In the case of using an opaque substrate, it is preferable that an electrode most remote from the substrate is transparent or semi-transparent.

The material of the anode includes, for example, electrically conductive metal oxides and semi-transparent metals, preferably, indium oxide, zinc oxide and tin oxide; electrically conductive compounds such as indium·tin·oxide (ITO) and indium·zinc·oxide; a composite of silver, palladium and copper (APC); NESA, gold, platinum, silver and copper.

The material of the cathode includes, for example, metals such as lithium, sodium, potassium, rubidium, cesium, beryllium, magnesium, calcium, strontium, barium, aluminum, zinc and indium; alloys composed of two or more of them; alloys composed of one or more of them and at least one of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

The anode and the cathode each may be a laminated structure composed of two or more layers.

In the light emitting device produced by the production method of the present invention, at least one of the anode and the cathode is usually transparent or semi-transparent, and it is preferable that the anode is transparent or semi-transparent.

Methods for forming the anode and the cathode include, for example, vacuum vapor deposition method, sputtering method, ion plating method, plating method, lamination method and the like.

[Light emitting material]

The light emitting material which may be contained in the ink described above containing materials of a light emitting layer (an iridium complex of formula (4) or a polymer compound comprising a constitutional unit derived from an iridium complex of formula (4); a host material) includes, for example, naphthalene and derivatives thereof, anthracene and derivatives thereof, perylene and derivatives thereof, and metal complexes having platinum or europium as the central metal.

[Hole transporting material]

The hole transporting material is classified into low molecular weight compounds and polymer compounds, and polymer compounds are preferable. The hole transporting material optionally has a crosslinkable group.
The polymer compound includes, for example, polyvinylcarbazole and derivatives thereof; polyarylene having an aromatic amine structure in the side chain or main chain and derivatives thereof. The polymer compound may also be a compound in which an electron accepting portion is linked. The electron accepting portion includes, for example, fullerene, tetrafluorotetracyanoquinodimethane, tetracyanoethylene, trinitrofluorenone and the like, preferably fullerene.
The hole transporting material may be used singly, or two or more hole transporting materials may be used in combination.

[Electron transporting material]

The electron transporting material is classified into low molecular weight compounds and polymer compounds. The electron transporting material optionally has a crosslinkable group.
The low molecular weight compound includes, for example, a metal complex having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene, diphenoquinone and derivatives thereof.
The polymer compound includes, for example, polyphenylene, polyfluorene and derivatives thereof. These polymer compounds may be doped with a metal.
The electron transporting material may be used singly, or two or more electron transporting materials may be used in combination.
When the light emitting device produced by the production method of the present invention comprises an electron transporting layer, the electron transporting material used for forming the electron transporting layer is preferably a polymer compound comprising at least one constitutional unit selected from the group consisting of a constitutional unit represented by the formula (ET-1) and a constitutional unit represented by the formula (ET-2).

[Chemical Formula 71]

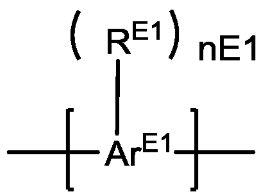

(ET-1)

[wherein,

nE1 represents an integer of 1 or more.
$Ar^{E1}$ represents an aromatic hydrocarbon group or a heterocyclic group, and these groups each optionally have a substituent other than $R^{E1}$.
$R^{E1}$ represents a group represented by the formula (ES-1). When a plurality of $R^{E1}$ are present, they may be the same or different.]

$$-(R^{E3})_{cE1}-(Q^{E1})_{nE4}-Y^{E1}(M^{E2})_{aE1}(Z^{E1})_{bE1} \qquad \text{(ES-1)}$$

[wherein,

cE1 represents 0 or 1, nE4 represents an integer of 0 or more, aE1 represents an integer of 1 or more, and bE1 represents an integer of 0 or more.
$R^{E3}$ represents an arylene group or a divalent heterocyclic group, and these groups each optionally have a substituent.
$Q^{E1}$ represents an alkylene group, an arylene group, an oxygen atom or a sulfur atom, and these groups each optionally have a substituent. When a plurality of $Q^{E1}$ are present, they may be the same or different.
$Y^{E1}$ represents $-CO_2^-$, $-SO_3^-$, $-SO_2^-$ or $PO_3^{2-}$.
$M^{E2}$ represents a metal cation or an ammonium cation, and this ammonium cation optionally has a substituent. When a plurality of $M^{E2}$ are present, they may be the same or different.

$Z^{E1}$ represents $F^-$, $Cl^-$, $Br^-$, $I^-$, $OH^-$, $R^{E4}SO_3^-$, $R^{E4}COO^-$, $ClO^-$, $ClO_2^-$, $ClO_3^-$, $ClO_4^-$, $SCN^-$, $CN^-$, $NO_3^-$, $SO_4^{2-}$, $HSO_4^-$, $PO_4^{3-}$, $HPO_4^{2-}$, $H_2PO_4^-$, $BF_4^-$ or $PF_6^-$. $R^{E4}$ represents an alkyl group, a cycloalkyl group or an aryl group, and these groups each optionally have a substituent. When a plurality of $Z^{E1}$ are present, they may be the same or different. aE1 and bE1 are selected so that the charge of the group represented by the formula (ES-1) is 0.]

nE1 is preferably an integer of 1 to 4, more preferably 1 or 2.

The aromatic hydrocarbon group or the heterocyclic group represented by $Ar^{E1}$ is preferably an atomic group remaining after removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group or a 2,7-carbazoledilyl group nE1 hydrogen atoms bonding directly to atoms constituting the ring, and optionally has a substituent other than $R^{E1}$.

The substituent other than $R^{E1}$ which $Ar^{E1}$ optionally has includes a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group, a cycloalkynyl group, a carboxyl group, and a group represented by the formula (ES-3).

$$-O(C_{n'}H_{2n'}O)_{nx}C_{m'}H_{2m'+1} \qquad \text{(ES-3)}$$

[wherein, n', m' and nx represent an integer of 1 or more.]

cE1 is preferably 0 or 1, and nE4 is preferably an integer of 0 to 6.

$R^{E3}$ is preferably an arylene group.

$Q^{E1}$ is preferably an alkylene group, an arylene group or an oxygen atom.

$Y^{E1}$ is preferably $-CO_2^-$ or $SO_3^-$.

$M^{E2}$ is preferably $Li^+$, $Na^+$, $K^+$, $Cs^+$, $N(CH_3)_4^+$, $NH(CH_3)_3^+$, $NH_2(CH_3)_2^+$ or $N(C_2H_5)_4^+$.

$Z^{E1}$ is preferably $F^-$, $Cl^-$, $Br^-$, $I^-$, $OH^-$, $R^{E4}SO_3^-$ or $R^{E4}COO^-$.

The substituent which $R^{E3}$ optionally has includes an alkyl group, a cycloalkyl group, an aryl group, a monovalent heterocyclic group and a group represented by the formula (ES-3). It is preferable that $R^{E3}$ has a group represented by the formula (ES-3) as a substituent, because a light emitting device produced by the production method of the present invention is more excellent in light emission efficiency.

The group represented by the formula (ES-1) includes, for example, groups represented by the following formulae.

[Chemical Formula 72]

$-COO^-M^+$ $\quad -CH_2-COO^-M^+$ $\quad -C_2H_4-COO^-M^+$

$-O-CH_2-COO^-M^+$ $\quad -O-C_2H_4\,COO^-M^+$

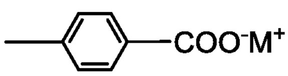
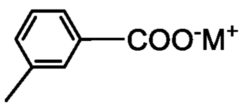
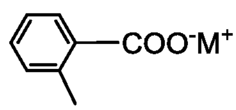

$-SO_3^-M^+$ $\quad -CH_2-SO_3^-M^+$ $\quad -C_2H_4-SO_3^-M^+$

$-O-CH_2-SO_3^-M^+$ $\quad -O-C_2H_4\cdot SO_3^-M^+$

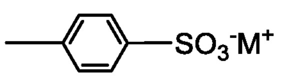
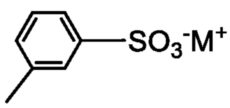
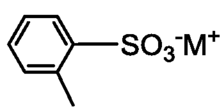

[wherein, $M^+$ represents $Li^+$, $Na^+$, $K^+$, $Cs^+$, $N(CH_3)_4^+$, $NH(CH_3)_3^+$, $NH_2(CH_3)_2^+$ or $N(C_2H_5)_4^+$.]

[Chemical Formula 73]

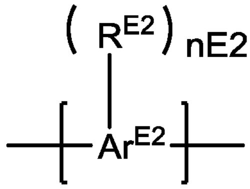

(ET-2)

[wherein,

nE2 represents an integer of 1 or more.
$Ar^{E2}$ represents an aromatic hydrocarbon group or a heterocyclic group, and these groups each optionally have a substituent other than $R^{E2}$.
$R^{E2}$ represents a group represented by the formula (ES-2). When a plurality of $R^{E2}$ are present, they may be the same or different.]

$$-(R^{E6})_{cE2}-(Q^{E2})_{nE6}-Y^{E2}(M^{E3})_{bE2}(Z^{E2})_{aE2} \qquad \text{(ES-2)}$$

[wherein,

cE2 represents 0 or 1, nE6 represents an integer of 0 or more, bE2 represents an integer of 1 or more, and aE2 represents an integer of 0 or more.
$R^{E6}$ represents an arylene group or a divalent heterocyclic group, and these groups each optionally have a substituent.
$Q^{E2}$ represents an alkylene group, an arylene group, an oxygen atom or a sulfur atom, and these groups each optionally have a substituent. When a plurality of $Q^{E2}$ are present, they may be the same or different.
$Y^{E2}$ represents a carbocation, an ammonium cation, a phosphonyl cation or a sulfonyl cation.
$M^{E3}$ represents $F^-$, $Cl^-$, $Br^-$, $I^-$, $OH^-$, $R^{E7}SO_3^-$, $R^{E7}COO^-$, $ClO^-$, $ClO_2^-$, $ClO_3^-$, $ClO_4^-$, $SCN^-$, $CN^-$, $NO_3^-$, $SO_4^{2-}$, $HSO_4^-$, $PO_4^{3-}$, $HPO_4^{2-}$, $H_2PO_4^-$, tetraphenyl borate, $BF_4^-$ or $PF_6^-$. $R^{E7}$ represents an alkyl group, a perfluoroalkyl group or an aryl group, and these groups each optionally have a substituent. When a plurality of $M^{E3}$ are present, they may be the same or different.
$Z^{E2}$ represents a metal ion or an ammonium ion, and this ammonium ion optionally has a substituent. When a plurality of $Z^{E2}$ are present, they may be the same or different.
aE2 and bE2 are selected so that the charge of the group represented by the formula (ES-2) is 0.]

nE2 is preferably an integer of 1 to 4, more preferably 1 or 2.

The aromatic hydrocarbon group or the heterocyclic group represented by $Ar^{E2}$ is preferably an atomic group remaining after removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group or a 2,7-carbazoledilyl group nE2 hydrogen atoms bonding directly to atoms constituting the ring, and optionally has a substituent other than $R^{E2}$.

The substituent other than $R^{E2}$ which $Ar^{E2}$ optionally has is the same as the substituent other than $R^{E1}$ which $Ar^{E1}$ optionally has.

cE2 is preferably 0 or 1, and nE6 is preferably an integer of 0 to 6.

$R^{E6}$ is preferably an arylene group.

$Q^{E2}$ is preferably an alkylene group, an arylene group or an oxygen atom.

$Y^{E2}$ is preferably a carbocation or an ammonium cation.

$M^{E3}$ is preferably $F^-$, $Cl^-$, $Br^-$, $I^-$, tetraphenyl borate, $CF_3SO_3^-$ or $CH_3COO^-$.

$Z^{E2}$ is preferably $Li^+$, $Na^+$, $K^+$, $Cs^+$, $N(CH_3)_4^+$, $NH(CH_3)_3^+$, $NH_2(CH_3)_2^+$ or $N(C_2H_5)_4^+$.

The substituent which $R^{E6}$ optionally has includes an alkyl group, a cycloalkyl group, an aryl group, a monovalent heterocyclic group and a group represented by the formula (ES-3). It is preferable that $R^{E6}$ has a group represented by the formula (ES-3) as a substituent, because a light emitting device produced by the production method of the present invention is more excellent in light emission efficiency.

The group represented by the formula (ES-2) includes, for example, groups represented by the following formulae.

[Chemical Formula 74]

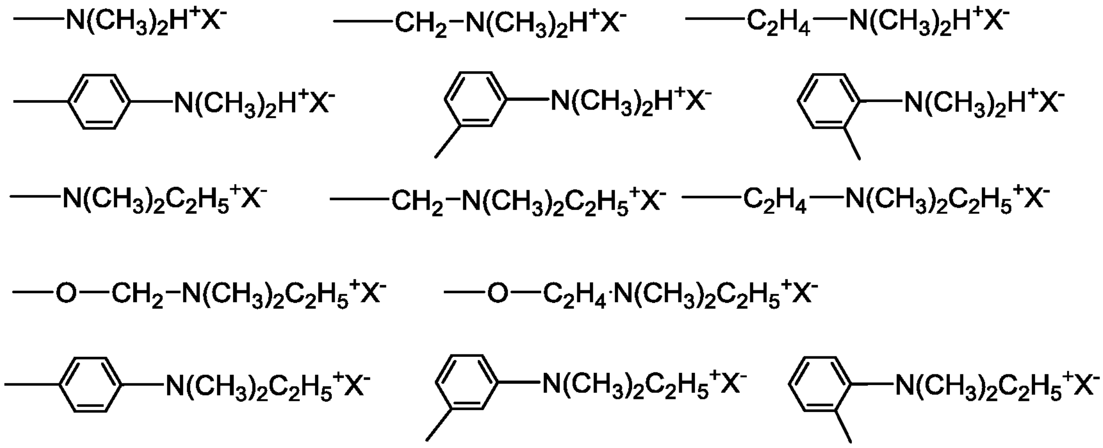

[wherein, $X^-$ represents $F^-$, $Cl^-$, $Br^-$, $I^-$, tetraphenyl borate, $CF_3SO_3^-$ or $CH_3COO^-$.]

The constitutional unit represented by the formula (ET-1) and the formula (ET-2) includes, for example, constitutional units represented by the formula (ET-31) to the formula (ET-34) described below.

[Chemical Formula 75]

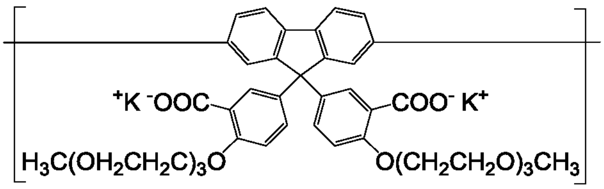

(ET-31)

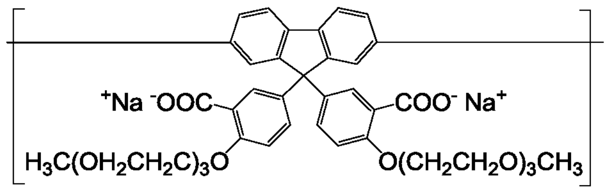

(ET-32)

[0296]

[Chemical Formula 76]

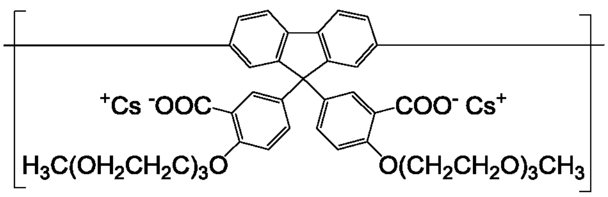

(ET-33)

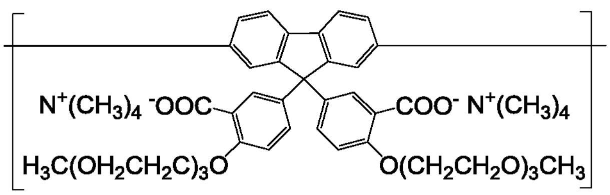

(ET-34)

[Hole injection material and electron injection material]

The hole injection material and the electron injection material are each classified into low molecular weight compounds and polymer compounds. The hole injection material and the electron injection material each optionally have a crosslinkable group.

The low molecular weight compound includes, for example, metal phthalocyanines such as copper phthalocyanine; carbon; oxides of metals such as molybdenum and tungsten; metal fluorides such as lithium fluoride, sodium fluoride, cesium fluoride and potassium fluoride.

The polymer compound includes, for example, polyaniline, polythiophene, polypyrrole, polyphenylenevinylene, polythienylenevinylene, polyquinoline and polyquinoxaline, and derivatives thereof; electrically conductive polymers such as a polymer comprising an aromatic amine structure in the main chain or side chain.

The hole injection material and the electron injection material may each be used singly, or two or more of them

may be used in combination.

[Ion dope]

When the hole injection material or the electron injection material comprises an electrically conductive polymer, the electric conductivity of the electrically conductive polymer is preferably $1\times10^{-5}$ S/cm to $1\times10^{3}$ S/cm. For adjusting the electric conductivity of the electrically conductive polymer within such a range, the electrically conductive polymer can be doped with a suitable amount of ions.

The kind of the ion to be doped is an anion for a hole injection material and a cation for an electron injection material. The anion includes, for example, a polystyrenesulfonate ion, an alkylbenzenesulfonate ion and a camphorsulfonate ion. The cation includes, for example, a lithium ion, a sodium ion, a potassium ion and a tetrabutylammonium ion.

The ion to be doped may be used singly, or two or more ions to be doped may be used.

[Encapsulating layer]

The encapsulating layer is not particularly restricted providing it has a barrier property against moisture and an oxygen gas, and in one embodiment of the encapsulating layer, an anode, a cathode, a light emitting layer and other layers of a light emitting device are encapsulated by a substrate made of a material such as glass, plastic and silicon under the condition filled with an inert gas such as a nitrogen gas and an argon gas. In another embodiment of the encapsulating layer, an anode, a cathode, a light emitting layer and other layers of a light emitting device are encapsulated by a substrate made of a material such as glass, plastic and silicon via an insulating layer composed of an organic substance or an insulating layer composed of an inorganic substance. The material of the insulating layer composed of an organic substance includes, for example, a thermoplastic resin and a photocrosslinkable resin. The material of the insulating layer composed of an inorganic substance includes, for example, a metal oxide and a metal nitride.

The encapsulating layer may contain a desiccant. The desiccant may also be one disposed on the encapsulating layer.

[Use of light emitting device]

For obtaining planar light emission by using a light emitting device, a planar anode and a planar cathode are disposed so as to overlap with each other. Patterned light emission can be produced by a method of placing a mask with a patterned window on the surface of a planer light emitting device, a method of forming an extremely thick layer intended to be a non-light emitting, thereby having the layer essentially no-light emitting or a method of forming an anode, a cathode or both electrodes in a patterned shape. By forming a pattern with any of these methods and disposing certain electrodes so as to switch ON/OFF independently, a segment type display capable of displaying numbers and letters and the like is provided. For producing a dot matrix display, both an anode and a cathode are formed in a stripe shape and disposed so as to cross with each other. Partial color display and multicolor display are made possible by a method of printing separately certain polymer compounds showing different emission or a method of using a color filter or a fluorescence conversion filter. The dot matrix display can be passively driven, or actively driven combined with TFT and the like. These displays can be used in computers, television sets, portable terminals and the like. The planar light emitting device can be suitably used as a planer light source for backlight of a liquid crystal display or as a planar light source for illumination. If a flexible substrate is used, it can be used also as a curved light source and a curved display.

EXAMPLES

The present invention will be illustrated further in detail by examples below, but the present invention is not limited to these examples.

In the present examples, the polystyrene-equivalent number average molecular weight (Mn) and the polystyrene-equivalent weight average molecular weight (Mw) of a polymer compound were measured by size exclusion chromatography (SEC) (manufactured by Shimadzu Corp., trade name: LC-10Avp). SEC measurement conditions are as described below.

[Measurement condition]

The polymer compound to be measured was dissolved in THF at a concentration of about 0.05 wt%, and 10 $\mu$L of the solution was injected into SEC. As the mobile phase of SEC, THF was used and allowed to flow at a flow rate of 2.0 mL/min. As the column, PLgel MIXED-B (manufactured by Polymer Laboratories) was used. As the detector, UV-VIS detector (manufactured by Shimadzu Corp., trade name: SPD-10Avp) was used.

Liquid chromatograph mass spectrometry (LC-MS) was carried out according to the following method.

A measurement sample was dissolved in chloroform or THF so as to give a concentration of about 2 mg/mL, and about 1 μL of the solution was injected into LC-MS (manufactured by Agilent Technologies, trade name: 1100LCMSD). As the mobile phase of LC-MS, acetonitrile and THF were used while changing the ratio thereof and allowed to flow at a flow rate of 0.2 mL/min. As the column, L-column 2 ODS (3 μm) (manufactured by Chemicals Evaluation and Research Institute, internal diameter: 2.1 mm, length: 100 mm, particle size: 3 μm) was used.

Measurement of NMR was carried out according to the following method.

5 to 10 mg of a measurement sample was dissolved in about 0.5 mL of deuterated chloroform ($CDCl_3$), deuterated tetrahydrofuran (THF-$d_8$) or deuterated methylene chloride ($CD_2Cl_2$), and measurement was performed using an NMR apparatus (manufactured by Agilent, trade name: INOVA 300 or MERCURY 400VX).

As the index of the purity of a compound, a value of the high performance liquid chromatography (HPLC) area percentage was used. This value is a value in HPLC (manufactured by Shimadzu Corp., trade name: LC-20A) at 254 nm, unless otherwise state. In this operation, the compound to be measured was dissolved in THF or chloroform so as to give a concentration of 0.01 to 0.2 wt%, and depending on the concentration, 1 to 10 μL of the solution was injected into HPLC. As the mobile phase of HPLC, acetonitrile and THF were used and allowed to flow at a flow rate of 1 mL/min as gradient analysis of acetonitrile/THF = 100/0 to 0/100 (volume ratio). As the column, Kaseisorb LC ODS 2000 (manufactured by Tokyo Chemical Industry Co., Ltd.) or an ODS column having an equivalent performance was used. As the detector, a photo diode array detector (manufactured by Shimadzu Corp., trade name: SPD-M20A) was used.

In examples, the average value of the ozone concentration for the whole process from initiation of a step of forming a light emitting layer to completion of a step of forming an encapsulating layer was measured using an ozone concentration measurement device for air pollution monitoring (manufactured by HORIBA, Ltd., product name: APOA-3700) .

<Synthesis Example 1> Synthesis of iridium complex 1

An iridium complex 1 was synthesized according to a method described in JP-A No. 2008-179617.

[Chemical Formula 77]

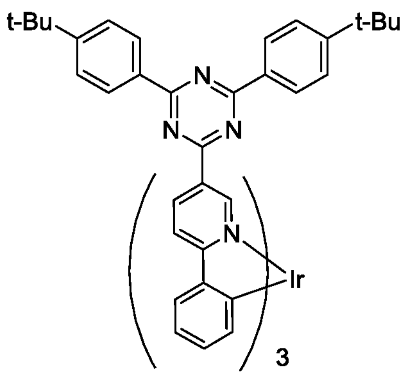

Iridium complex 1

<Synthesis Example 2> Synthesis of iridium complex 2

An iridium complex 2 was synthesized according to a method described in International Publication WO2009/131255.

[Chemical Formula 78]

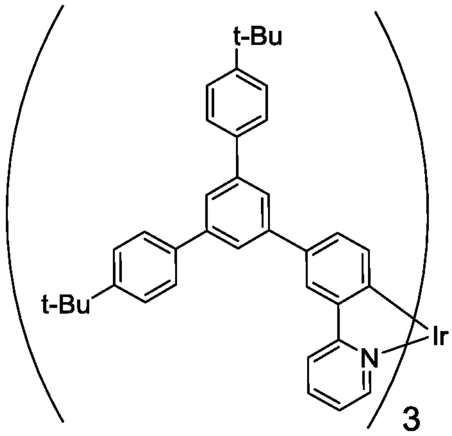

Iridium complex 2

<Synthesis Example 3> Synthesis of iridium complex 3

An iridium complex 3 was synthesized according to a method described in JP-A No. 2013-147551.

[Chemical Formula 79]

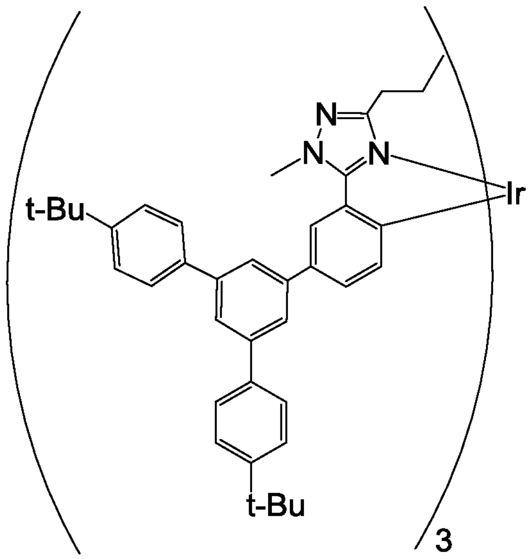

Iridium complex 3

<Synthesis Example 4> Synthesis of iridium complex 4

[Chemical Formula 80]

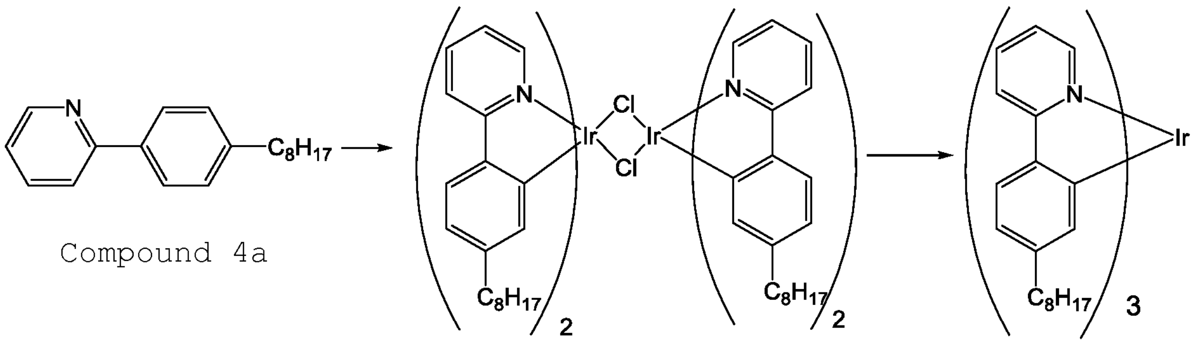

Compound 4a

Compound 4b

Iridium complex 4

Into a reaction vessel were added a compound 4a (20.00 g) synthesized according to a method described in JP-A No. 2005-99481 and iridium chloride trihydrate (11.93 g), and the gas in the reaction vessel was purged with an argon gas. Thereafter, to this were added 2-ethoxyethanol (180 mL) and water (60 mL), the atmosphere in the reaction vessel was turned into an argon gas stream, then, the mixture was refluxed at 101 to 102°C for 20 hours. After standing to cool, the resultant mixture was separated by filtration. The resultant residue was washed with water (400 mL), methanol (200 mL) and hexane (200 mL) in this order, then, dried, to obtain a compound 4b (22.49 g).

Into a reaction vessel were added the compound 4b (22.49 g) and the compound 4a (19.77 g), and the gas in the reaction vessel was purged with an argon gas. Thereafter, to this were added diglyme (128 mL) and silver trifluoromethanesulfonate (7.60 g), and the atmosphere in the reaction vessel was turned into an argon gas stream, then, the mixture was stirred for 5 hours at 148 to 150°C. Thereafter, to this was added silver trifluoromethanesulfonate (7.60 g), further, the mixture was stirred for 12 hours. After standing to cool, to the resultant reaction mixture was added water (600 mL), and the generated precipitate was separated by filtration. The resultant precipitate was dissolved in toluene (500 mL), then, filtrated. The resultant filtrate was dried over magnesium sulfate, then, filtrated and concentrated, to distill off the solvent. The resultant residue was dissolved in a mixed solvent composed of hexane and toluene (hexane/toluene = 3/1 (by volume)), and purified by silica gel column chromatography, thereafter, the solvent was distilled off. The resultant residue was washed with methanol (200 mL), then, dried. The resultant solid was crystallized using a mixed solvent composed of toluene and acetonitrile (toluene/acetonitrile = 1.0/4.8 (by volume)), and the resultant crystal was separated by filtration. The resultant solid was washed with methanol, then, dried, to obtain an iridium complex 4 (14.30 g).

$^1$H NMR (300 MHz, $CDCl_3$): δ (ppm) = 0.88 (m, 9H), 1.22 (m, 30H), 1.44 (m, 6H), 2.35 (t, J = 7.5 Hz, 6H), 6.69 (m, 6H), 6.78 (t, J = 6.0 Hz, 3H), 7.47 (m, 9H), 7.77 (d, J = 6.0 Hz, 3H).
LC-MS (APCI, positive) m/z: 992 ($[M+H]^+$)

<Synthesis Example 5> Synthesis of iridium complex 5

An iridium complex 5 was synthesized according to a method described in JP-A No. 2006-188673.

[Chemical Formula 81]

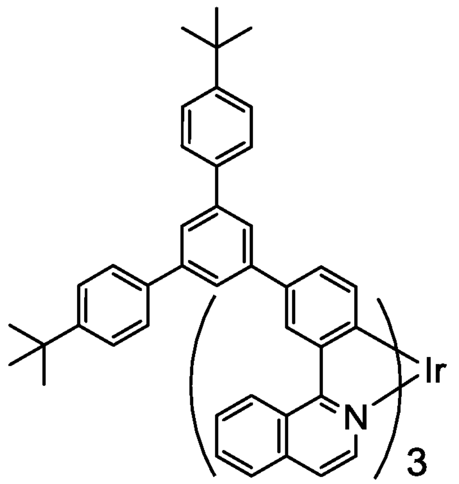

Iridium complex 5

<Synthesis Example 6> Synthesis of iridium complex 6

[Chemical Formula 82]

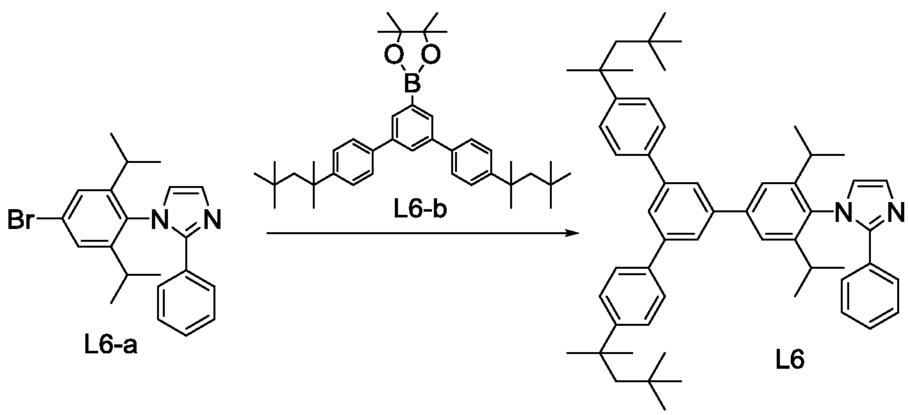


A compound L6-a was synthesized according to US Patent Application Publication No. 2011/0057559.

An argon gas atmosphere was prepared in a reaction vessel, then, a compound L6-a (9.9 g), a compound L6-b (15 g), 2-dicyclohexylphosphino-2',6'-dimethoxybiphenyl (0.11 g), tris(dibenzylideneacetone)dipalladium (0.12 g), a 20 wt% tetraethylammonium aqueous solution (20 ml), toluene (200 ml) and ethanol (50 ml) were added, and the mixture was stirred for 18 hours under reflux with heating. Thereafter, the mixture was cooled down to room temperature, and toluene was added and extraction was performed. The resultant organic layer was washed with ion exchanged water, then, concentrated under reduced pressure, thereby obtaining a solid. The resultant solid was purified by silica gel chromatography (ethyl acetate/hexane), and further, recrystallized using a mixed solvent of toluene and acetonitrile, then, dried under reduced pressure, thereby obtaining a compound L6 (17 g, yield: 90%).

[Chemical Formula 83]

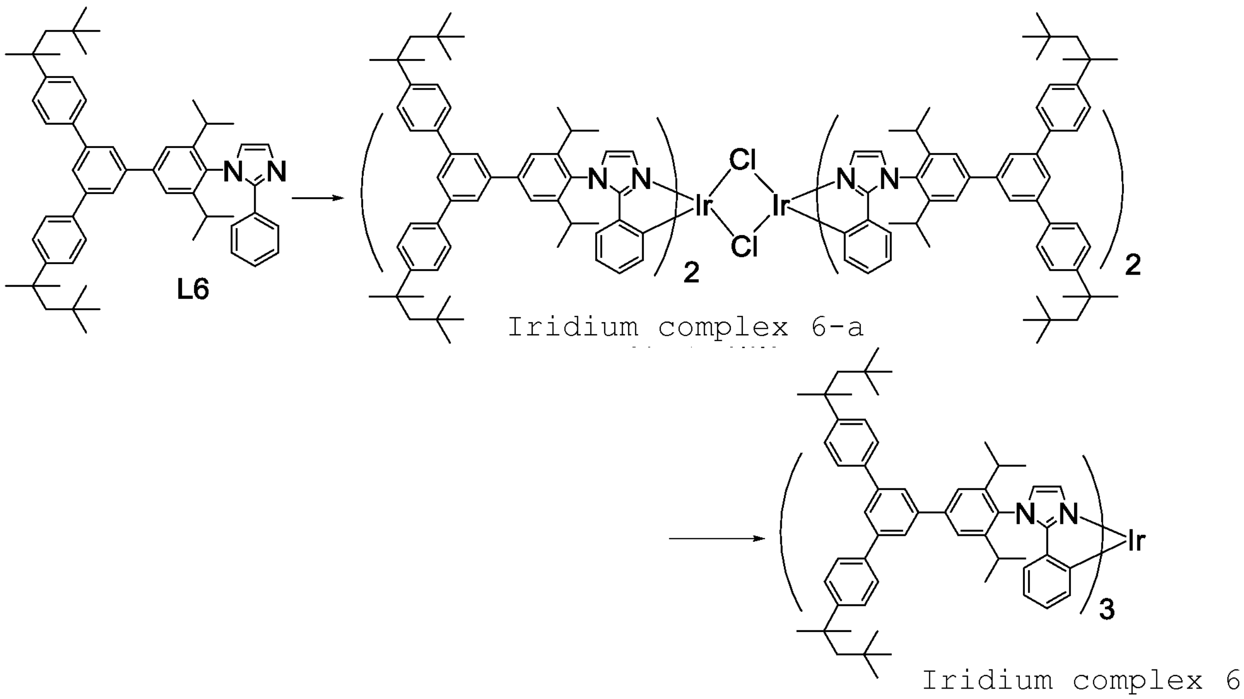

L6

Iridium complex 6-a

Iridium complex 6

An argon gas atmosphere was prepared in a reaction vessel, then, the compound L6 (10 g), iridium chloride hydrate (2.2 g), 2-ethoxyethanol (120 ml) and water (40 ml) were added, and the mixture was stirred for 14 hours under reflux with heating. Thereafter, the mixture was cooled down to room temperature, and methanol was added, to observe generation of a precipitate. The resultant precipitate was filtrated, and the resultant solid was washed with methanol, then, dried under reduced pressure, thereby obtaining an iridium complex 6-a (10 g, yellow powder).

An argon gas atmosphere was prepared in a reaction vessel, then, an iridium complex 6-a (9.5 g), silver trifluoromethanesulfonate (31 g), dichloromethane (100 ml) and methanol (30 ml) were added, and the mixture was stirred at room temperature overnight. The deposited precipitate was filtrated, then, the resultant filtrate was concentrated under reduced pressure. Thereafter, to this were added the compound L6 (7.8 g), 2,6-lutidine (6.7 ml) and diethylene glycol dimethyl ether (180 ml), and the mixture was stirred overnight under reflux with heating. Thereafter, the mixture was cooled down to room temperature, a mixed solvent of ion exchanged water and methanol was added, and the deposited precipitate was filtrated. The resultant solid was purified by silica gel chromatography (dichloromethane/hexane), and further, recrystallized using a mixed solvent of toluene and acetonitrile, then, dried under reduced pressure, thereby obtaining an iridium complex 6 (1.2 g, yield: 6.5%).

$^{1}$H-NMR (600 MHz, $(CD_3)_2CO-d_6$) $\delta$ (ppm) = 8.01-7.97 (m, 9H), 7.91 (d, 6H), 7.81 (d, 12H), 7.59 (d, 12H), 7.25 (s, 3H), 6.92-6.89 (m, 6H), 6.57 (t, 3H), 5.87-5.81 (m, 6H), 2.89-2.86 (m, 3H), 2.52-2.48 (m, 3H), 1.87 (s, 12H), 1.42 (s, 36H), 1.38 (d, 9H), 1.16 (d, 9H), 1.12 (d, 9H), 1.07 (d, 9H), 0.80 (54 H).

<Synthesis Example 7> Synthesis of iridium complex 7

An iridium complex 7 was synthesized according to a method described in International Publication WO2006/121811 and US Patent Application Publication No. 2011/0057559.

[Chemical Formula 84]

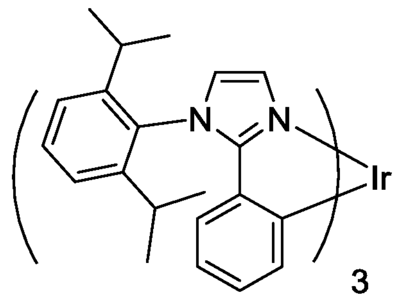

Iridium complex 7

<Synthesis Example 8> Synthesis of polymer compound P1

[Chemical Formula 85]

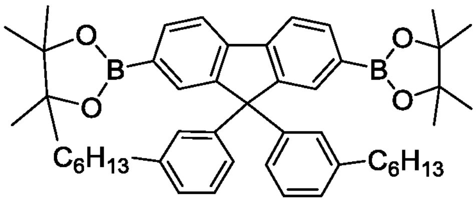

CM1

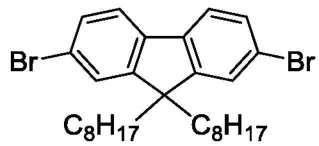

CM2

[Chemical Formula 86]

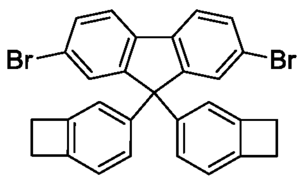

CM3

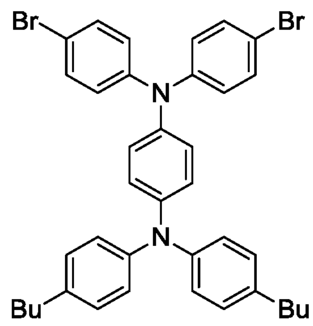

CM4

A monomer CM1 was synthesized according to a method described in JP-A No. 2011-174061.
A monomer CM2 was synthesized according to a method described in International Publication WO2002/045184.
A monomer CM3 was synthesized according to a method described in JP-A No. 2008-106241.
A monomer CM4 was synthesized according to a method described in JP-A No. 2003-226744.
(Step 1) An inert gas atmosphere was prepared in a reaction vessel, then, the monomer CM1 (185 g), the monomer

CM2 (35.9 g), the monomer CM3 (20.1 g), the monomer CM4 (104 g), dichlorobis(triphenylphosphine)palladium (177 mg) and toluene (4.3 kg) were added, and the mixture was heated at 100°C.

(Step 2) Thereafter, into this was dropped a 20 wt% tetraethylammonium hydroxide aqueous solution (873 g), and the mixture was stirred at 100°C for 5 hours.

(Step 3) Thereafter, to this were added phenylboronic acid (3.08 g) and toluene (120 g), and the mixture was stirred at 100°C for 14 hours.

(Step 4) An aqueous layer was eliminated from the resultant reaction liquid, then, to this were added a sodium diethyldithiacarbamate aqueous solution and toluene, and the mixture was stirred at 40°C for 3 hours. Thereafter, the mixture was cooled down to room temperature, and an aqueous layer was eliminated, thereby obtaining an organic layer. The resultant organic layer was washed with 10 wt% hydrochloric acid twice, with a 3 wt% ammonia aqueous solution twice and with water twice. The washed organic layer was purified by passing through an alumina column and a silica gel column in this order. The resultant purified liquid was dropped into methanol, and the mixture was stirred, to generate a precipitate. The resultant precipitate was collected by filtration, and dried, thereby obtaining 204 g of a polymer compound P1. The polymer compound P1 had a Mn of $6.7\times10^4$ and a Mw of $2.3\times10^5$.

The polymer compound P1 is a copolymer constituted of a constitutional unit derived from the monomer CM1, a constitutional unit derived from the monomer CM2, a constitutional unit derived from the monomer CM3 and a constitutional unit derived from the monomer CM4 at a molar ratio of 50:12.5:7.5:30 according to the theoretical values calculated from the amounts of the charged raw materials.

<Synthesis Example 9> Synthesis of polymer compound P2

[Chemical Formula 87]

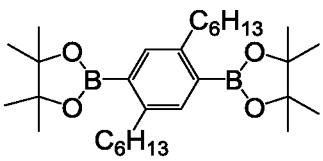

CM5

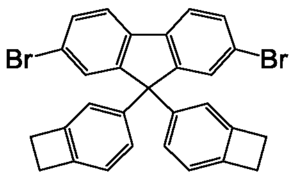

CM3

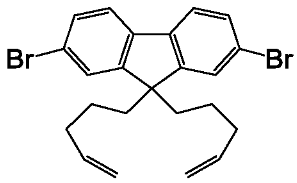

CM6

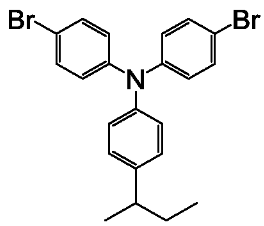

CM7

A monomer CM5 was synthesized according to a method described in JP-A No. 2010-189630.

A monomer CM6 was synthesized according to a method described in JP-A No. 2010-215886.

A monomer CM7 was synthesized according to a method described in Japanese Patent Application National Publication No. 2002-539292.

(Step 1) An inert gas atmosphere was prepared in a reaction vessel, then, the monomer CM5 (0.9950 g), the monomer CM3 (0.1064 g), the monomer CM6 (0.0924 g), the monomer CM7 (0.7364 g), dichlorobis[tris(2-methoxyphenyl)phosphine]palladium (1.8 mg) and toluene (47 ml) were added, and the mixture was heated at 105°C.

(Step 2) Into the reaction liquid was dropped a 20 wt% tetraethylammonium hydroxide aqueous solution (6.6 ml), and the mixture was refluxed for 5.5 hours.

(Step 3) Thereafter, to this were added phenylboronic acid (24.4 mg), a 20 wt% tetraethylammonium hydroxide aqueous solution (6.6 ml) and dichlorobis[tris(2-methoxyphenyl)phosphine]palladium (1.8 mg), and the mixture was refluxed for 14 hours.

(Step 4) Thereafter, to this was added a sodium diethyldithiacarbamate aqueous solution, and the mixture was stirred at 80°C for 2 hours. After cooling, the reaction liquid was washed with water twice, with a 3 wt% acetic acid aqueous solution twice and with water twice, and the resultant solution was dropped into methanol, to generate a precipitate. The precipitate was dissolved in toluene, and the solution was purified by passing through an alumina column and a silica gel column in this order. The resultant solution was dropped into methanol, and the mixture was stirred, then, the resultant precipitate was collected by filtration, and dried, thereby obtaining 0.91 g of a polymer compound P2. The polymer compound P2 had a Mn of $5.2\times10^4$ and a Mw of $2.5\times10^5$.

The polymer compound P2 is a copolymer constituted of a constitutional unit derived from the monomer CM5, a constitutional unit derived from the monomer CM3, a constitutional unit derived from the monomer CM6 and a constitutional unit derived from the monomer CM7 at a molar ratio of 50:5:5:40 according to the theoretical values calculated from the amounts of the charged raw materials.

<Synthesis Example 10> Synthesis of monomer CM8

[Chemical Formula 88]

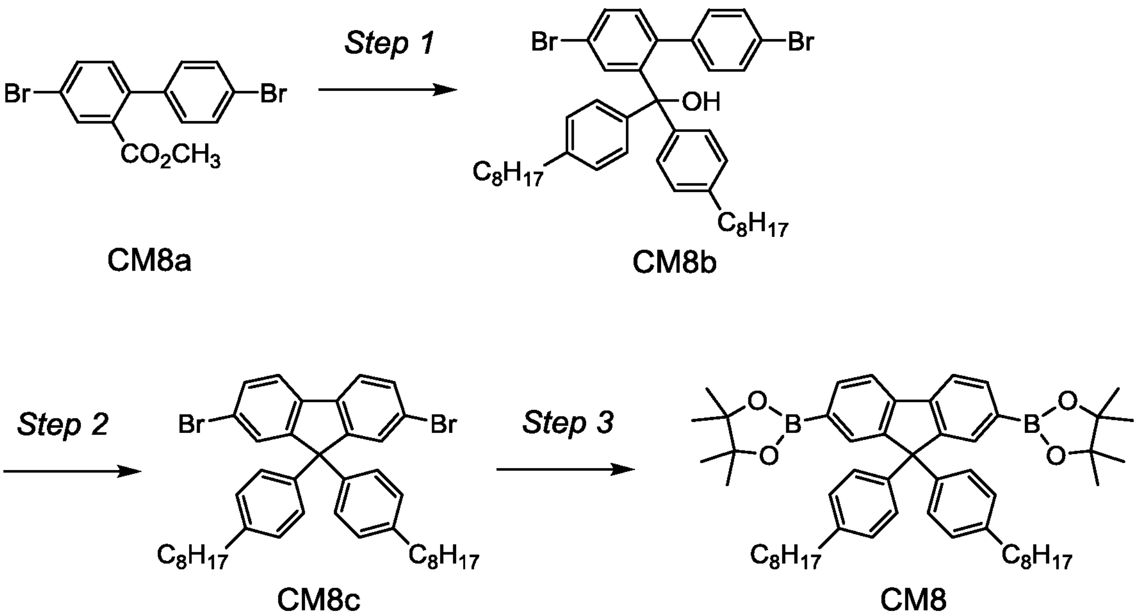


CM8a CM8b CM8c CM8

A compound CM8a was synthesized according to a method described in International Publication WO2012/086671.

<Step 1>

A nitrogen gas atmosphere was prepared in a reaction vessel, then, 4-bromo-n-octylbenzene (250 g) and tetrahydrofuran (dehydrated product, 2.5 L) were added, and the mixture was cooled down to -70°C or lower. Thereafter, a 2.5 mol/L n-butyllithium hexane solution (355 mL) was dropped into this, and the mixture was stirred for 3 hours at -70°C or lower. Thereafter, a solution prepared by dissolving the compound CM8a (148 g) in tetrahydrofuran (dehydrated product, 400 mL) was dropped into this, then, the mixture was warmed up to room temperature, and stirred at room temperature overnight. The resultant reaction mixture was cooled down to 0°C, then, water (150 mL) was added and the mixture was stirred. The resultant reaction mixture was concentrated under reduced pressure, to remove the organic solvent. To the resultant reaction mixture were added hexane (1 L) and water (200 mL), and the aqueous layer was removed by a liquid-separation operation. The resultant organic layer was washed with saturated saline, then, magnesium sulfate was added and the layer was dried. The resultant mixture was filtrated, and the filtrate was concentrated under reduced pressure, to obtain a compound CM8b (330 g) as a yellow oily matter.

<Stage 2>

A nitrogen gas atmosphere was prepared in a reaction vessel, then, the compound CM8b (330 g) and dichloromethane (900 mL) were added, and the mixture was cooled down to 5°C or lower. Thereafter, a 2.0 mol/L boron trifluoride diethyl ether complex (245 mL) was dropped into this. Thereafter, the mixture was warmed up to room temperature, and stirred at room temperature overnight. The resultant reaction mixture was added into a vessel containing ice water (2 L), stirred for 30 minutes, then, the aqueous layer was removed. The resultant organic layer was washed with a 10% by weight potassium phosphate aqueous solution (1 L) once, with water (1 L) twice, then, dried over magnesium sulfate. The resultant mixture was filtrated, and the filtrate was concentrated under reduced pressure, to obtain an oily

matter. The resultant oily matter was dissolved in toluene (200 mL), then, the solution was passed through a filter paved with silica gel, to obtain a toluene solution 1. After the toluene solution 1 was obtained, toluene (about 3 L) was further passed through a filter paved with silica gel, to obtain a toluene solution 2. The toluene solution 1 and the toluene solution 2 were mixed, then, concentrated under reduced pressure, to obtain an oily matter. To the resultant oily matter was added methanol (500 mL), and the mixture was stirred. The resultant reaction mixture was filtrated, to obtain a solid. To this solid was added a mixed solvent of butyl acetate and methanol, and recrystallization thereof was repeated, to obtain a monomer CM8c (151 g) as a white solid. The monomer CM8c showed an HPLC area percentage value (detection wavelength UV: 280 nm) of 99.0% or more.

$^1$H-NMR (400 MHz/$CDCl_3$): δ (ppm) = 7.56 (d, 2H), 7.49 (d, 2H), 7.46 (dd, 2H), 7.06 to 7.01 (m, 8H), 2.55 (t, 4H), 1.61 to 1.54 (m, 4H), 1.30 to 1.26 (m, 20H), 0.87 (t, 6H).

<Stage 3>

A nitrogen gas atmosphere was prepared in a reaction vessel, then, the monomer CM8c (100 g) and tetrahydrofuran (dehydrated product, 1000 mL) were added, and the mixture was cooled down to -70°C or lower. Thereafter, a 2.5 mol/L n-butyllithium hexane solution (126 mL) was dropped into this, and the mixture was stirred for 5 hours at -70°C or lower. Thereafter, 2-isopropoxy-4,4,5,5-tetramethyl-1,3,2-dioxaborolane (81 mL) was dropped into this. Thereafter, the mixture was warmed up to room temperature, and stirred at room temperature overnight. The resultant reaction mixture was cooled down to -30°C, and a 2.0 mol/L hydrochloric acid diethyl ether solution (143 mL) was dropped. Thereafter, the mixture was warmed up to room temperature and concentrated under reduced pressure, to obtain a solid. To the resultant solid was added toluene (1.2 L), and the mixture was stirred at room temperature for 1 hour, then, passed through a filter paved with silica gel, to obtain a filtrate. The resultant filtrate was concentrated under reduced pressure, to obtain a solid. To the resultant solid was added methanol and the mixture was stirred, then, filtrated, to obtain a solid. The resultant solid was purified by repeating recrystallization thereof using isopropyl alcohol, then, dried under reduced pressure at 50°C overnight, to obtain a monomer CM8 (72 g) as a white solid. The monomer CM8 showed an HPLC area percentage value (detection wavelength UV: 280 nm) of 99.0% or more.

$^1$H-NMR (400 MHz/$CDCl_3$) : δ (ppm) = 7.82 (d, 2H), 7.81 (s, 2H), 7.76 (d, 2H), 7.11 (d, 4H), 7.00 (d, 4H), 2.52 (t, 4H), 1.59 to 1.54 (m, 4H), 1.36 to 1.26 (m, 20H), 1.31 (s, 24H), 0.87 (t, 6H).

<Synthesis Example 11> Synthesis of polymer compound P3

[Chemical Formula 89]

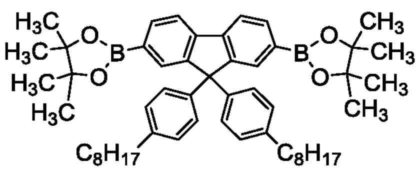

CM8

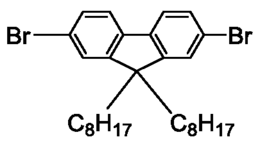

CM2

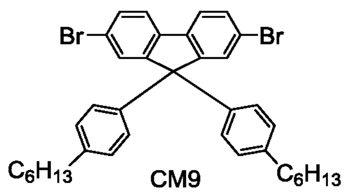

CM9

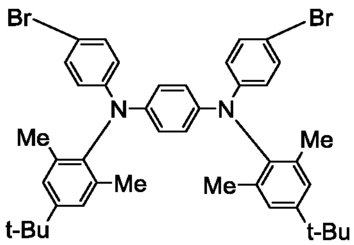

CM10

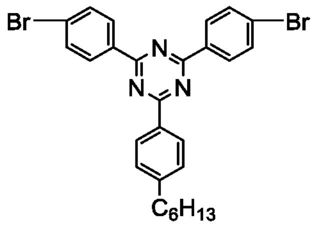

CM11

A monomer CM9 was synthesized according to a method described in International Publication WO2012/86671.

A monomer CM10 was synthesized according to a method described in JP-A No. 2004-143419.

A monomer CM11 was synthesized according to a method described in International Publication

WO2009/131255.

(Step 1) An inert gas atmosphere was prepared in a reaction vessel, then, the monomer CM8 (4.7686 g), the monomer CM2 (1.9744 g), the monomer CM9 (0.7734 g), the monomer CM10 (0.4432 g), the monomer CM11 (0.3308 g) and toluene (67 ml) were added, and the mixture was heated at 105°C.

(Step 2) To the reaction liquid were added bistriphenylphosphinepalladium dichloride (4.2 mg) and a 20 wt% tetraethylammonium hydroxide aqueous solution (20 ml), then, the mixture was refluxed for 3 hours.

(Step 3) Thereafter, to this were added phenylboronic acid (0.077 g), bistriphenylphosphinepalladium dichloride (4.2 mg), toluene (60 ml) and a 20 wt% tetraethylammonium hydroxide aqueous solution (20 ml), and the mixture was refluxed for 24 hours.

(Step 4) Thereafter, an organic layer and an aqueous layer were separated, then, to the resultant organic layer were added sodium N,N-diethyldithiocarbamate trihydrate (3.33 g) and ion exchanged water (67 ml), and the mixture was stirred at 85°C for 2 hours. Thereafter, an organic layer and an aqueous layer were separated, then, the resultant organic layer was washed with ion exchanged water (78 ml) twice, with a 3 wt% acetic acid aqueous solution (78 ml) twice and with ion exchanged water (78 ml) twice in this order. Thereafter, an organic layer and an aqueous layer were separated, then, the resultant organic layer was dropped into methanol to cause precipitation of a solid which was then collected by filtration and dried, thereby obtaining a solid. The resultant solid was dissolved in toluene, and the solution was allowed to pass through a silica gel column and an alumina column through which toluene had passed previously. The resultant solution was dropped into methanol to cause precipitation of a solid which was then collected by filtration and dried, thereby obtaining a polymer compound P3 (4.95 g). The polymer compound P3 had a Mn of $1.4\times10^5$ and a Mw of $4.1\times10^5$.

The polymer compound P3 is a copolymer constituted of a constitutional unit derived from the monomer CM8, a constitutional unit derived from the monomer CM2, a constitutional unit derived from the monomer CM9, a constitutional unit derived from the monomer CM10 and a constitutional unit derived from the monomer CM11 at a molar ratio of 50:30:10:5:5 according to the theoretical values calculated from the amounts of the charged raw materials.

<Synthesis Example 12> Synthesis of polymer compound P4

[Chemical Formula 90]

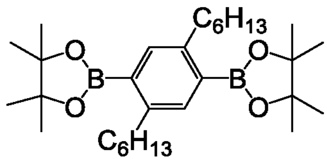

CM5

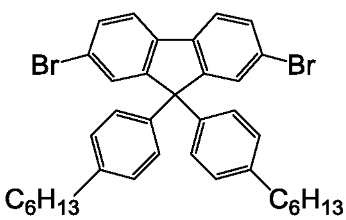

CM9

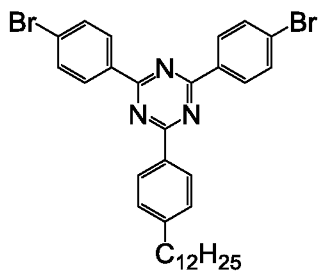

CM12

A monomer CM12 was synthesized according to a method described in JP-A No. 2010-189630.

A polymer compound P4 was synthesized according to a method described in JP-A No. 2012-36388 using the monomer CM5, the monomer CM9 and the monomer CM12. The polymer compound P4 had a Mn of $9.1\times10^4$ and a Mw of $2.3\times10^5$.

The polymer compound P4 is a copolymer constituted of a constitutional unit derived from the monomer CM5, a constitutional unit derived from the monomer CM9 and a constitutional unit derived from the monomer CM12 at a molar ratio of 50:40:10 according to the theoretical values calculated from the amounts of the charged raw materials.

<Synthesis Example 13> Synthesis of polymer compound P5

[Chemical Formula 91]

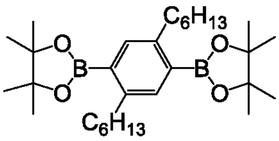
CM5

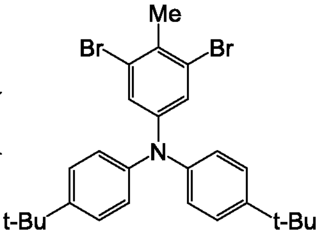
CM13

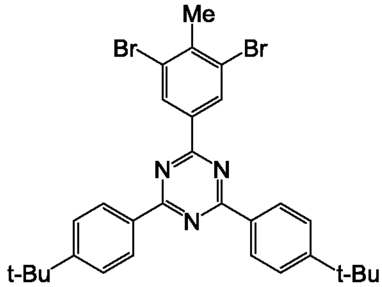
CM14

Monomers CM13 and CM14 were synthesized according to a method desclosed in JP-A No. 2012-36381.

A polymer compound P5 was synthesized according to a method desclosed in JP-A No. 2012-36381 using the monomer CM5, the monomer CM13 and the monomer CM14. The polymer compound P5 had a Mn of $3.4\times10^4$ and a Mw of $1.2\times10^5$.

The polymer compound P5 is a copolymer constituted of a constitutional unit derived from the monomer CM5, a constitutional unit derived from the monomer CM13 and a constitutional unit derived from the monomer CM14 at a molar ratio of 50:20:30 according to the theoretical values calculated from the amounts of the charged raw materials.

<Synthesis Example 14> Synthesis of polymer compound P6

[Chemical Formula 92]

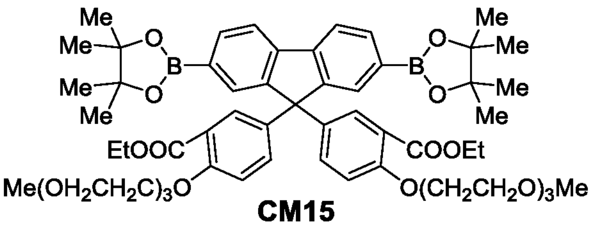
CM15

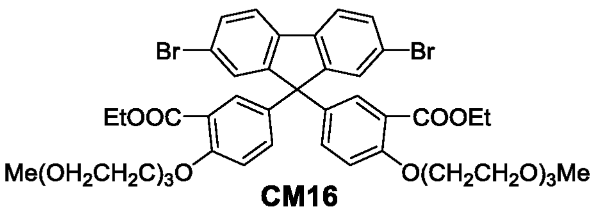
CM16

(Synthesis of polymer compound P6-a)

A polymer compound P6-a was synthesized according to a method described in JP-A No. 2012-33845 using a monomer CM15 synthesized according to a method described in JP-A No. 2012-33845 and a monomer CM16 synthesized according to a method described in JP-A No. 2012-33845.

The polymer compound P6-a had a Mn of $5.2\times10^4$.

The polymer compound P6-a is a copolymer constituted of a constitutional unit derived from the monomer CM15 and a constitutional unit derived from the monomer CM16 at a molar ratio of 50:50 according to the theoretical values calculated from the amounts of the charged raw materials.

[Chemical Formula 93]

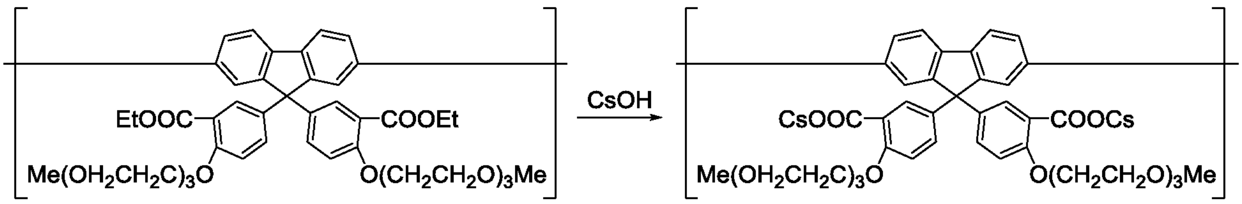


Polymer compound P6-a

Polymer compound P6

(Synthesis of polymer compound P6)

An inert gas atmosphere was prepared in a reaction vessel, then, the polymer compound P6-a (200 mg), tetrahydrofuran (20 ml) and ethanol (20 ml) were added, and the mixture was heated at 55°C. To this was added cesium hydroxide (200 mg) dissolved in water (2 ml), and the mixture was stirred at 55°C for 6 hours. Thereafter, the mixture was cooled down to room temperature, then, concentrated under reduced pressure, thereby obtaining a solid. The resultant solid was washed with water, then, dried under reduced pressure, thereby obtaining a polymer compound P6 (150 mg, pale yellow solid). It was confirmed based on the NMR spectrum of the resultant polymer compound P6 that a signal derived from an ethyl group of an ethyl ester portion of the polymer compound P6-a disappeared completely.

<Example 1> Fabrication and evaluation of light emitting device 1

(Formation of anode and hole injection layer)

A glass substrate was attached with an ITO film with a thickness of 150 nm by a sputtering method, thereby forming an anode. On the anode, poly(3,4)ethylenedioxythiophene/polystyrenesulfonic acid (manufactured by H. C. stark, trade name: CLEVIOS P AI4083) (hereinafter, referred to as "AI4083") was spin-coated to form a film with a thickness of 65 nm, which was then heated on a hot plate at 200°C for 10 minutes under an air atmosphere, thereby forming a hole injection layer.

(Formation of hole transporting layer)

Into xylene was dissolved the polymer compound P1 at a concentration of 0.7 wt%. The resultant xylene solution was spin-coated on the hole injection layer to form a film with a thickness of 20 nm, and the film was heated at 180°C for 60 minutes under a nitrogen gas atmosphere, thereby forming a hole transporting layer.

(Formation of light emitting layer)

Into xylene were dissolved the polymer compound P3 and an iridium complex 1 (polymer compound P3/iridium complex 1 = 92.5 wt%/7.5 wt%) at a concentration of 1.4 wt%. The resultant xylene solution was spin-coated on the hole transporting layer to form a film with a thickness of 80 nm, and the film was heated at 130°C for 10 minutes under a nitrogen gas atmosphere, thereby forming a light emitting layer.

(Formation of cathode)

The substrate carrying the light emitting layer formed thereon was placed in a vapor deposition machine and the internal pressure thereof was reduced to $1.0\times10^{-4}$ Pa or less, then, as a cathode, barium was vapor-deposited with a thickness of about 5 nm on the light emitting layer, then, aluminum was vapor-deposited with a thickness of about 60 nm on the barium layer. After vapor deposition, an encapsulating layer was formed by using a glass substrate under a nitrogen gas atmosphere, thereby fabricating a light emitting device 1. A space is present between the anode, the cathode and each layer contained in the light emitting device 1 and the glass substrate used for formation of the encapsulating. Since formation of the encapsulating layer is conducted under a nitrogen gas atmosphere, the space is filled with a nitrogen gas.

The light emitting device 1 was fabricated under the indoor environment having a chemical filter (manufactured by NICHIAS Corporation, product name: Chemicalguard-AX (a chemical filter using activated carbon)) installed to an external air intake. In fabrication of the light emitting device 1, the time interval for the whole process from initiation of

the step of forming the light emitting layer to completion of the step of forming the encapsulating layer during which the light emitting device in production is exposed to ozone was 30 minutes, and the average value of the ozone concentration for this time interval was 0.8 ppb. The average value of the ozone concentration: A ppb for the whole process during which the light emitting device in production is exposed to ozone was 0.8 ppb, and the time interval: B min for the whole process during which the light emitting device in production is exposed to ozone was 30 minutes, that is, A×B = 24.

When voltage was applied to the light emitting device 1, EL emission (red) was observed. When the luminance was 1000 cd/$m^2$, the driving voltage was 6.5 V and the light emission efficiency was 22.0 cd/A. The current value was set in such a manner that the initial luminance was 12000 cd/$m^2$, then, the light emitting device was driven at constant current, and the luminance half life (hereinafter, referred to also as "LT50") was measured, to find a value of 328.1 hours.

<Comparative Example 1> Fabrication and evaluation of light emitting device C1

A light emitting device C1 was fabricated in the same manner as for the light emitting device 1, excepting that fabrication was carried out under the indoor environment having no chemical filter installed to an external air intake. In fabrication of the light emitting device C1, the time interval for the whole process from initiation of the step of forming the light emitting layer to completion of the step of forming the encapsulating layer during which the light emitting device in production is exposed to ozone was 30 minutes, and the average value of the ozone concentration for this time interval was 55 ppb. The average value of the ozone concentration: A ppb for the whole process during which the light emitting device in production is exposed to ozone 55 ppb, and the time interval: B min for the whole process during which the light emitting device in production is exposed to ozone was 30 minutes, that is, A×B = 1650.

When voltage was applied to the light emitting device C1, EL emission (red) was observed. When the luminance was 1000 cd/$m^2$, the driving voltage was 7.6 V and the light emission efficiency was 16.8 cd/A. The current value was set in such a manner that the initial luminance was 12000 cd/$m^2$, then, the light emitting device was driven at constant current, and LT50 was measured, to find a value of 63.0 hours.

<Comparative Example 2> Fabrication and evaluation of light emitting device C2

A light emitting device C2 was fabricated in the same manner as for the light emitting device 1, excepting that fabrication was carried out under the indoor environment having no chemical filter installed to an external air intake. In fabrication of the light emitting device C2, the time interval for the whole process from initiation of the step of forming the light emitting layer to completion of the step of forming the encapsulating layer during which the light emitting device in production is exposed to ozone was 30 minutes, and the average value of the ozone concentration for this time interval was 110 ppb. The average value of the ozone concentration: A ppb for the whole process during which the light emitting device in production is exposed to ozone was 110 ppb, and the time interval: B min for the whole process during which the light emitting device in production is exposed to ozone was 30 minutes, that is, A×B = 3300.

When voltage was applied to the light emitting device C2, EL emission (red) was observed. When the luminance was 1000 cd/$m^2$, the driving voltage was 8.8 V and the light emission efficiency was 12.9 cd/A. The current value was set in such a manner that the initial luminance was 12000 cd/$m^2$, then, the light emitting device was driven at constant current, and LT50 was measured, to find a value of 28.8 hours.

[Table 2]

| | light emitting layer | A×B | light emission efficiency (cd/A) (1 kcd/$m^2$) | LT50 (hr) |
|---|---|---|---|---|
| light emitting device 1 | polymer compound P3 /iridium complex 1 | 24 | 22.0 | 328.1 |
| light emitting device C1 | polymer compound P3 /iridium complex 1 | 1650 | 16.8 | 63.0 |
| light emitting device C2 | polymer compound P3 /iridium complex 1 | 3300 | 12.9 | 28.8 |

<Example 2> Fabrication and evaluation of light emitting device 2

(Formation of anode and hole injection layer)

A glass substrate was attached with an ITO film with a thickness of 45 nm by a sputtering method, thereby

forming an anode. On the anode, a polythiophene•sulfonic acid type hole injection agent AQ-1200 (manufactured by Plextronics) was spin-coated to form a film with a thickness of 35 nm, which was then heated on a hot plate at 170°C for 15 minutes under an air atmosphere, thereby forming a hole injection layer.

(Formation of hole transporting layer)

Into xylene was dissolved the polymer compound P2 at a concentration of 0.7 wt%. The resultant xylene solution was spin-coated on the hole injection layer to form a film with a thickness of 20 nm, and the film was heated at 180°C for 60 minutes under a nitrogen gas atmosphere, thereby forming a hole transporting layer.

(Formation of light emitting layer)

Into xylene were dissolved the polymer compound P4 and an iridium complex 2 (polymer compound P4/iridium complex 2 = 60 wt%/40 wt%) at a concentration of 2.0 wt%. The resultant xylene solution was spin-coated on the hole transporting layer to form a film with a thickness of 80 nm, and the film was heated at 130°C for 10 minutes under a nitrogen gas atmosphere, thereby forming a light emitting layer.

(Formation of cathode)

The substrate carrying the light emitting layer formed thereon was placed in a vapor deposition machine and the internal pressure thereof was reduced to $1.0\times10^{-4}$ Pa or less, then, as a cathode, sodium fluoride was vapor-deposited with a thickness of about 5 nm on the light emitting layer, then, aluminum was vapor-deposited with a thickness of about 60 nm on the sodium fluoride layer. After vapor deposition, an encapsulating layer was formed by using a glass substrate under a nitrogen gas atmosphere, thereby fabricating a light emitting device 2. A space is present between the anode, the cathode and each layer contained in the light emitting device 2 and the glass substrate used for formation of the encapsulating layer. Since formation of the encapsulating layer is conducted under a nitrogen gas atmosphere, the space is filled with a nitrogen gas.

The light emitting device 2 was fabricated under the indoor environment having a chemical filter (manufactured by NICHIAS Corporation, product name: Chemicalguard-AX (a chemical filter using activated carbon)) installed to an external air intake. In fabrication of the light emitting device 2, the time interval for the whole process from initiation of the step of forming the light emitting layer to completion of the step of forming the encapsulating layer during which the light emitting device in production is exposed to ozone was 20 minutes, and the average value of the ozone concentration for this time interval was 0.7 ppb. The average value of the ozone concentration: A ppb for the whole process during which the light emitting device in production is exposed to ozone was 0.7 ppb, and the time interval: B min for the whole process during which the light emitting device in production is exposed to ozone was 20 minutes, that is, $A\times B = 14$.

When voltage was applied to the light emitting device 2, EL emission (green) was observed. When the luminance was 1000 cd/$m^2$, the driving voltage was 6.4 V and the light emission efficiency was 58.5 cd/A. The current value was set in such a manner that the initial luminance was 8000 cd/$m^2$, then, the light emitting device was driven at constant current, and LT50 was measured, to find a value of 92.8 hours.

<Example 3> Fabrication and evaluation of light emitting device 3

A light emitting device 3 was fabricated in the same manner as for the light emitting device 2, excepting that fabrication was carried out under the indoor environment having no chemical filter installed to an external air intake. In fabrication of the light emitting device 3, the time interval for the whole process from initiation of the step of forming the light emitting layer to completion of the step of forming the encapsulating layer during which the light emitting device in production is exposed to ozone was 25 minutes, and the average value of the ozone concentration for this time interval was 25 ppb. The average value of the ozone concentration: A ppb for the whole process during which the light emitting device in production is exposed to ozone was 25 ppb, and the time interval: B min for the whole process during which the light emitting device in production is exposed to ozone was 25 minutes, that is, $A\times B = 625$.

When voltage was applied to the light emitting device 3, EL emission (green) was observed. When the luminance was 1000 cd/$m^2$, the driving voltage was 6.7 V and the light emission efficiency was 55.0 cd/A. The current value was set in such a manner that the initial luminance was 8000 cd/$m^2$, then, the light emitting device was driven at constant current, and LT50 was measured, to find a value of 77.9 hours.

<Comparative Example 3> Fabrication and evaluation of light emitting device C3

A light emitting device C3 was fabricated in the same manner as for the light emitting device 2, excepting that

fabrication was carried out under the indoor environment having no chemical filter installed to an external air intake. In fabrication of the light emitting device C3, the time interval for the whole process from initiation of the step of forming the light emitting layer to completion of the step of forming the encapsulating layer during which the light emitting device in production is exposed to ozone was 25 minutes, and the average value of the ozone concentration for this time interval was 110 ppb. The average value of the ozone concentration: A ppb for the whole process during which the light emitting device in production is exposed to ozone was 110 ppb, and the time interval: B min for the whole process during which the light emitting device in production is exposed to ozone was 25 minutes, that is, A×B = 2750.

When voltage was applied to the light emitting device C3, EL emission (green) was observed. When the luminance was 1000 cd/$m^2$, the driving voltage was 8.8 V and the light emission efficiency was 25.8 cd/A. The current value was set in such a manner that the initial luminance was 8000 cd/$m^2$, then, the light emitting device was driven at constant current, and LT50 was measured, to find a value of 26.3 hours.

[Table 3]

| | light emitting layer | A×B | light emission efficiency (cd/A) (1 kcd/$m^2$) | LT50 (hr) |
|---|---|---|---|---|
| light emitting device 2 | polymer compound P4 /iridium complex 2 | 14 | 58.5 | 92.8 |
| light emitting device 3 | polymer compound P4 /iridium complex 2 | 625 | 55.0 | 77.9 |
| light emitting device C3 | polymer compound P4 /iridium complex 2 | 2750 | 25.8 | 26.3 |

<Example 4> Fabrication and evaluation of light emitting device 4

(Formation of anode and hole injection layer)

A glass substrate was attached with an ITO film with a thickness of 45 nm by a sputtering method, thereby forming an anode. On the anode, a polythiophene•sulfonic acid type hole injection agent AQ-1200 (manufactured by Plextronics) was spin-coated to form a film with a thickness of 35 nm, which was then heated on a hot plate at 170°C for 15 minutes under an air atmosphere, thereby forming a hole injection layer.

(Formation of hole transporting layer)

Into xylene was dissolved the polymer compound P2 at a concentration of 0.7 wt%. The resultant xylene solution was spin-coated on the hole injection layer to form a film with a thickness of 20 nm, and the film was heated at 180°C for 60 minutes under a nitrogen gas atmosphere, thereby forming a hole transporting layer.

(Formation of light emitting layer)

Into xylene were dissolved the polymer compound P5, the iridium complex 3, the iridium complex 4 and the iridium complex 5 (polymer compound P5/iridium complex 3/iridium complex 4/iridium complex 5 = 59/40/0.6/0.4) at a concentration of 2.2 wt%. The resultant xylene solution was spin-coated on the hole transporting layer to form a film with a thickness of 75 nm, and the film was heated at 130°C for 10 minutes under a nitrogen gas atmosphere, thereby forming a light emitting layer.

(Formation of cathode)

The substrate carrying the light emitting layer formed thereon was placed in a vapor deposition machine and the internal pressure thereof was reduced to $1.0\times10^{-4}$ Pa or less, then, as a cathode, sodium fluoride was vapor-deposited with a thickness of about 5 nm on the light emitting layer, then, aluminum was vapor-deposited with a thickness of about 60 nm on the sodium fluoride layer. After vapor deposition, an encapsulating layer was formed by using a glass substrate under a nitrogen gas atmosphere, thereby fabricating a light emitting device 4. A space is present between the anode, the cathode and each layer contained in the light emitting device 4 and the glass substrate used for formation of the encapsulating layer. Since formation of the encapsulating layer is conducted under a nitrogen gas atmosphere, the space is filled with a nitrogen gas.

The light emitting device 4 was fabricated under the indoor environment having a chemical filter (manufactured by NICHIAS Corporation, product name: Chemicalguard-AX (a chemical filter using activated carbon)) installed to an external air intake. In fabrication of the light emitting device 4, the time interval for the whole process from initiation of the step of forming the light emitting layer to completion of the step of forming the encapsulating layer during which the light emitting device in production is exposed to ozone was 20 minutes, and the average value of the ozone concentration for this time interval was 0.7 ppb. The average value of the ozone concentration: A ppb for the whole process during which the light emitting device in production is exposed to ozone was 0.7 ppb, and the time interval: B min for the whole process during which the light emitting device in production is exposed to ozone was 20 minutes, that is, A×B = 14.
When voltage was applied to the light emitting device 4, EL emission (white) was observed. When the luminance was 1000 cd/$m^2$, the driving voltage was 7.3 V and the light emission efficiency was 21.6 cd/A.

<Example 5> Fabrication and evaluation of light emitting device 5

A light emitting device 5 was fabricated in the same manner as for the light emitting device 4, excepting that fabrication was carried out under the indoor environment having no chemical filter installed to an external air intake. In fabrication of the light emitting device 5, the time interval for the whole process from initiation of the step of forming the light emitting layer to completion of the step of forming the encapsulating layer during which the light emitting device in production is exposed to ozone was 25 minutes, and the average value of the ozone concentration for this time interval was 25 ppb. The average value of the ozone concentration: A ppb for the whole process during which the light emitting device in production is exposed to ozone was 25 ppb, and the time interval: B min for the whole process during which the light emitting device in production is exposed to ozone was 25 minutes, that is, A×B = 625.
When voltage was applied to the light emitting device 5, EL emission (white) was observed. When the luminance was 1000 cd/$m^2$, the driving voltage was 7.5 V and the light emission efficiency was 21.2 cd/A.

<Comparative Example 4> Fabrication and evaluation of light emitting device C4

A light emitting device C4 was fabricated in the same manner as for the light emitting device 4, excepting that fabrication was carried out under the indoor environment having no chemical filter installed to an external air intake. In fabrication of the light emitting device C4, the time interval for the whole process from initiation of the step of forming the light emitting layer to completion of the step of forming the encapsulating layer during which the light emitting device in production is exposed to ozone was 110 minutes, and the average value of the ozone concentration for this time interval was 25 ppb. The average value of the ozone concentration: A ppb for the whole process during which the light emitting device in production is exposed to ozone was 25 ppb, and the time interval: B min for the whole process during which the light emitting device in production is exposed to ozone was 110 minutes, that is, A×B = 2750.
When voltage was applied to the light emitting device C4, EL emission (white) was observed. When the luminance was 1000 cd/$m^2$, the driving voltage was 10.0 V and the light emission efficiency was 10.0 cd/A.

[Table 4]

| | light emitting layer | A×B | light emission efficiency (cd/A) (1 kcd/$m^2$) |
|---|---|---|---|
| light emitting device 4 | polymer compound P5 /iridium complex 3 /iridium complex 4 /iridium complex 5 | 14 | 21.6 |
| light emitting device 5 | polymer compound P5 /iridium complex 3 /iridium complex 4 /iridium complex 5 | 625 | 21.2 |
| light emitting device C4 | polymer compound P5 /iridium complex 3 /iridium complex 4 /iridium complex 5 | 2750 | 10.0 |

<Example 6> Fabrication and evaluation of light emitting device 6

(Formation of anode and hole injection layer)

A glass substrate was attached with an ITO film with a thickness of 45 nm by a sputtering method, thereby forming an anode. On the anode, a polythiophene•sulfonic acid type hole injection agent AQ-1200 (manufactured by Plextronics) was spin-coated to form a film with a thickness of 35 nm, which was then heated on a hot plate at 170°C for 15 minutes under an air atmosphere, thereby forming a hole injection layer.

(Formation of hole transporting layer)

Into xylene was dissolved the polymer compound P2 at a concentration of 0.7 wt%. The resultant xylene solution was spin-coated on the hole injection layer to form a film with a thickness of 20 nm, and the film was heated at 180°C for 60 minutes under a nitrogen gas atmosphere, thereby forming a hole transporting layer.

(Formation of light emitting layer)

Into xylene were dissolved the polymer compound P5 and the iridium complex 3 (polymer compound P5/iridium complex 3 = 60/40) at a concentration of 2.0 wt%. The resultant xylene solution was spin-coated on the hole transporting layer to form a film with a thickness of 80 nm, and the film was heated at 130°C for 10 minutes under a nitrogen gas atmosphere, thereby forming a light emitting layer.

(Formation of cathode)

The substrate carrying the light emitting layer formed thereon was placed in a vapor deposition machine and the internal pressure thereof was reduced to $1.0\times10^{-4}$ Pa or less, then, as a cathode, sodium fluoride was vapor-deposited with a thickness of about 5 nm on the light emitting layer, then, aluminum was vapor-deposited with a thickness of about 60 nm on the sodium fluoride layer. After vapor deposition, an encapsulating layer was formed by using a glass substrate under a nitrogen gas atmosphere, thereby fabricating a light emitting device 6. A space is present between the anode, the cathode and each layer contained in the light emitting device 6 and the glass substrate used for formation of the encapsulating layer. Since formation of the encapsulating layer is conducted under a nitrogen gas atmosphere, the space is filled with a nitrogen gas.

The light emitting device 6 was fabricated under the indoor environment having a chemical filter (manufactured by NICHIAS Corporation, product name: Chemicalguard-AX (a chemical filter using activated carbon)) installed to an external air intake. In fabrication of the light emitting device 6, the time interval for the whole process from initiation of the step of forming the light emitting layer to completion of the step of forming the encapsulating layer during which the light emitting device in production is exposed to ozone was 20 minutes, and the average value of the ozone concentration for this time interval was 0.7 ppb. The average value of the ozone concentration: A ppb for the whole process during which the light emitting device in production is exposed to ozone was 0.7 ppb, and the time interval: B min for the whole process during which the light emitting device in production is exposed to ozone was 20 minutes, that is, $A\times B = 14$.

When voltage was applied to the light emitting device 6, EL emission (blue) was observed. When the luminance was 1000 cd/$m^2$, the driving voltage was 7.6 V and the light emission efficiency was 15.8 cd/A.

<Example 7> Fabrication and evaluation of light emitting device 7

A light emitting device 7 was fabricated in the same manner as for the light emitting device 6, excepting that fabrication was carried out under the indoor environment having no chemical filter installed to an external air intake. In fabrication of the light emitting device 7, the time interval for the whole process from initiation of the step of forming the light emitting layer to completion of the step of forming the encapsulating layer during which the light emitting device in production is exposed to ozone was 10 minutes, and the average value of the ozone concentration for this time interval was 25 ppb. The average value of the ozone concentration: A ppb for the whole process during which the light emitting device in production is exposed to ozone was 25 ppb, and the time interval: B min for the whole process during which the light emitting device in production is exposed to ozone was 10 minutes, that is, $A\times B = 250$.

When voltage was applied to the light emitting device 7, EL emission (blue) was observed. When the luminance was 1000 cd/$m^2$, the driving voltage was 8.0 V and the light emission efficiency was 15.1 cd/A.

<Example 8> Fabrication and evaluation of light emitting device 8

A light emitting device 8 was fabricated in the same manner as for the light emitting device 6, excepting that fabrication was carried out under the indoor environment having no chemical filter installed to an external air intake. In fabrication of the light emitting device 8, the time interval for the whole process from initiation of the step of forming the light emitting layer to completion of the step of forming the encapsulating layer during which the light emitting device in production is exposed to ozone was 25 minutes, and the average value of the ozone concentration for this time interval was 25 ppb. The average value of the ozone concentration: A ppb for the whole process during which the light emitting device in production is exposed to ozone was 25 ppb, and the time interval: B min for the whole process during which the light emitting device in production is exposed to ozone was 25 minutes, that is, $A\times B = 625$.

When voltage was applied to the light emitting device 8, EL emission (blue) was observed. When the luminance

was 1000 cd/$m^2$, the driving voltage was 8.2 V and the light emission efficiency was 15.0 cd/A.

<Comparative Example 5> Fabrication and evaluation of light emitting device C5

A light emitting device C5 was fabricated in the same manner as for the light emitting device 6, excepting that fabrication was carried out under the indoor environment having no chemical filter installed to an external air intake. In fabrication of the light emitting device C5, the time interval for the whole process from initiation of the step of forming the light emitting layer to completion of the step of forming the encapsulating layer during which the light emitting device in production is exposed to ozone was 110 minutes, and the average value of the ozone concentration for this time interval was 25 ppb. The average value of the ozone concentration: A ppb for the whole process during which the light emitting device in production is exposed to ozone was 25 ppb, and the time interval: B min for the whole process during which the light emitting device in production is exposed to ozone was 110 minutes, that is, $A \times B = 2750$.

When voltage was applied to the light emitting device C5, EL emission (blue) was observed. When the luminance was 1000 cd/$m^2$, the driving voltage was 10.1 V and the light emission efficiency was 9.0 cd/A.

[Table 5]

| | light emitting layer | $A \times B$ | light emission efficiency (cd/A) (1 kcd/$m^2$) |
|---|---|---|---|
| light emitting device 6 | polymer compound P5 /iridium complex 3 | 14 | 15.8 |
| light emitting device 7 | polymer compound P5 /iridium complex 3 | 250 | 15.1 |
| light emitting device 8 | polymer compound P5 /iridium complex 3 | 625 | 15.0 |
| light emitting device C5 | polymer compound P5 /iridium complex 3 | 2750 | 9.0 |

<Example 9> Fabrication and evaluation of light emitting device 9

(Formation of anode and hole injection layer)

A glass substrate was attached with an ITO film with a thickness of 45 nm by a sputtering method, thereby forming an anode. On the anode, a polythiophene•sulfonic acid type hole injection agent AQ-1200 (manufactured by Plextronics) was spin-coated to form a film with a thickness of 35 nm, which was then heated on a hot plate at 170°C for 15 minutes under an air atmosphere, thereby forming a hole injection layer.

(Formation of hole transporting layer)

Into xylene was dissolved the polymer compound P2 at a concentration of 0.7 wt%. The resultant xylene solution was spin-coated on the hole injection layer to form a film with a thickness of 20 nm, and the film was heated at 180°C for 60 minutes under a nitrogen gas atmosphere, thereby forming a hole transporting layer.

(Formation of light emitting layer)

Into toluene were dissolved the polymer compound P3 and the iridium complex 1 (polymer compound P3/an iridium complex 1 = 92.5 wt%/7.5 wt%) at a concentration of 1.3 wt%. The resultant toluene solution was spin-coated on the hole transporting layer to form a film with a thickness of 80 nm, and the film was heated at 150°C for 10 minutes under a nitrogen gas atmosphere, thereby forming a light emitting layer.

(Formation of cathode)

The substrate carrying the light emitting layer formed thereon was placed in a vapor deposition machine and the internal pressure thereof was reduced to $1.0 \times 10^{-4}$ Pa or less, then, as a cathode, sodium fluoride was vapor-deposited with a thickness of about 5 nm on the light emitting layer, then, aluminum was vapor-deposited with a thickness of about 60 nm on the sodium fluoride layer. After vapor deposition, an encapsulating layer was formed by using a glass substrate under a nitrogen gas atmosphere, thereby fabricating a light emitting device 9. A space is present between the anode, the cathode and each layer contained in the light emitting device 9 and the glass substrate used for formation of the encapsulating layer. Since formation of the encapsulating layer is conducted under a nitrogen gas atmosphere, the space is filled with a nitrogen gas.

The light emitting device 9 was fabricated under the indoor environment having a chemical filter (manufactured by NICHIAS Corporation, product name: Chemicalguard-AX (a chemical filter using activated carbon)) installed to an external air intake. In fabrication of the light emitting device 9, the time interval for the whole process from initiation of the step of forming the light emitting layer to completion of the step of forming the encapsulating layer during which the light emitting device in production is exposed to ozone was 60 minutes, and the average value of the ozone concentration for this time interval was 0.6 ppb. The average value of the ozone concentration: A ppb for the whole process during which the light emitting device in production is exposed to ozone was 0.6 ppb, and the time interval: B min for the whole process during which the light emitting device in production is exposed to ozone was 60 minutes, that is, A×B = 36.
When voltage was applied to the light emitting device 9, EL emission (red) was observed. When the luminance was 1000 cd/m$^2$, the driving voltage was 5.6 V and the light emission efficiency was 21.7 cd/A.

<Example 10> Fabrication and evaluation of light emitting device 10

A light emitting device 10 was fabricated in the same manner as for the light emitting layer 9. In fabrication of the light emitting device 10, the time interval for the whole process from initiation of the step of forming the light emitting layer to completion of the step of forming the encapsulating layer during which the light emitting device in production is exposed to ozone was 230 minutes, and the average value of the ozone concentration for this time interval was 0.7 ppb. The average value of the ozone concentration: A ppb for the whole process during which the light emitting device in production is exposed to ozone was 0.7 ppb, and the time interval: B min for the whole process during which the light emitting device in production is exposed to ozone was 230 minutes, that is, A×B = 161.
When voltage was applied to the light emitting device 10, EL emission (red) was observed. When the luminance was 1000 cd/m$^2$, the driving voltage was 5.7 V and the light emission efficiency was 21.9 cd/A.

<Comparative Example 6> Fabrication and evaluation of light emitting device C6

A light emitting device C6 was fabricated in the same manner as for the light emitting device 9, excepting that fabrication was carried out under the indoor environment having no chemical filter installed to an external air intake. In fabrication of the light emitting device C6, the time interval for the whole process from initiation of the step of forming the light emitting layer to completion of the step of forming the encapsulating layer during which the light emitting device in production is exposed to ozone was 115 minutes, and the average value of the ozone concentration for this time interval was 15 ppb. The average value of the ozone concentration: A ppb for the whole process during which the light emitting device in production is exposed to ozone was 15 ppb, and the time interval: B min for the whole process during which the light emitting device in production is exposed to ozone was 115 minutes, that is, A×B = 1725.
When voltage was applied to the light emitting device C6, EL emission (red) was observed. When the luminance was 1000 cd/m$^2$, the driving voltage was 6.7 V and the light emission efficiency was 17.2 cd/A.

<Comparative Example 7> Fabrication and evaluation of light emitting device C7

A light emitting device C7 was fabricated in the same manner as for the light emitting device 9, excepting that fabrication was carried out under the indoor environment having no chemical filter installed to an external air intake. In fabrication of the light emitting device C7, the time interval for the whole process from initiation of the step of forming the light emitting layer to completion of the step of forming the encapsulating layer during which the light emitting device in production is exposed to ozone was 260 minutes, and the average value of the ozone concentration for this time interval was 18 ppb. The average value of the ozone concentration: A ppb for the whole process during which the light emitting device in production is exposed to ozone was 18 ppb, and the time interval: B min for the whole process during which the light emitting device in production is exposed to ozone was 260 minutes, that is, A×B = 4680.
When voltage was applied to the light emitting device C7, EL emission (red) was observed. When the luminance was 1000 cd/m$^2$, the driving voltage was 7.5 V and the light emission efficiency was 12.4 cd/A.

[Table 6]

| | light emitting layer | A×B | light emission efficiency (cd/A) (1 kcd/m$^2$) |
|---|---|---|---|
| light emitting device 9 | polymer compound P3/iridium complex 1 | 36 | 21.7 |
| light emitting device 10 | polymer compound P3 /iridium complex 1 | 161 | 21.9 |
| light emitting device C6 | polymer compound P3 /iridium complex 1 | 1725 | 17.2 |

(continued)

| | light emitting layer | A×B | light emission efficiency (cd/A) (1 kcd/m$^2$) |
|---|---|---|---|
| light emitting device C7 | polymer compound P3 /iridium complex 1 | 4680 | 12.4 |

<Example 11> Fabrication and evaluation of light emitting device 11

(Formation of anode and hole injection layer)

A glass substrate was attached with an ITO film with a thickness of 45 nm by a sputtering method, thereby forming an anode. On the anode, a polythiophene•sulfonic acid type hole injection agent AQ-1200 (manufactured by Plextronics) was spin-coated to form a film with a thickness of 35 nm, which was then heated on a hot plate at 170°C for 15 minutes under an air atmosphere, thereby forming a hole injection layer.

(Formation of hole transporting layer)

Into xylene was dissolved the polymer compound P2 at a concentration of 0.7 wt%. The resultant xylene solution was spin-coated on the hole injection layer to form a film with a thickness of 20 nm, and the film was heated at 180°C for 60 minutes under a nitrogen gas atmosphere, thereby forming a hole transporting layer.

(Formation of light emitting layer)

Into toluene were dissolved a low molecular weight compound SM1 (manufactured by Luminescence Technology, LT-N4013) and an iridium complex 6 (low molecular weight compound SM1/iridium complex 6 = 90 wt%/10 wt%) at a concentration of 1.9 wt%. The resultant toluene solution was spin-coated on the hole transporting layer to form a film with a thickness of 60 nm, and the film was heated at 130°C for 10 minutes under a nitrogen gas atmosphere, thereby forming a light emitting layer.

[Chemical Formula 94]

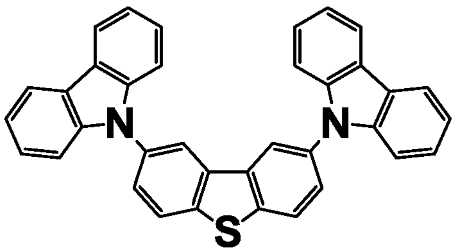

Low molecular weight compound SM1

(Formation of electron transporting layer)

Into 2,2,3,3,4,4,5,5-octafluoro-1-pentanol was dissolved the polymer compound P6 at a concentration of 0.25 wt%. The resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer.

(Formation of cathode)

The substrate carrying the electron transporting layer formed thereon was placed in a vapor deposition machine and the internal pressure thereof was reduced to $1.0\times10^{-4}$ Pa or less, then, as a cathode, sodium fluoride was vapor-deposited with a thickness of about 5 nm on the electron transporting layer, then, aluminum was vapor-deposited with a thickness of about 60 nm on the sodium fluoride layer. After vapor deposition, an encapsulating layer was formed by using a glass substrate under a nitrogen gas atmosphere, thereby fabricating a light emitting device 11. A space is present between the anode, the cathode and each layer contained in the light emitting device 11 and the glass substrate

used for formation of the encapsulating layer. Since formation of the encapsulating layer is conducted under a nitrogen gas atmosphere, the space is filled with a nitrogen gas.

The light emitting device 11 was fabricated under the indoor environment having a chemical filter (manufactured by NICHIAS Corporation, product name: Chemicalguard-AX (a chemical filter using activated carbon)) installed to an external air intake. In fabrication of the light emitting device 11, the time interval for the whole process from initiation of the step of forming the light emitting layer to completion of the step of forming the encapsulating layer during which the light emitting device in production is exposed to ozone was 230 minutes, and the average value of the ozone concentration for this time interval was 0.7 ppb. The average value of the ozone concentration: A ppb for the whole process during which the light emitting device in production is exposed to ozone was 0.7 ppb, and the time interval: B min for the whole process during which the light emitting device in production is exposed to ozone was 230 minutes, that is, A×B = 161.

When voltage was applied to the light emitting device 11, EL emission (blue) was observed. When the luminance was 1000 cd/$m^2$, the driving voltage was 5.5 V and the light emission efficiency was 8.8 cd/A.

<Comparative Example 8> Fabrication and evaluation of light emitting device C8

A light emitting device C8 was fabricated in the same manner as for the light emitting device 11, excepting that fabrication was carried out under the indoor environment having no chemical filter installed to an external air intake. In fabrication of the light emitting device C8, the time interval for the whole process from initiation of the step of forming the light emitting layer to completion of the step of forming the encapsulating layer during which the light emitting device in production is exposed to ozone was 115 minutes, and the average value of the ozone concentration for this time interval was 15 ppb. The average value of the ozone concentration: A ppb for the whole process during which the light emitting device in production is exposed to ozone was 15 ppb, and the time interval: B min for the whole process during which the light emitting device in production is exposed to ozone was 115 minutes, that is, A×B = 1725.

When voltage was applied to the light emitting device C8, EL emission (blue) was observed. When the luminance was 1000 cd/$m^2$, the driving voltage was 7.5 V and the light emission efficiency was 4.9 cd/A.

[Table 7]

| | light emitting layer | A×B | light emission efficiency (cd/A) (1 kcd/$m^2$) |
|---|---|---|---|
| light emitting device 11 | low molecular weight compound SM1/iridium complex 6 | 161 | 8.8 |
| light emitting device C8 | low molecular weight compound SM1/iridium complex 6 | 1725 | 4.9 |

<Example 12> Fabrication and evaluation of light emitting device 12

(Formation of anode and hole injection layer)

A glass substrate was attached with an ITO film with a thickness of 45 nm by a sputtering method, thereby forming an anode. On the anode, a polythiophene•sulfonic acid type hole injection agent AQ-1200 (manufactured by Plextronics) was spin-coated to form a film with a thickness of 35 nm, which was then heated on a hot plate at 170°C for 15 minutes under an air atmosphere, thereby forming a hole injection layer.

(Formation of hole transporting layer)

Into xylene was dissolved the polymer compound P2 at a concentration of 0.7 wt%. The resultant xylene solution was spin-coated on the hole injection layer to form a film with a thickness of 20 nm, and the film was heated at 180°C for 60 minutes under a nitrogen gas atmosphere, thereby forming a hole transporting layer.

(Formation of light emitting layer)

Into toluene were dissolved a low molecular weight compound SM1 (manufactured by Luminescence Technology, LT-N4013) and an iridium complex 7 (low molecular weight compound SM1/iridium complex 7 = 70 wt%/30 wt%) at a concentration of 1.5 wt%. The resultant toluene solution was spin-coated on the hole transporting layer to form a film with a thickness of 60 nm, and the film was heated at 130°C for 10 minutes under a nitrogen gas atmosphere, thereby forming a light emitting layer.

(Formation of electron transporting layer)

Into 2,2,3,3,4,4,5,5-octafluoro-1-pentanol was dissolved the polymer compound P6 at a concentration of 0.25 wt%. The resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer.

(Formation of cathode)

The substrate carrying the electron transporting layer formed thereon was placed in a vapor deposition machine and the internal pressure thereof was reduced to $1.0 \times 10^{-4}$ Pa or less, then, as a cathode, sodium fluoride was vapor-deposited with a thickness of about 5 nm on the electron transporting layer, then, aluminum was vapor-deposited with a thickness of about 60 nm on the sodium fluoride layer. After vapor deposition, an encapsulating layer was formed by using a glass substrate under a nitrogen gas atmosphere, thereby fabricating a light emitting device 12. A space is present between the anode, the cathode and each layer contained in the light emitting device 12 and the glass substrate used for formation of the encapsulating layer. Since formation of the encapsulating layer is conducted under a nitrogen gas atmosphere, the space is filled with a nitrogen gas.

The light emitting device 12 was fabricated under the indoor environment having a chemical filter (manufactured by NICHIAS Corporation, product name: Chemicalguard-AX (a chemical filter using activated carbon)) installed to an external air intake. In fabrication of the light emitting device 12, the time interval for the whole process from initiation of the step of forming the light emitting layer to completion of the step of forming the encapsulating layer during which the light emitting device in production is exposed to ozone was 515 minutes, and the average value of the ozone concentration for this time interval was 0.5 ppb. The average value of the ozone concentration: A ppb for the whole process during which the light emitting device in production is exposed to ozone was 0.5 ppb, and the time interval: B min for the whole process during which the light emitting device in production is exposed to ozone was 515 minutes, that is, $A \times B = 257.5$.

When voltage was applied to the light emitting device 12, EL emission (blue) was observed. When the luminance was 200 cd/m$^2$, the driving voltage was 5.0 V and the light emission efficiency was 8.3 cd/A.

<Comparative Example 9> Fabrication and evaluation of light emitting device C9

A light emitting device C9 was fabricated in the same manner as for the light emitting device 13, excepting that fabrication was carried out under the indoor environment having no chemical filter installed to an external air intake. In fabrication of the light emitting device C9, the time interval for the whole process from initiation of the step of forming the light emitting layer to completion of the step of forming the encapsulating layer during which the light emitting device in production is exposed to ozone was 115 minutes, and the average value of the ozone concentration for this time interval was 15 ppb. The average value of the ozone concentration: A ppb for the whole process during which the light emitting device in production is exposed to ozone was 15 ppb, and the time interval: B min for the whole process during which the light emitting device in production is exposed to ozone was 115 minutes, that is, $A \times B = 1725$.

When voltage was applied to the light emitting device C9, EL emission (blue) was observed. When the luminance was 200 cd/m$^2$, the driving voltage was 10.0 V and the light emission efficiency was 6.4 cd/A.

<Comparative Example 10> Fabrication and evaluation of light emitting device C10

A light emitting device C10 was fabricated in the same manner as for the light emitting device 13, excepting that fabrication was carried out under the indoor environment having no chemical filter installed to an external air intake. In fabrication of the light emitting device C10, the time interval for the whole process from initiation of the step of forming the light emitting layer to completion of the step of forming the encapsulating layer during which the light emitting device in production is exposed to ozone was 260 minutes, and the average value of the ozone concentration for this time interval was 18 ppb. The average value of the ozone concentration: A ppb for the whole process during which the light emitting device in production is exposed to ozone was 18 ppb, and the time interval: B min for the whole process during which the light emitting device in production is exposed to ozone was 260 minutes, that is, $A \times B = 4680$.

When voltage was applied to the light emitting device C10, EL emission (blue) was observed. When the luminance was 200 cd/m$^2$, the driving voltage was 11.5 V and the light emission efficiency was 4.3 cd/A.

[Table 8]

| | light emitting layer | A×B | light emission efficiency (cd/A) (200 cd/m$^2$) |
|---|---|---|---|
| light emitting device 12 | low molecular weight compound SM1 /iridium complex 7 | 257.5 | 8.3 |
| light emitting device C9 | low molecular weight compound SM1 /iridium complex 7 | 1725 | 6.4 |
| light emitting device C10 | low molecular weight compound SM1 /iridium complex 7 | 4680 | 4.3 |

Industrial Applicability

According to the present invention, a method of producing a light emitting device excellent in light emission efficiency can be provided. Further, according to a preferable embodiment of the present invention, a method of producing a light emitting device excellent in luminance life can be provided.

## Claims

1. A method of producing a light emitting device comprising an anode, a cathode, a light emitting layer disposed between the anode and the cathode, and an encapsulating layer, comprising
a step of forming the light emitting layer by an application method using an iridium complex having an iridium atom as the central metal or a polymer compound comprising a constitutional unit derived from an iridium complex having an iridium atom as the central metal,
a step of forming the anode or the cathode, and
a step of forming the encapsulating layer,
wherein for the whole process from initiation of the step of forming the light emitting layer to completion of the step of forming the encapsulating layer during which the light emitting device in production is exposed to ozone, the average value of the ozone concentration: A ppb and the time interval: B min satisfy the formula (1-1):

$$0 \leq A \times B \leq 1000 \qquad (1\text{-}1)$$

and the iridium complex is an iridium complex represented by the formula (4):

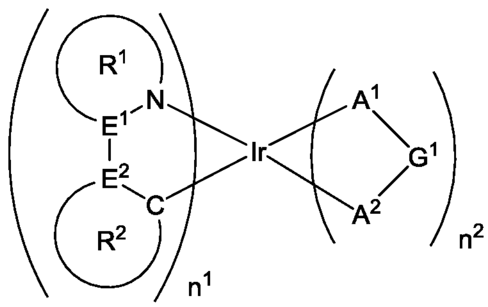

**(4)**

wherein
$n^1$ represents an integer of 1 or more, $n^2$ represents an integer of 0 or more, and $n^1$+$n^2$ is 3,
$E^1$ and $E^2$ each independently represent a carbon atom or a nitrogen atom, and at least one of $E^1$ and $E^2$ is a carbon atom,
the ring $R^1$ represents a 5-membered or 6-membered aromatic heterocyclic ring and these rings each optionally have a substituent, and when a plurality of the substituents are present, they may be the same or different and may be combined together to form a ring together with the atoms to which they are attached, and when a plurality of the rings $R^1$ are present, they may be the same or different, and $E^1$ is a carbon atom when the ring $R^1$ is a 6-membered aromatic heterocyclic ring,

the ring $R^2$ represents a 5-membered or 6-membered aromatic hydrocarbon ring or a 5-membered or 6-membered aromatic heterocyclic ring and these rings each optionally have a substituent, and when a plurality of the substituents are present, they may be the same or different and may be combined together to form a ring together with the atoms to which they are attached, and when a plurality of the rings $R^2$ are present, they may be the same or different, and $E^2$ is a carbon atom when the ring $R^2$ is a 6-membered aromatic heterocyclic ring, and
$A^1$-$G^1$-$A^2$ represents an anionic bidentate ligand, and $A^1$ and $A^2$ each independently represent a carbon atom, an oxygen atom or a nitrogen atom, and these atoms each may be an atom constituting a ring, and $G^1$ represents a single bond or an atomic group constituting the bidentate ligand together with $A^1$ and $A^2$, and when a plurality of $A^1$-$G^1$-$A^2$ are present, they may be the same or different.

**2.** The method of producing a light emitting device according to claim 1, wherein A and B satisfy the formula (1-2) :

$$0 \leq A \times B \leq 100 \qquad (1\text{-}2).$$

**3.** The method of producing a light emitting device according to claim 1 or 2, wherein A satisfies the formula (2-1) :

$$0 \leq A \leq 30 \qquad (2\text{-}1).$$

**4.** The method of producing a light emitting device according to any one of claims 1 to 3, wherein B satisfies the formula (3-0):

$$0 \leq B \leq 1000 \qquad (3\text{-}0).$$

**5.** The method of producing a light emitting device according to any one of claims 1 to 4, wherein the whole process from initiation of the step of forming the light emitting layer to completion of the step of forming the encapsulating layer is performed under an environment using a chemical filter.

**6.** The method of producing a light emitting device according to any one of claims 1 to 5, wherein the iridium complex represented by the formula (4) is an iridium complex represented by the formula (4-A1), an iridium complex represented by the formula (4-A2), an iridium complex represented by the formula (4-A3) or an iridium complex represented by the formula (4-A4):

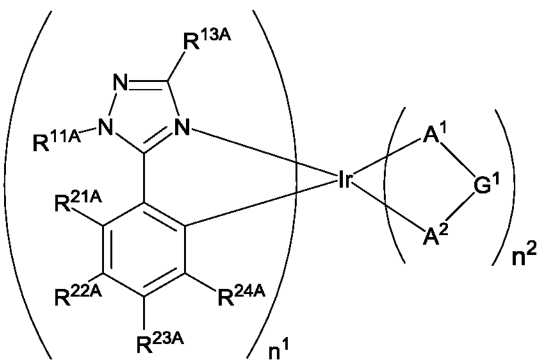

(4-A1)

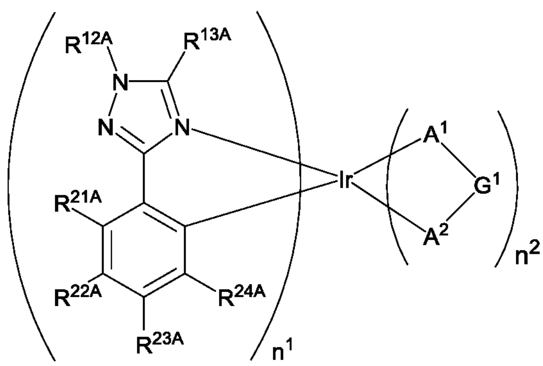

(4-A2)

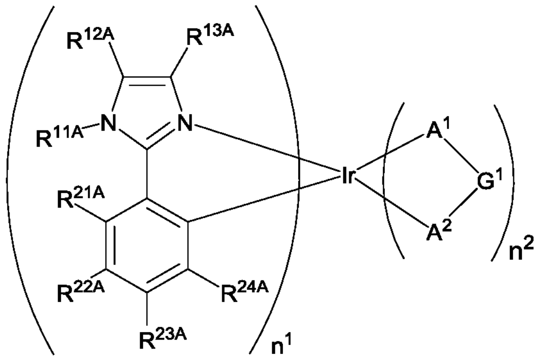

**(4-A3)**

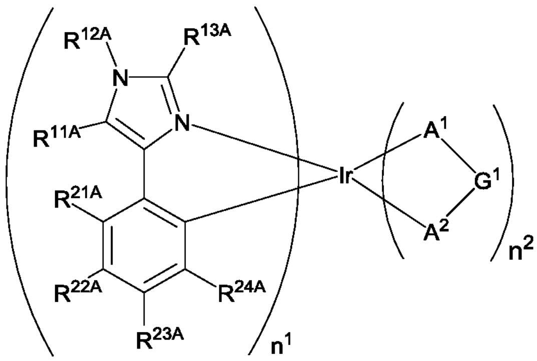

**(4-A4)**

wherein

$n^1$, $n^2$ and $A^1$-$G^1$-$A^2$ represent the same meaning as described above, and

$R^{11A}$, $R^{12A}$, $R^{13A}$, $R^{21A}$, $R^{22A}$, $R^{23A}$ and $R^{24A}$ each independently represent a hydrogen atom, an alkyl group, a cycloalkyl group, an alkoxy group, a cycloalkoxy group, an aryl group, an aryloxy group, a monovalent heterocyclic group, a substituted amino group or a halogen atom and these groups each optionally have a substituent, and when a plurality of $R^{11A}$, $R^{12A}$, $R^{13A}$, $R^{21A}$, $R^{22A}$, $R^{23A}$ and $R^{24A}$ are present, they may be the same or different at each occurrence, and $R^{11A}$ and $R^{12A}$, $R^{12A}$ and $R^{13A}$, $R^{11A}$ and $R^{21A}$, $R^{21A}$ and $R^{22A}$, $R^{22A}$ and $R^{23A}$, and $R^{23A}$ and $R^{24A}$ each may be combined together to form a ring together with the atoms to which they are attached.

**7.** The method of producing a light emitting device according to any one of claims 1 to 5, wherein the iridium complex represented by the formula (4) is an iridium complex represented by the formula (4-B1), an iridium complex represented by the formula (4-B2) or an iridium complex represented by the formula (4-B3):

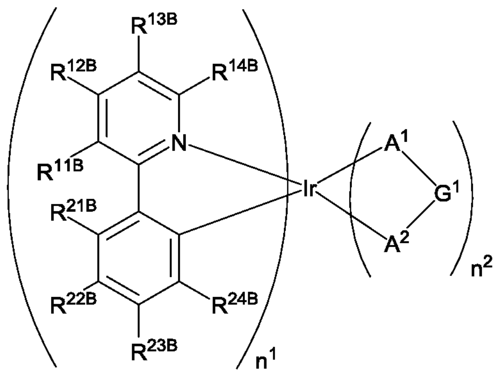

**(4-B1)**

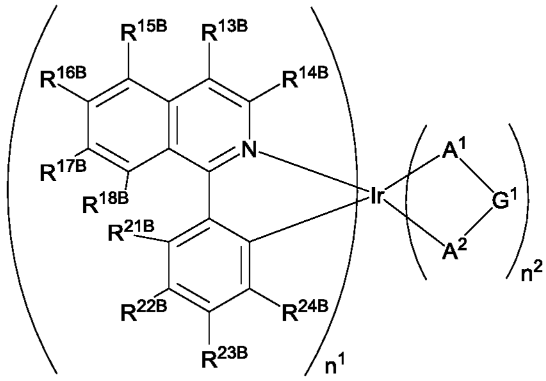

**(4-B2)**

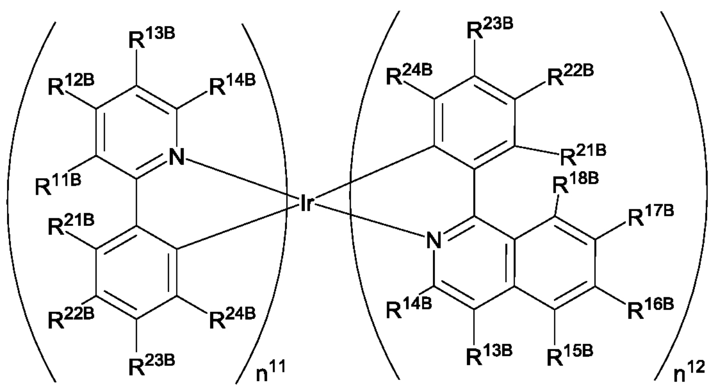

**(4-B3)**

wherein

$n^1$, $n^2$ and $A^1$-$G^1$-$A^2$ represent the same meaning as described above,
$n^{11}$ represents an integer of 1 or more, $n^{12}$ represents an integer of 1 or more, and $n^{11}+n^{12}$ is 3, and
$R^{11B}$, $R^{12B}$, $R^{13B}$, $R^{14B}$, $R^{15B}$, $R^{16B}$, $R^{17B}$, $R^{18B}$, $R^{21B}$, $R^{22B}$, $R^{23B}$ and $R^{24B}$ each independently represent a hydrogen atom, an alkyl group, a cycloalkyl group, an alkoxy group, a cycloalkoxy group, an aryl group, an aryloxy group, a monovalent heterocyclic group or a halogen atom and these groups each optionally have a substituent, and when a plurality of $R^{11B}$, $R^{12B}$, $R^{13B}$, $R^{14B}$, $R^{15B}$, $R^{16B}$, $R^{17B}$, $R^{18B}$, $R^{21B}$, $R^{22B}$, $R^{23B}$ and $R^{24B}$ are present, they may be the same or different at each occurrence, and $R^{11B}$ and $R^{12B}$, $R^{12B}$ and $R^{13B}$, $R^{13B}$ and $R^{14B}$, $R^{13B}$ and $R^{15B}$, $R^{15B}$ and $R^{16B}$, $R^{16B}$ and $R^{17B}$, $R^{17B}$ and $R^{18B}$, $R^{11B}$ and $R^{21B}$, $R^{18B}$ and $R^{21B}$, $R^{21B}$ and $R^{22B}$, $R^{22B}$ and $R^{23B}$, and $R^{23B}$ and $R^{24B}$ each may be combined together to form a ring together with the carbon atoms to which they are attached.

8. The method of producing a light emitting device according to any one of claims 1 to 7, wherein the light emitting layer is formed by an application method by using an ink containing an iridium complex or a polymer compound comprising a constitutional unit derived from an iridium complex and a compound represented by the formula (H-1):

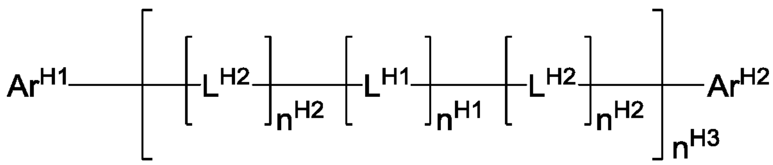

**(H-1)**

wherein
$Ar^{H1}$ and $Ar^{H2}$ each independently represent an aryl group or a monovalent heterocyclic group and these groups each optionally have a substituent,
$n^{H1}$ and $n^{H2}$ each independently represent 0 or 1, and when a plurality of $n^{H1}$ are present, they may be the same or different, and the plurality of $n^{H2}$ may be the same or different,
$n^{H3}$ represents an integer of 0 or more,
$L^{H1}$ represents an arylene group, a divalent heterocyclic group or a group represented by-$[C(R^{H11})_2]n^{H11}$- and these groups each optionally have a substituent, and when a plurality of $L^{H1}$ are present, they may be the same or different,
$n^{H11}$ represents an integer of 1 to 10, and $R^{H11}$ represents a hydrogen atom, an alkyl group, a cycloalkyl group, an alkoxy group, a cycloalkoxy group, an aryl group or a monovalent heterocyclic group and these groups each optionally have a substituent, and the plurality of $R^{H11}$ may be the same or different and may be combined together to form a ring together with the carbon atoms to which they are attached,
$L^{H2}$ represents a group represented by -N(-$L^{H21}$-$R^{H21}$)-, and when a plurality of $L^{H2}$ are present, they may be the same or different, and
$L^{H21}$ represents a single bond, an arylene group or a divalent heterocyclic group and these groups each optionally have a substituent, and $R^{H21}$ represents a hydrogen atom, an alkyl group, a cycloalkyl group, an aryl group or a monovalent heterocyclic group and these groups each optionally have a substituent.

9. The method of producing a light emitting device according to claim 8, wherein the compound represented by the formula (H-1) is a compound represented by the formula (H-2) :

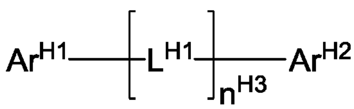

**(H-2)**

wherein $Ar^{H1}$, $Ar^{H2}$, $n^{H3}$ and $L^{H1}$ represent the same meaning as described above.

10. The method of producing a light emitting device according to any one of claims 1 to 7, wherein the light emitting layer is formed by an application method by using an ink containing an iridium complex or a polymer compound comprising a constitutional unit derived from an iridium complex and a polymer compound comprising a constitutional unit represented by the formula (Y):

$-[Ar^{Y1}]-$ (Y)

wherein $Ar^{Y1}$ represents an arylene group, a divalent heterocyclic group or a divalent group in which at least one arylene group and at least one divalent heterocyclic group are bonded directly to each other, and these groups each

optionally have a substituent.

**11.** The method of producing a light emitting device according to claim 10, wherein the polymer compound further comprises a constitutional unit represented by the formula (X) :

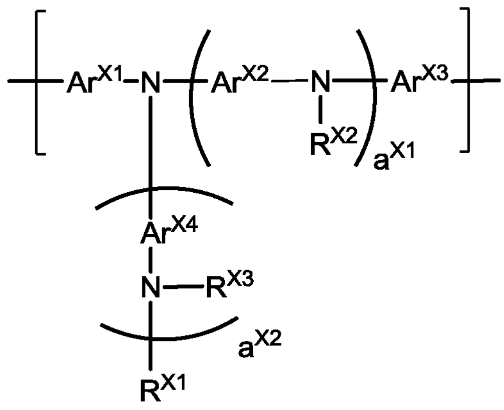

(X)

wherein
$a^{X1}$ and $a^{X2}$ each independently represent an integer of 0 or more,
$Ar^{X1}$ and $Ar^{X3}$ each independently represent an arylene group or a divalent heterocyclic group and these groups each optionally have a substituent,
$Ar^{X2}$ and $Ar^{X4}$ each independently represent an arylene group, a divalent heterocyclic group or a divalent group in which at least one arylene group and at least one divalent heterocyclic group are bonded directly to each other, and these groups each optionally have a substituent, and
$R^{X1}$, $R^{X2}$ and $R^{X3}$ each independently represent a hydrogen atom, an alkyl group, a cycloalkyl group, an aryl group or a monovalent heterocyclic group and these groups each optionally have a substituent.

## Patentansprüche

**1.** Verfahren zur Herstellung einer lichtemittierenden Vorrichtung mit einer Anode, einer Kathode, einer zwischen der Anode und der Kathode angeordneten lichtemittierenden Schicht und einer einkapselnden Schicht, umfassend
einen Schritt der Bildung der lichtemittierenden Schicht durch ein Applikationsverfahren unter Verwendung eines Iridiumkomplexes mit einem Iridiumatom als zentralem Metall oder einer Polymerverbindung, die eine von einem Iridiumkomplex mit einem Iridiumatom als zentralem Metall abgeleitete konstitutionelle Einheit umfasst,
einen Schritt zur Bildung der Anode oder der Kathode und
einen Schritt zur Bildung der einkapselnden Schicht,
wobei für den gesamten Prozess vom Beginn des Schrittes der Bildung der lichtemittierenden Schicht bis zum Abschluss des Schrittes der Bildung der einkapselnden Schicht, während dessen die lichtemittierende Vorrichtung in der Produktion Ozon ausgesetzt wird, der Durchschnittswert der Ozonkonzentration: A ppb und das Zeitintervall: B min der Formel (1-1) genügen:

$$0 \leq AxB \leq 1000 \qquad (1-1)$$

und der Iridiumkomplex ein Iridiumkomplex der Formel (4) ist:

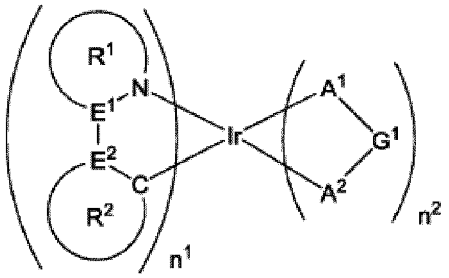

(4)

wobei

$n^1$ eine ganze Zahl von 1 oder mehr ist, $n^2$ eine ganze Zahl von 0 oder mehr ist, und $n^1+n^2$ 3 ist,

$E^1$ und $E^2$ jeweils unabhängig voneinander ein Kohlenstoffatom oder ein Stickstoffatom darstellen und mindestens eines von $E^1$ und $E^2$ ein Kohlenstoffatom ist, der Ring $R^1$ einen 5- oder 6-gliedrigen aromatischen heterocyclischen Ring darstellt und diese Ringe jeweils gegebenenfalls einen Substituenten aufweisen, und wenn mehrere Substituenten vorhanden sind, können sie gleich oder verschieden sein und zusammen mit den Atomen, an die sie gebunden sind, einen Ring bilden, und wenn mehrere der Ringe $R^1$ vorhanden sind, können sie gleich oder verschieden sein, und $E^1$ ist ein Kohlenstoffatom, wenn der Ring $R^1$ ein 6-gliedriger aromatischer heterocyclischer Ring ist,

der Ring $R^2$ einen 5- oder 6-gliedrigen aromatischen Kohlenwasserstoffring oder einen 5- oder 6-gliedrigen aromatischen heterocyclischen Ring darstellt und diese Ringe jeweils gegebenenfalls einen Substituenten aufweisen, und wenn mehrere Substituenten vorhanden sind, können sie gleich oder verschieden sein und können zusammen mit den Atomen, an die sie gebunden sind, einen Ring bilden, und wenn mehrere der Ringe $R^2$ vorhanden sind, können sie gleich oder verschieden sein, und $E^2$ ist ein Kohlenstoffatom, wenn der Ring $R^2$ ein 6-gliedriger aromatischer heterocyclischer Ring ist, und

$A^1$-$G^1$-$A^2$ einen anionischen zweizähnigen Liganden darstellt und $A^1$ und $A^2$ jeweils unabhängig voneinander ein Kohlenstoffatom, ein Sauerstoffatom oder ein Stickstoffatom darstellen und diese Atome jeweils ein Atom sein können, das einen Ring bildet, und $G^1$ eine Einfachbindung oder eine Atomgruppe darstellt, die den zweizähnigen Liganden zusammen mit $A^1$ und $A^2$ bildet, und wenn mehrere $A^1$-$G^1$-$A^2$ vorhanden sind, können sie gleich oder verschieden sein.

**2.** Verfahren zur Herstellung einer lichtemittierenden Vorrichtung nach Anspruch 1, wobei A und B die Formel (1-2) erfüllen:

$$0 \leq AxB \leq 100 \qquad (1\text{-}2).$$

**3.** Verfahren zur Herstellung einer lichtemittierenden Vorrichtung nach Anspruch 1 oder 2, wobei A die Formel (2-1) erfüllt:

$$0 \leq A \leq 30 \qquad (2\text{-}1).$$

**4.** Verfahren zur Herstellung einer lichtemittierenden Vorrichtung nach einem der Ansprüche 1 bis 3, wobei B die Formel (3-0) erfüllt:

$$0 \leq B \leq 1000 \qquad (3\text{-}0).$$

**5.** Verfahren zur Herstellung einer lichtemittierenden Vorrichtung nach einem der Ansprüche 1 bis 4, wobei der gesamte Prozess von der Einleitung des Schrittes der Bildung der lichtemittierenden Schicht bis zum Abschluss des Schrittes der Bildung der einkapselnden Schicht in einer Umgebung unter Verwendung eines chemischen Filters durchgeführt wird.

**6.** Verfahren zur Herstellung einer lichtemittierenden Vorrichtung nach einem der Ansprüche 1 bis 5, wobei der Iridiumkomplex der Formel (4) ein Iridiumkomplex der Formel (4-A1), ein Iridiumkomplex der Formel (4-A2), ein Iridiumkomplex der Formel (4-A3) oder ein Iridiumkomplex der Formel (4-A4) ist:

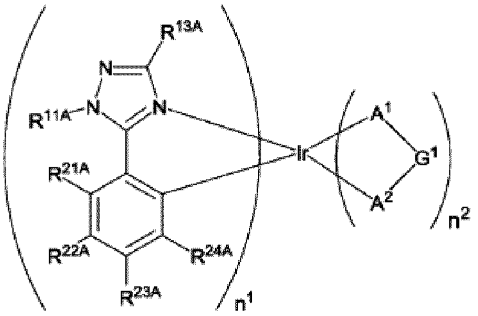

**(4-A1)**

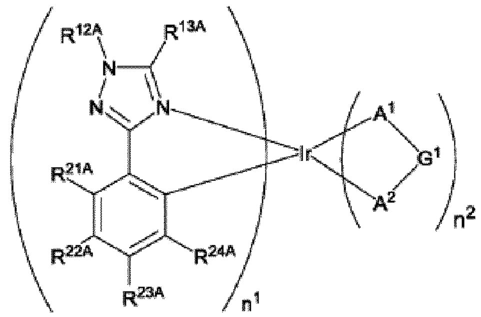

**(4-A2)**

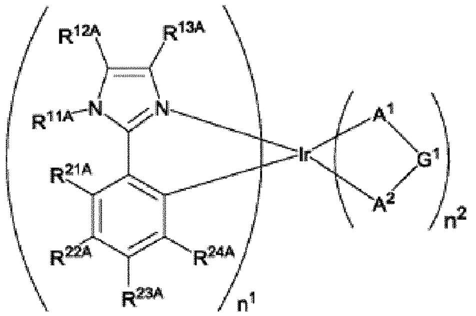

**(4-A3)**

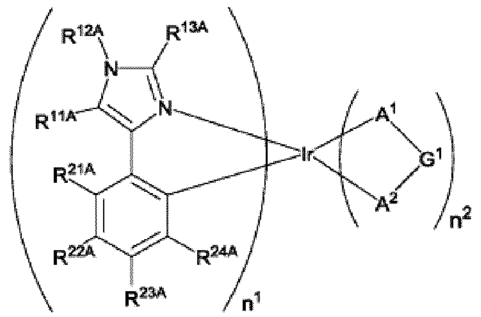

**(4-A4)**

wobei
$n^1$, $n^2$ und $A^1$-$G^1$-$A^2$ dieselbe Bedeutung wie oben beschrieben haben, und
$R^{11A}$, $R^{12A}$, $R^{13A}$, $R^{21A}$, $R^{22A}$, $R^{23A}$ und $R^{24A}$ jeweils unabhängig voneinander ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe, eine substituierte Aminogruppe oder ein Halogenatom darstellen und diese Gruppen jeweils gegebenenfalls einen Substituenten aufweisen, und wenn mehrere $R^{11A}$, $R^{12A}$, $R^{13A}$, $R^{21A}$, $R^{22A}$, $R^{23A}$ und $R^{24A}$ vorhanden sind, können sie bei jedem Auftreten gleich oder verschieden sein, und $R^{11A}$ und $R^{12A}$, $R^{12A}$ und $R^{13A}$, $R^{11A}$ und $R^{21A}$, $R^{21A}$ und $R^{22A}$, $R^{22A}$ und $R^{23A}$, und $R^{23A}$ und $R^{24A}$ können jeweils zusammen mit den Atomen, an die sie gebunden sind, einen Ring bilden.

**7.** Verfahren zur Herstellung einer lichtemittierenden Vorrichtung nach einem der Ansprüche 1 bis 5, wobei der Iridiumkomplex der Formel (4) ein Iridiumkomplex der Formel (4-B1), ein Iridiumkomplex der Formel (4-B2) oder ein Iridiumkomplex der Formel (4-B3) ist:

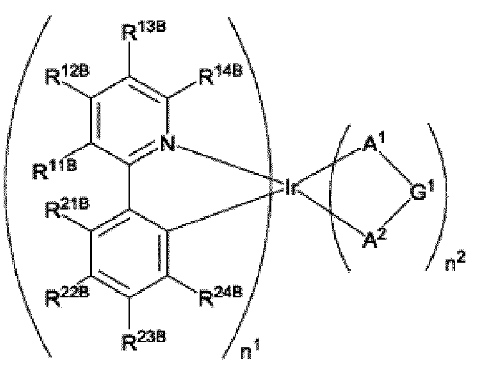

**(4-B1)**

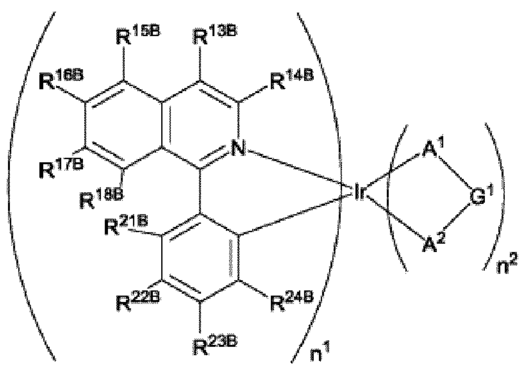

**(4-B2)**

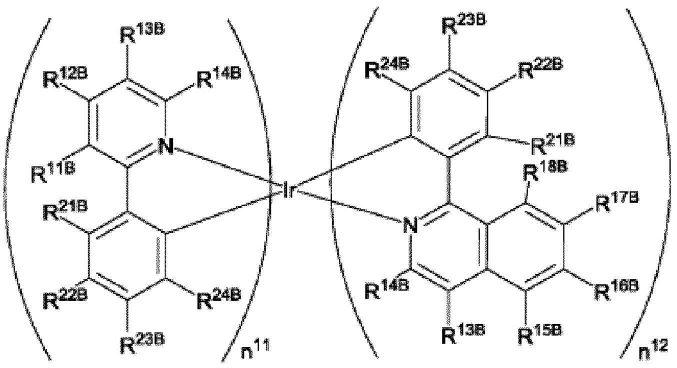

(4-B3)

$n^1$, $n^2$ und $A^1$-$G^1$-$A^2$ dieselbe Bedeutung wie oben beschrieben haben,
$n^{11}$ eine ganze Zahl von 1 oder mehr ist, $n^{12}$ eine ganze Zahl von 1 oder mehr ist, und $n^{11}+n^{12}$ 3 ist,
$R^{11B}$, $R^{12B}$, $R^{13B}$, $R^{14B}$, $R^{15B}$, $R^{16B}$, $R^{17B}$, $R^{18B}$, $R^{21B}$, $R^{22B}$, $R^{23B}$ und $R^{24B}$ jeweils unabhängig voneinander ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe oder ein Halogenatom darstellen und diese Gruppen jeweils gegebenenfalls einen Substituenten aufweisen, und wenn mehrere $R^{11B}$, $R^{12B}$, $R^{13B}$, $R^{14B}$, $R^{15B}$, $R^{16B}$, $R^{17B}$, $R^{18B}$, $R^{21B}$, $R^{22B}$, $R^{23B}$ und $R^{24B}$ vorhanden sind, können sie bei jedem Auftreten gleich oder verschieden sein, und $R^{11B}$ und $R^{12B}$, $R^{12B}$ und $R^{13B}$, $R^{13B}$ und $R^{14B}$, $R^{13B}$ und $R^{15B}$, $R^{15B}$ und $R^{16B}$, $R^{16B}$ und $R^{17B}$, $R^{17B}$ und $R^{18B}$, $R^{11B}$ und $R^{21B}$, $R^{18B}$ und $R^{21B}$, $R^{21B}$ und $R^{22B}$, $R^{22B}$ und $R^{23B}$, und $R^{23B}$ und $R^{24B}$ können jeweils zusammen mit den Kohlenstoffatomen, an die sie gebunden sind, einen Ring bilden.

**8.** Verfahren zur Herstellung einer lichtemittierenden Vorrichtung nach einem der Ansprüche 1 bis 7, wobei die lichtemittierende Schicht durch ein Auftragsverfahren unter Verwendung einer Tinte gebildet wird, die einen Iridiumkomplex oder eine Polymerverbindung enthält, die eine von einem Iridiumkomplex abgeleitete konstitutionelle Einheit und eine Verbindung der Formel (H-1) umfasst:

$$Ar^{H1}-\left[\left[L^{H2}\right]_{n^{H2}}-\left[L^{H1}\right]_{n^{H1}}-\left[L^{H2}\right]_{n^{H2}}\right]_{n^{H3}}-Ar^{H2} \qquad \textbf{(H-1)}$$

wobei
$Ar^{H1}$ und $Ar^{H2}$ jeweils unabhängig voneinander eine Arylgruppe oder eine monovalente heterocyclische Gruppe darstellen und diese Gruppen jeweils gegebenenfalls einen Substituenten aufweisen,
$n^{H1}$ und $n^{H2}$ jeweils unabhängig voneinander 0 oder 1 darstellen, und wenn mehrere $n^{H1}$ vorhanden sind, können sie gleich oder verschieden sein, und die mehreren $n^{H2}$ können gleich oder verschieden sein,
$n^{H3}$ für eine ganze Zahl von 0 oder mehr steht,
$L^{H1}$ eine Arylengruppe, eine zweiwertige heterocyclische Gruppe oder eine durch $-[C(R^{H11})2]n^{H1}-$ dargestellte Gruppe darstellt und diese Gruppen jeweils gegebenenfalls einen Substituenten aufweisen, und wenn mehrere $L^{H1}$ vorhanden sind, können sie gleich oder verschieden sein,
$n^{H11}$ eine ganze Zahl von 1 bis 10 darstellt und $R^{H11}$ ein Wasserstoffatom, eine Alkylgruppe, eine Cycloalkylgruppe, eine Alkoxygruppe, eine Cycloalkoxygruppe, eine Arylgruppe oder eine einwertige heterocyclische Gruppe darstellt und diese Gruppen jeweils gegebenenfalls einen Substituenten aufweisen und die Vielzahl von $R^{H11}$ gleich oder verschieden sein kann und zusammen mit den Kohlenstoffatomen, an die sie gebunden sind, einen Ring bilden kann,
$L^{H2}$ eine durch $-N(-L^{H21}-R^{H21})-$ dargestellte Gruppe darstellt, und wenn mehrere $L^{H2}$ vorhanden sind, können sie gleich oder verschieden sein, und
$L^{H21}$ eine Einfachbindung, eine Arylengruppe oder eine zweiwertige heterocyclische Gruppe darstellt und diese Gruppen jeweils gegebenenfalls einen Substituenten aufweisen und $R^{H21}$ ein Wasserstoffatom, eine Alkylgruppe, eine Cycloalkylgruppe, eine Arylgruppe oder eine einwertige heterocyclische Gruppe darstellt und diese Gruppen jeweils gegebenenfalls einen Substituenten aufweisen.

**9.** Verfahren zur Herstellung einer lichtemittierenden Vorrichtung nach Anspruch 8, wobei die durch die Formel (H-1) dargestellte Verbindung eine durch die Formel (H-2) dargestellte Verbindung ist:

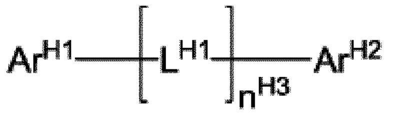
**(H-2)**

wobei $Ar^{H1}$, $Ar^{H2}$, $n^{H3}$ und $L^{H1}$ dieselbe Bedeutung wie oben beschrieben haben.

**10.** Verfahren zur Herstellung einer lichtemittierenden Vorrichtung nach einem der Ansprüche 1 bis 7, wobei die lichtemittierende Schicht durch ein Auftragsverfahren unter Verwendung einer Tinte gebildet wird, die einen Iridiumkomplex oder eine Polymerverbindung enthält, die eine von einem Iridiumkomplex abgeleitete konstitutionelle Einheit und eine Polymerverbindung, die eine konstitutionelle Einheit der Formel (Y) umfasst, umfasst:

$$-[Ar^{Y1}]- \qquad (Y)$$

wobei $Ar^{Y1}$ eine Arylengruppe, eine zweiwertige heterocyclische Gruppe oder eine zweiwertige Gruppe darstellt, in der mindestens eine Arylengruppe und mindestens eine zweiwertige heterocyclische Gruppe direkt aneinander gebunden sind und diese Gruppen jeweils gegebenenfalls einen Substituenten aufweisen.

**11.** Verfahren zur Herstellung einer lichtemittierenden Vorrichtung nach Anspruch 10, wobei die Polymerverbindung weiterhin eine durch die Formel (X) dargestellte konstitutionelle Einheit umfasst:

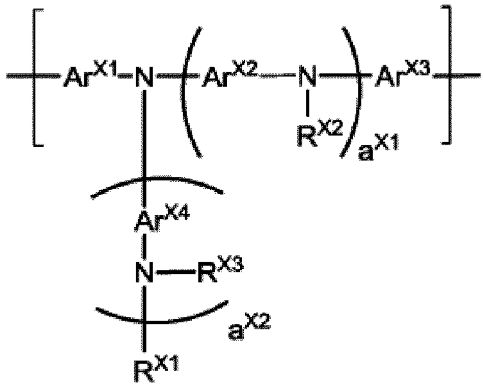
(X)

wobei
$a^{X1}$ und $a^{X2}$ jeweils unabhängig voneinander eine ganze Zahl von 0 oder mehr darstellen,
$Ar^{X1}$ und $Ar^{X3}$ jeweils unabhängig voneinander eine Arylengruppe oder eine zweiwertige heterocyclische Gruppe darstellen und diese Gruppen jeweils gegebenenfalls einen Substituenten aufweisen,
$Ar^{X2}$ und $Ar^{X4}$ jeweils unabhängig voneinander eine Arylengruppe, eine zweiwertige heterocyclische Gruppe oder eine zweiwertige Gruppe darstellen, in der mindestens eine Arylengruppe und mindestens eine zweiwertige heterocyclische Gruppe direkt aneinander gebunden sind und diese Gruppen jeweils gegebenenfalls einen Substituenten aufweisen, und
$R^{X1}$, $R^{X2}$ und $R^{X3}$ eweils unabhängig voneinander ein Wasserstoffatom, eine Alkylgruppe, eine Cycloalkylgruppe, eine Arylgruppe oder eine einwertige heterocyclische Gruppe darstellen und diese Gruppen jeweils gegebenenfalls einen Substituenten aufweisen.

## Revendications

**1.** Procédé de production d'un dispositif luminescent comprenant une anode, une cathode, une couche luminescente disposée entre l'anode et la cathode, et une couche d'encapsulation, comprenant
une étape de formation de la couche luminescente par un procédé d'application utilisant un complexe d'iridium ayant un atome d'iridium en tant que métal central ou un composé polymère comprenant un motif constitutif dérivé d'un complexe d'iridium ayant un atome d'iridium en tant que métal central,

une étape de formation de l'anode ou de la cathode, et une étape de formation de la couche d'encapsulation, dans lequel, pour tout le procédé allant de l'initiation de l'étape de formation de la couche luminescente à l'achèvement de l'étape de formation de la couche d'encapsulation, durant lequel le dispositif luminescent en production est exposé à de l'ozone, la valeur moyenne de la concentration d'ozone : A ppb et l'intervalle de temps : B min satisfont à la formule (1-1) :

$$0 \leq A \times B \leq 1000 \qquad (1-1)$$

et le complexe d'iridium est un complexe d'iridium représenté par la formule (4) :

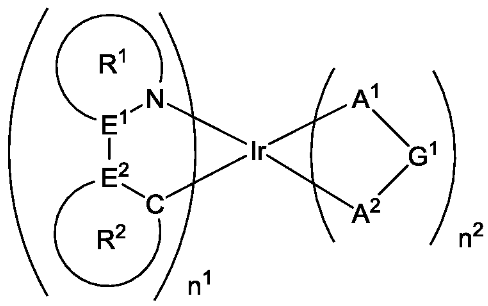
(4)

dans laquelle
$n^1$ représente un entier valant 1 ou plus, $n^2$ représente un entier valant 0 ou plus, et $n^1 + n^2$ vaut 3,
chacun d'$E^1$ et $E^2$ représente indépendamment un atome de carbone ou un atome d'azote, et au moins l'un parmi $E^1$ et $E^2$ est un atome de carbone,
le cycle $R^1$ représente un hétérocycle aromatique à 5 chaînons ou à 6 chaînons, et chacun de ces cycles porte éventuellement un substituant, et lorsque plusieurs des substituants sont présents, ils peuvent être identiques ou différents et peuvent être combinés ensemble pour former un cycle conjointement avec les atomes auxquels ils sont rattachés, et lorsque plusieurs des cycles $R^1$ sont présents, ils peuvent être identiques ou différents, et $E^1$ est un atome de carbone quand le cycle $R^1$ est un hétérocycle aromatique à 6 chaînons,
le cycle $R^2$ représente un cycle hydrocarboné aromatique à 5 chaînons ou à 6 chaînons ou un hétérocycle aromatique à 5 chaînons ou à 6 chaînons, et chacun de ces cycles porte éventuellement un substituant, et lorsque plusieurs des substituants sont présents, ils peuvent être identiques ou différents et peuvent être combinés ensemble pour former un cycle conjointement avec les atomes auxquels ils sont rattachés, et lorsque plusieurs des cycles $R^2$ sont présents, ils peuvent être identiques ou différents, et $E^2$ est un atome de carbone quand le cycle $R^2$ est un hétérocycle aromatique à 6 chaînons, et
$A^1$-$G^1$-$A^2$ représente un ligand bidenté anionique, et chacun d'$A^1$ et $A^2$ représente indépendamment un atome de carbone, un atome d'oxygène ou un atome d'azote, et chacun de ces atomes peut être un atome constitutif d'un cycle, et $G^1$ représente une liaison simple ou un groupe atomique constitutif du ligand bidenté conjointement avec $A^1$ et $A^2$, et quand plusieurs $A^1$-$G^1$-$A^2$ sont présents, ils peuvent être identiques ou différents.

2. Procédé de production d'un dispositif luminescent selon la revendication 1, dans lequel A et B satisfont à la formule (1-2) :

$$0 \leq A \times B \leq 100 \qquad (1-2)$$

3. Procédé de production d'un dispositif luminescent selon la revendication 1 ou 2, dans lequel A satisfait à la formule (2-1) :

$$0 \leq A \leq 30 \qquad (2-1)$$

4. Procédé de production d'un dispositif luminescent selon l'une quelconque des revendications 1 à 3, dans lequel B satisfait à la formule (3-0) :

$$0 \leq B \leq 1000 \qquad (3\text{-}0)$$

5. Procédé de production d'un dispositif luminescent selon l'une quelconque des revendications 1 à 4, dans lequel tout le procédé allant de l'initiation de l'étape de formation de la couche luminescente à l'achèvement de l'étape de formation de la couche d'encapsulation est effectué dans un environnement utilisant un filtre chimique.

6. Procédé de production d'un dispositif luminescent selon l'une quelconque des revendications 1 à 5, dans lequel le complexe d'iridium représenté par la formule (4) est un complexe d'iridium représenté par la formule (4-A1), un complexe d'iridium représenté par la formule (4-A2), un complexe d'iridium représenté par la formule (4-A3) ou un complexe d'iridium représenté par la formule (4-A4) :

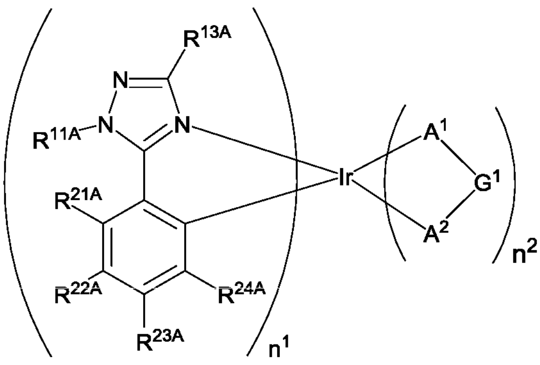

**(4-A1)**

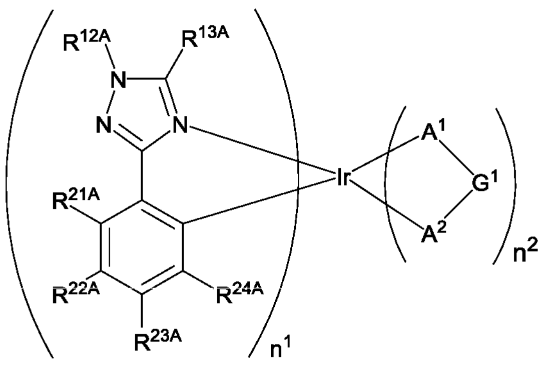

**(4-A2)**

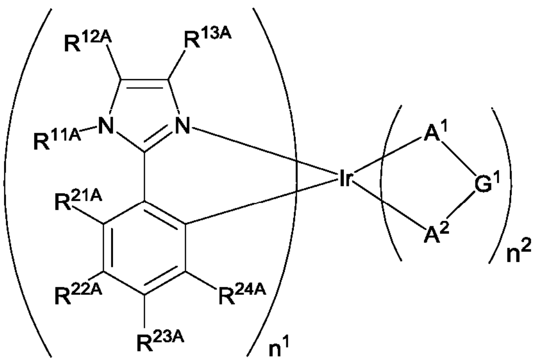

**(4-A3)**

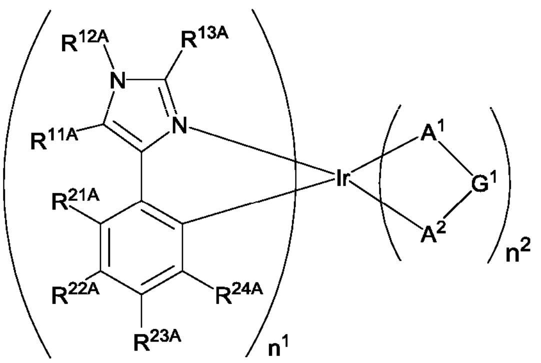

**(4-A4)**

dans lesquelles
$n^1$, $n^2$ et $A^1$-$G^1$-$A^2$ ont les mêmes significations que celles décrites ci-dessus, et
chacun de $R^{11A}$, $R^{12A}$, $R^{13A}$, $R^{21A}$, $R^{22A}$, $R^{23A}$ et $R^{24A}$ représente indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un groupe amino substitué ou un atome d'halogène, et chacun de ces groupes porte éventuellement un substituant, et quand plusieurs parmi $R^{11A}$, $R^{12A}$, $R^{13A}$, $R^{21A}$, $R^{22A}$, $R^{23A}$ et $R^{24A}$ sont présents, ils peuvent être identiques ou différents à chaque occurrence, et $R^{11A}$ et $R^{12A}$, $R^{12A}$ et $R^{13A}$, $R^{11A}$ et $R^{21A}$, $R^{21A}$ et $R^{22A}$, $R^{22A}$ et $R^{23A}$, et $R^{23A}$ et $R^{24A}$ peuvent chacun être combinés ensemble pour former un cycle conjointement avec les atomes auxquels ils sont rattachés.

7. Procédé de production d'un dispositif luminescent selon l'une quelconque des revendications 1 à 5, dans lequel le complexe d'iridium représenté par la formule (4) est un complexe d'iridium représenté par la formule (4-B1), un complexe d'iridium représenté par la formule (4-B2) ou un complexe d'iridium représenté par la formule (4-B3) :

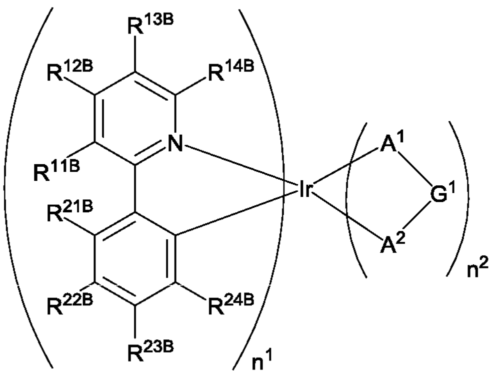

**(4-B1)**

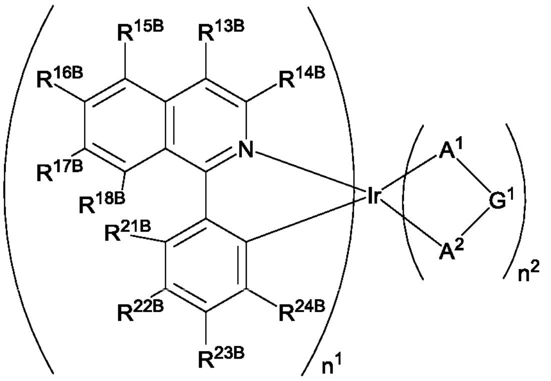

**(4-B2)**

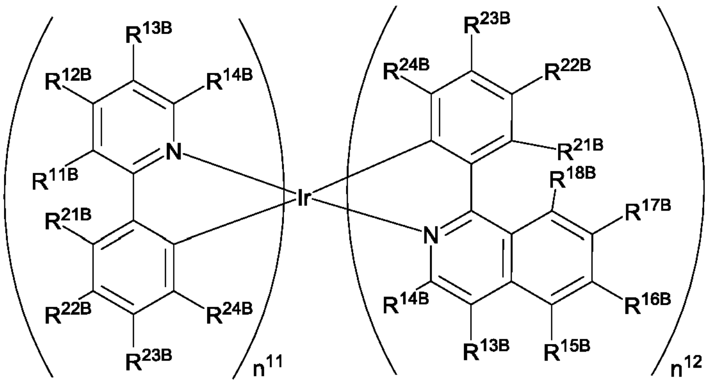

**(4-B3)**

dans lesquelles
$n^1$, $n^2$ et $A^1$-$G^1$-$A^2$ ont les mêmes significations que celles décrites ci-dessus, et
$n^{11}$ représente un entier valant 1 ou plus, $n^{12}$ représente un entier valant 1 ou plus, et $n^{11} + n^{12}$ vaut 3, et
chacun de $R^{11B}$, $R^{12B}$, $R^{13B}$, $R^{14B}$, $R^{15B}$, $R^{16B}$, $R^{17B}$, $R^{18B}$, $R^{21B}$, $R^{22B}$, $R^{23B}$ et $R^{24B}$ représente indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent ou un atome d'halogène, et chacun de ces groupes porte éventuellement un substituant, et quand plusieurs parmi $R^{11B}$, $R^{12B}$, $R^{13B}$, $R^{14B}$, $R^{15B}$, $R^{16B}$, $R^{17B}$, $R^{18B}$, $R^{21B}$, $R^{22B}$, $R^{23B}$ et $R^{24B}$ sont présents, ils peuvent être identiques ou différents à chaque occurrence, et $R^{11B}$ et $R^{12B}$, $R^{12B}$ et $R^{13B}$, $R^{13B}$ et $R^{14B}$, $R^{13B}$ et $R^{15B}$, $R^{15B}$ et $R^{16B}$, $R^{16B}$ et $R^{17B}$, $R^{17B}$ et $R^{18B}$, $R^{11B}$ et $R^{21B}$, $R^{18B}$ et $R^{21B}$, $R^{21B}$ et $R^{22B}$, $R^{22B}$ et $R^{23B}$, et $R^{23B}$ et $R^{24B}$ peuvent chacun être combinés ensemble pour former un cycle conjointement avec les atomes auxquels ils sont rattachés.

**8.** Procédé de production d'un dispositif luminescent selon l'une quelconque des revendications 1 à 7, dans lequel la couche luminescente est formée par un procédé d'application utilisant une encre contenant un complexe d'iridium ou un composé polymère comprenant un motif constitutif dérivé d'un complexe d'iridium et un composé représenté par la formule (H-1) :

$$Ar^{H1}-\left[\left[L^{H2}\right]_{n^{H2}}-\left[L^{H1}\right]_{n^{H1}}-\left[L^{H2}\right]_{n^{H2}}\right]_{n^{H3}}-Ar^{H2} \qquad \textbf{(H-1)}$$

dans laquelle
chacun d'$Ar^{H1}$ et $Ar^{H2}$ représente indépendamment un groupe aryle ou un groupe hétérocyclique monovalent et chacun de ces groupes porte éventuellement un substituant,
chacun de $n^{H1}$ et $n^{H2}$ vaut indépendamment 0 ou 1, et quand plusieurs $n^{H1}$ sont présents, ils peuvent être identiques

ou différents, et les plusieurs $n^{H2}$ peuvent être identiques ou différents,
$n^{H3}$ représente un entier valant 0 ou plus,
$L^{H1}$ représente un groupe arylène, un groupe hétérocyclique divalent ou un groupe représenté par $-[C(R^{H11})_2]n^{H11}-$, et chacun de ces groupes porte éventuellement un substituant, et quand plusieurs $L^{H1}$ sont présents, ils peuvent être identiques ou différents,
$n^{H11}$ représente un entier de 1 à 10, et $R^{H11}$ représente un atome d'hydrogène, un groupe alkyle, un groupe cycloalkyle, un groupe alcoxy, un groupe cycloalcoxy, un groupe aryle ou un groupe hétérocyclique monovalent, et chacun de ces groupes porte éventuellement un substituant, et les plusieurs $R^{H11}$ peuvent être identiques ou différents et peuvent être combinés ensemble pour former un cycle conjointement avec les atomes de carbone auxquels ils sont rattachés,
$L^{H2}$ représente un groupe représenté par $-N(-L^{H21}-R^{H21})-$, et quand plusieurs $L^{H2}$ sont présents, ils peuvent être identiques ou différents, et
$L^{H21}$ représente une liaison simple, un groupe arylène ou un groupe hétérocyclique divalent, et chacun de ces groupes porte éventuellement un substituant, et $R^{H21}$ représente un atome d'hydrogène, un groupe alkyle, un groupe cycloalkyle, un groupe aryle ou un groupe hétérocyclique monovalent, et chacun de ces groupes porte éventuellement un substituant.

**9.** Procédé de production d'un dispositif luminescent selon la revendication 8, dans lequel le composé représenté par la formule (H-1) et un composé représenté par la formule (H-2) :

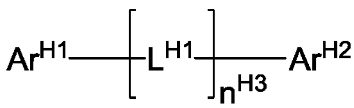

**(H-2)**

dans laquelle $Ar^{H1}$, $Ar^{H2}$, $n^{H3}$ et $L^{H1}$ ont les mêmes significations que celles décrites ci-dessus.

**10.** Procédé de production d'un dispositif luminescent selon l'une quelconque des revendications 1 à 7, dans lequel la couche luminescente est formée par un procédé d'application utilisant une encre contenant un complexe d'iridium ou un composé polymère comprenant un motif constitutif dérivé d'un complexe d'iridium et un composé polymère comprenant un motif constitutif représenté par la formule (Y) :

$$-[Ar^{Y1}]- \qquad (Y)$$

dans laquelle $Ar^{Y1}$ représente un groupe arylène, un groupe hétérocyclique divalent ou un groupe divalent dans lequel au moins un groupe arylène et au moins un groupe hétérocyclique divalent sont liés directement l'un à l'autre, et chacun de ces groupes porte éventuellement un substituant.

**11.** Procédé de production d'un dispositif luminescent selon la revendication 10, dans lequel le composé polymère comprend en outre un motif constitutif représenté par la formule (X) :

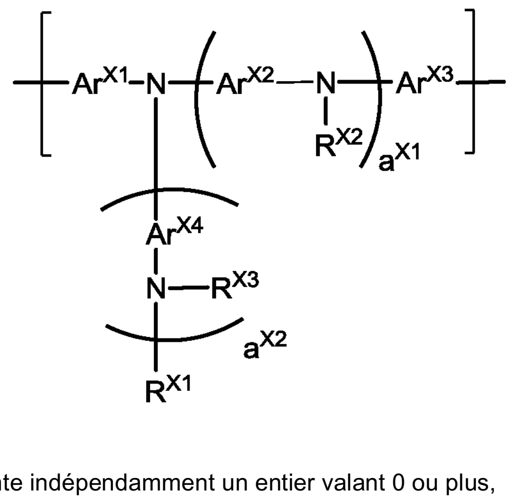

**(X)**

dans laquelle
chacun d'$a^{X1}$ et $a^{X2}$ représente indépendamment un entier valant 0 ou plus,

chacun d'$Ar^{X1}$ et $Ar^{X3}$ représente indépendamment un groupe arylène ou un groupe hétérocyclique divalent, et chacun de ces groupes porte éventuellement un substituant,
chacun d'$Ar^{X2}$ et $Ar^{X4}$ représente indépendamment un groupe arylène, un groupe hétérocyclique divalent ou un groupe divalent dans lequel au moins un groupe arylène et au moins un groupe hétérocyclique divalent sont liés directement l'un à l'autre, et chacun de ces groupes porte éventuellement un substituant, et
chacun de $R^{X1}$, $R^{X2}$ et $R^{X3}$ représente indépendamment un atome d'hydrogène, un groupe alkyle, un groupe cycloalkyle, un groupe aryle ou un groupe hétérocyclique monovalent, et chacun de ces groupes porte éventuellement un substituant.

Fig. 1

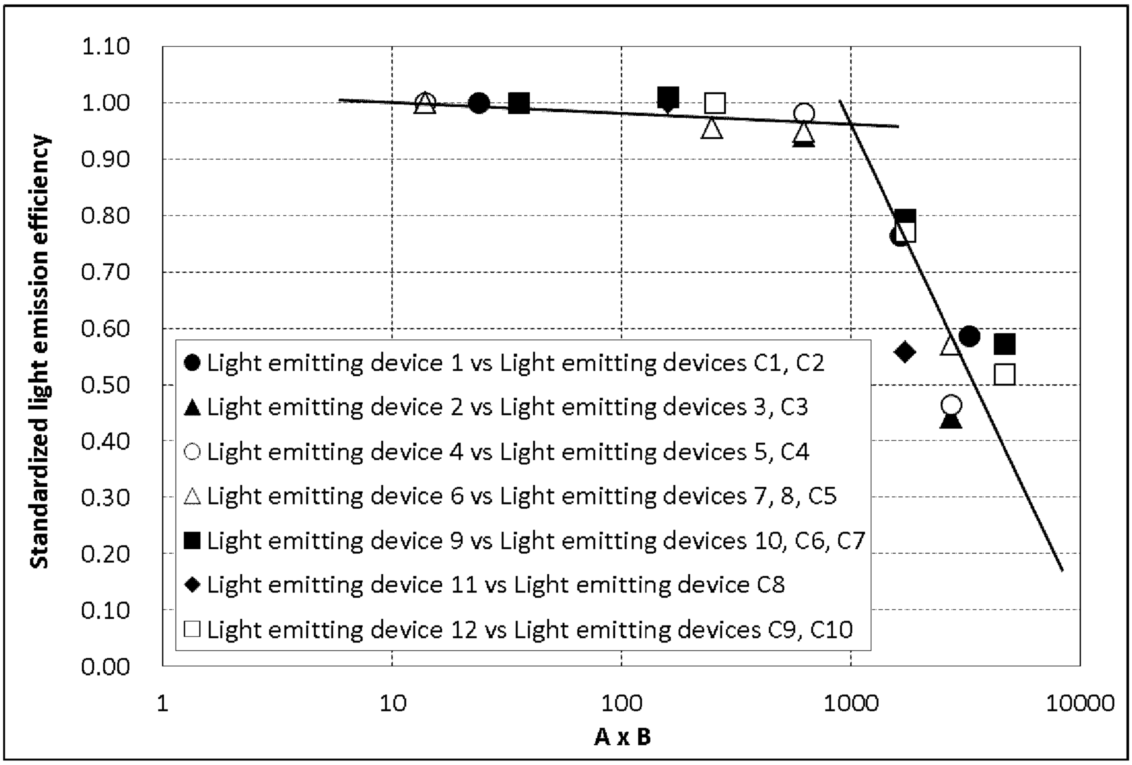
1.10
1.00
0.90
0.80
0.70
0.60
0.50
0.40
0.30
0.20
0.10
0.00
Standardized light emission efficiency
1
10
100
1000
10000
A x B
Light emitting device 1 vs Light emitting devices C1, C2
Light emitting device 2 vs Light emitting devices 3, C3
Light emitting device 4 vs Light emitting devices 5, C4
Light emitting device 6 vs Light emitting devices 7, 8, C5
Light emitting device 9 vs Light emitting devices 10, C6, C7
Light emitting device 11 vs Light emitting device C8
Light emitting device 12 vs Light emitting devices C9, C10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20060040136 A
- EP 1780817 A2
- WO 02067343 A
- JP 2003231692 A
- WO 2003079736 A
- WO 2006097717 A
- WO 2011024761 A
- WO 200244189 A
- JP 2006188673 A
- JP 2004530254 A
- JP 2008179617 A
- JP 2011105701 A
- JP 2007504272 A
- JP 2013147449 A
- JP 2013147450 A
- WO 2009131255 A
- JP 2013147551 A
- JP 2005099481 A
- US 20110057559 A
- WO 2006121811 A
- JP 2011174061 A
- WO 2002045184 A
- JP 2008106241 A
- JP 2003226744 A
- JP 2010189630 A
- JP 2010215886 A
- JP 2002539292 A
- WO 2012086671 A
- WO 201286671 A
- JP 2004143419 A
- JP 2012036388 A
- JP 2012036381 A
- JP 2012033845 A


### Non-patent literature cited in the description


- *Journal of the American Chemical Society,* 1985, vol. 107, 1431-1432
- *Journal of the American Chemical Society,* 1984, vol. 106, 6647-6653
- *Chem. Rev.,* 2009, vol. 109, 897-1091